# EUROPEAN PATENT APPLICATION

(11) **EP 4 737 460 A1**
(43) Date of publication of application: **06.05.2026**
(21) Application number: 25209922.1
(22) Date of filing: 20.10.2025
(51) Int. Cl.: C07F 5/02, C09K 11/06, H10K 50/11, H10K 85/60

(54) **CONDENSED HETEROCYCLIC COMPOUND, LIGHT-EMITTING DEVICE AND ELECTRONIC DEVICE**

(30) Priority: 31.10.2024 KR 20240151850; 18.08.2025 KR 20250114446
(71) Applicant: Samsung Display Co., Ltd., Yongin-si, Gyeonggi-do 17113 (KR)
(72) Inventor: SIM, Munki, 17113 Yongin-si (KR); PAK, Hankyu, 17113 Yongin-si (KR); JANG, Taehoon, 17113 Yongin-si (KR); JUNG, Minjung, 17113 Yongin-si (KR); BAE, Sungsoo, 17113 Yongin-si (KR); HWANG, Seokhwan, 17113 Yongin-si (KR); KIM, Hyungjong, 17113 Yongin-si (KR); MIYASHITA, Hirokazu, 17113 Yongin-si (KR); PARK, Junha, 17113 Yongin-si (KR); SUNG, Minjae, 17113 Yongin-si (KR)
(74) Representative: Marks & Clerk LLP

(57) **Abstract**

A light-emitting device includes a first electrode, a second electrode, and an emission layer between the first electrode and the second electrode, where the emission layer includes a condensed heterocyclic compound represented by Chemical Formula 1. In addition, an electronic device that includes the light-emitting device, an electronic apparatus that includes the light-emitting device, and the condensed heterocyclic compound are also provided.

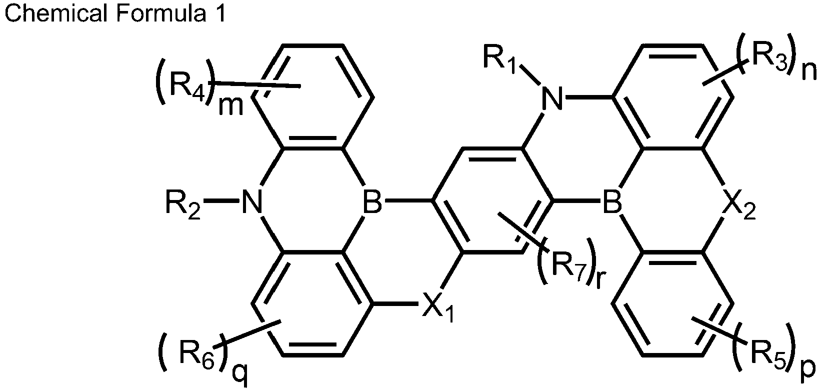

## Description

### BACKGROUND

### 1. Field

One or more embodiments of the present application relate to a condensed heterocyclic compound, a light-emitting device, and an electronic device.

### 2. Description of the Related Art

An organic light-emitting device has a self-luminous property under a driving voltage, and may provide improved viewing angle and contrast properties. Additionally, the organic light-emitting device has characteristics of high response speed and high luminance compared to other light-emitting devices of the comparable art.

The organic light-emitting device may include an emission layer arranged between a first electrode and a second electrode. Holes provided from the first electrode and electrons provided from the second electrode may be recombined in the emission layer to generate excitons. Light emission properties are implemented as the excitons transition and decay from an excited state to a ground state, emitting light from the emission layer.

The emission layer may include a host material and a dopant material to implement the above-described light emitting mechanism.

### SUMMARY

One or more aspects of embodiments of the present disclosure are directed toward a condensed heterocyclic compound that has improved spectroscopic and luminescent properties.

One or more aspects of embodiments of the present disclosure are directed toward a light-emitting device that has improved luminescent properties and reliability.

One or more aspects of embodiments of the present disclosure are directed toward an electronic device including the light-emitting device.

Additional aspects will be set forth in part in the description which follows and, in part, will be apparent from the description, or may be learned by practice of the presented embodiments of the disclosure.

According to one or more embodiments of the present disclosure, a condensed heterocyclic compound represented by Chemical Formula 1 is provided.

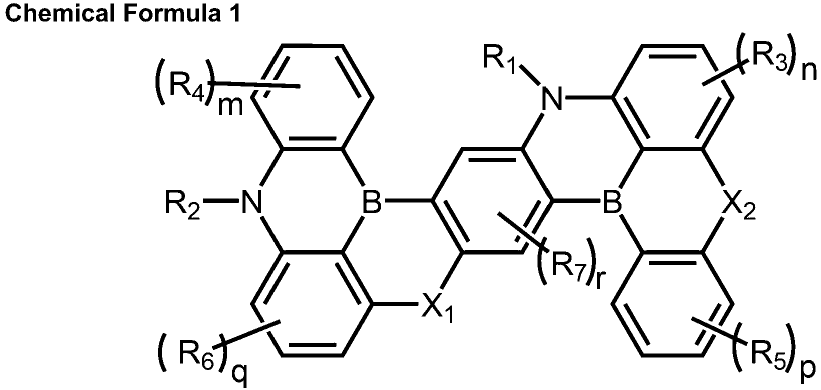

In Chemical Formula 1, X₁ and X₂ are each independently O, S, or Se.

R₁ and R₂ are each independently a group represented by Chemical Formula 2.

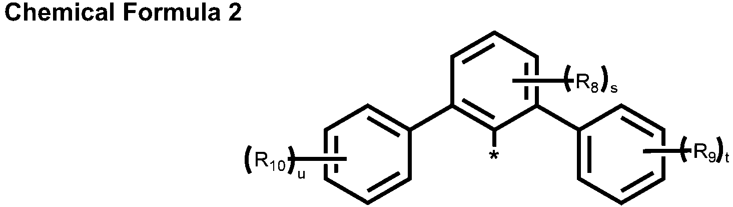

In Chemical Formulae 1 and 2, R₃ to R₁₀ are each independently hydrogen, deuterium, a halogen, a hydroxyl group, a cyano group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, a substituted or unsubstituted C₈-C₆₀ condensed polycyclic group, - SiRR'R", -P(=O)RR', -NRR', -BRR', -C(=O)R, or -S(=O)₂R; and/or two or more selected from among R₃ to R₁₀ are combined with each other to form a substituted or unsubstituted C₃-C₆₀ cycloalkyl ring, a substituted or unsubstituted C₅-C₆₀ cycloalkenyl ring, a substituted or unsubstituted C₃-C₆₀ heterocycloalkyl ring, a substituted or unsubstituted C₃-C₆₀ heterocycloalkenyl ring, a substituted or unsubstituted C₆-C₆₀ aryl ring, or a substituted or unsubstituted C₂-C₆₀ heteroaryl ring.

R, R', and R" are each independently hydrogen, deuterium, a halogen, a hydroxyl group, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, or a substituted or unsubstituted C₈-C₆₀ condensed polycyclic group.

n, q, and s are each independently an integer from 0 to 3, m and p are each independently an integer from 0 to 4, r is an integer from 0 to 2, and t and u are each independently an integer from 0 to 5. When n, m, p, q, r, s, t, and u are each 2 or greater, two or more selected from among respective R₃(s) to R₁₀(s) may each independently be the same as or different from each other. * represents a bonding point.

In one or more embodiments, the group represented by Chemical Formula 2 may be represented by Chemical Formula 2-1 or 2-2.

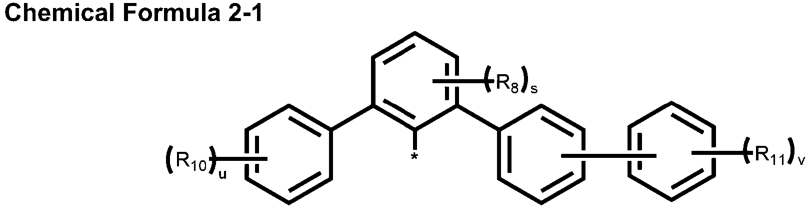

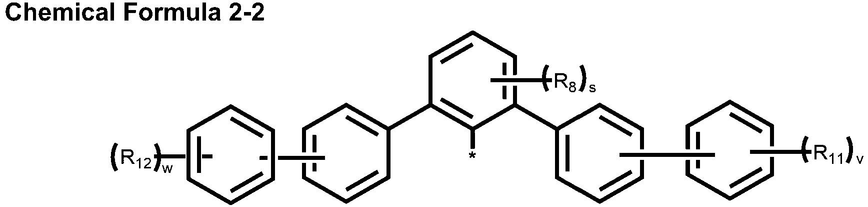

In Chemical Formulae 2-1 and 2-2, R₈, R₁₀, s, and u are each independently the same as those defined in Chemical Formula 2. R₁₁ and R₁₂ are each independently hydrogen, deuterium, a halogen, a cyano group, a hydroxyl group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, a substituted or unsubstituted C₈-C₆₀ condensed polycyclic group, -SiRR'R", -P(=O)RR', -NRR', -BRR', -C(=O)R, or -S(=O)₂R.

R, R', and R" are each independently the same as those defined in Chemical Formulae 1 and 2.

v and w are each independently an integer from 0 to 5. When v and w are each 2 or greater, two or more selected from among respective R₁₁(s) and R₁₂(s) may each independently be the same as or different from each other.

In one or more embodiments, the condensed heterocyclic compound may be represented by Chemical Formulae 1-1 to 1-11.

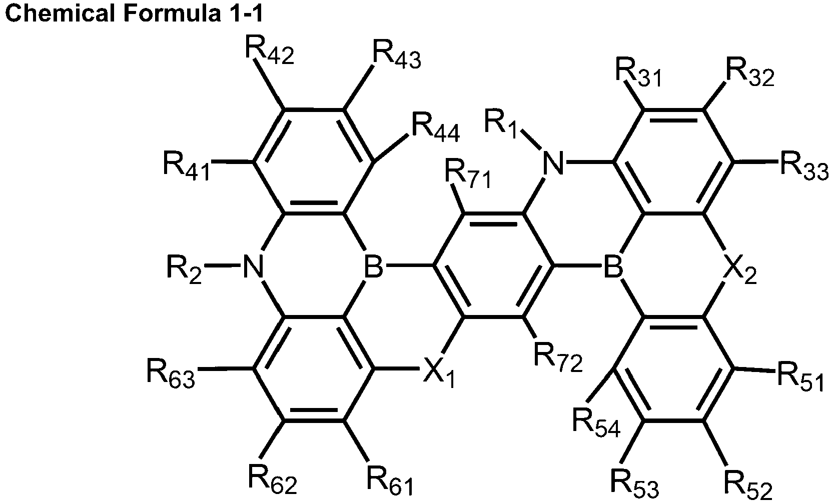

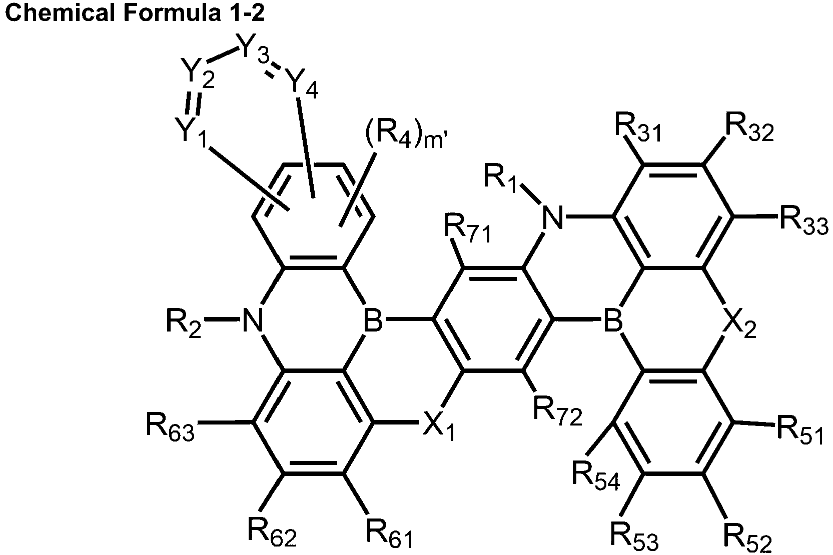

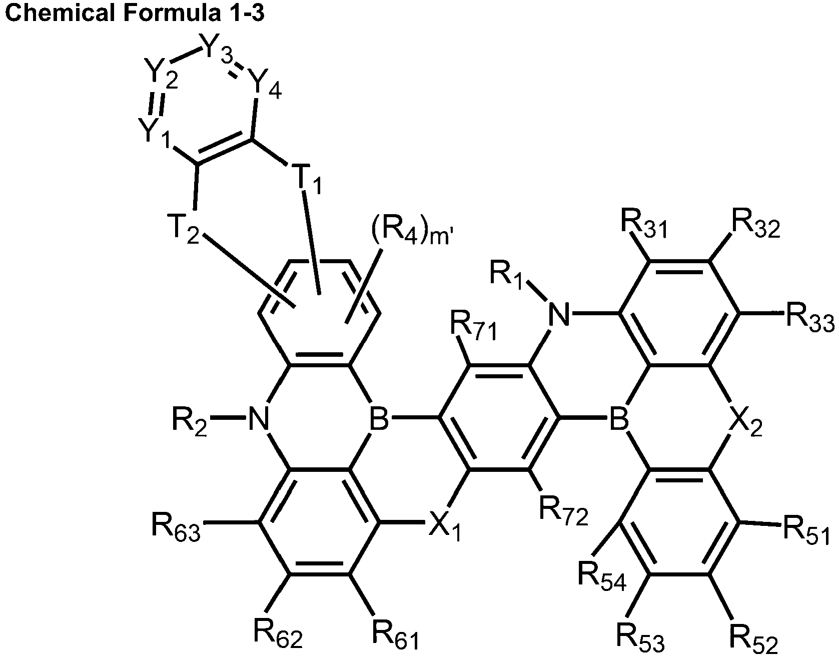

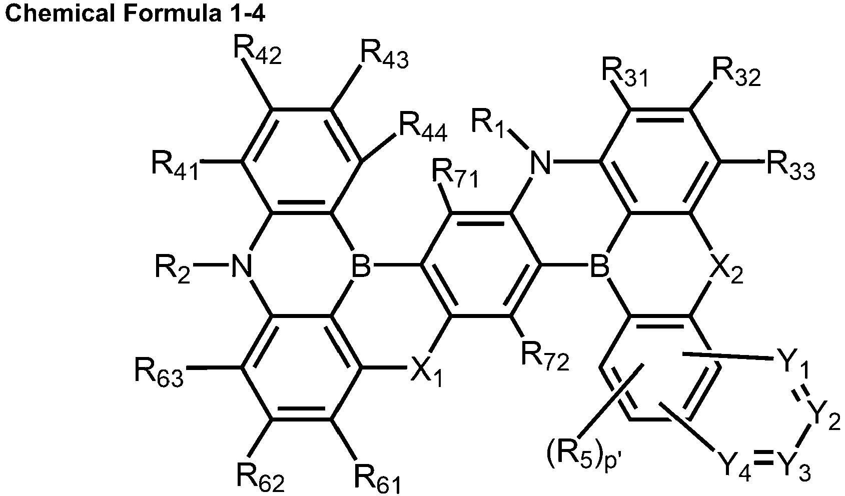

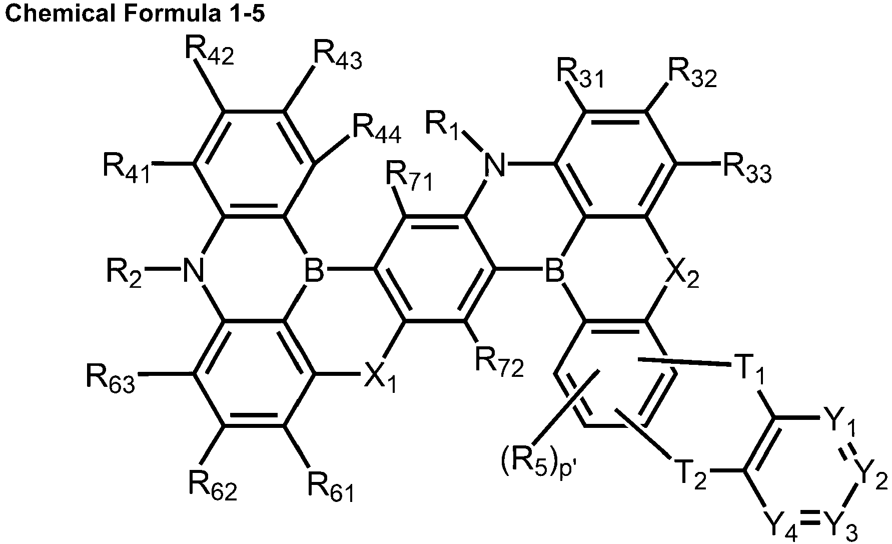

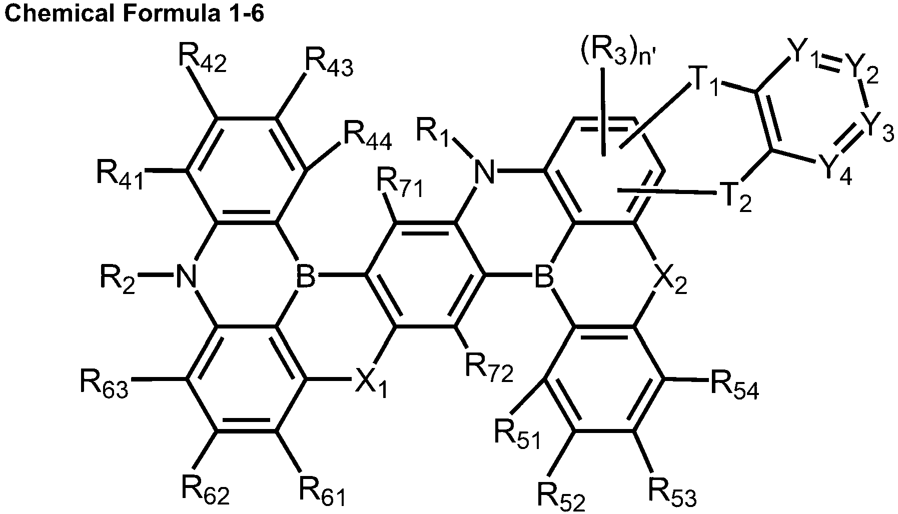

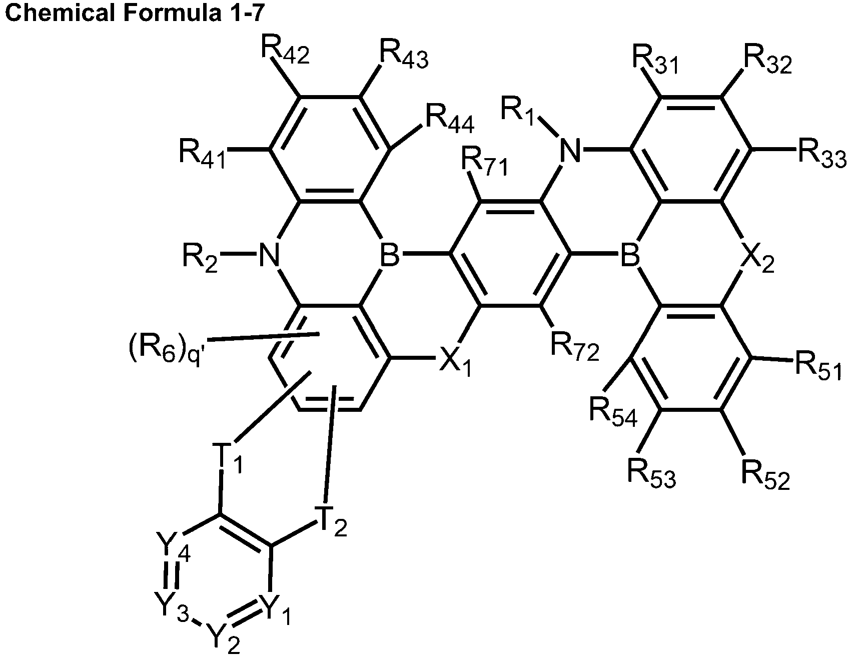

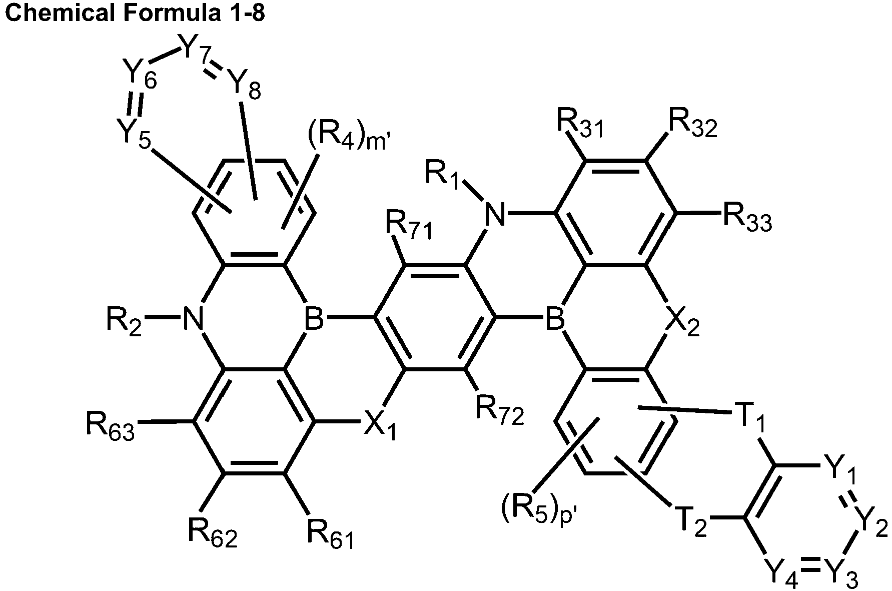

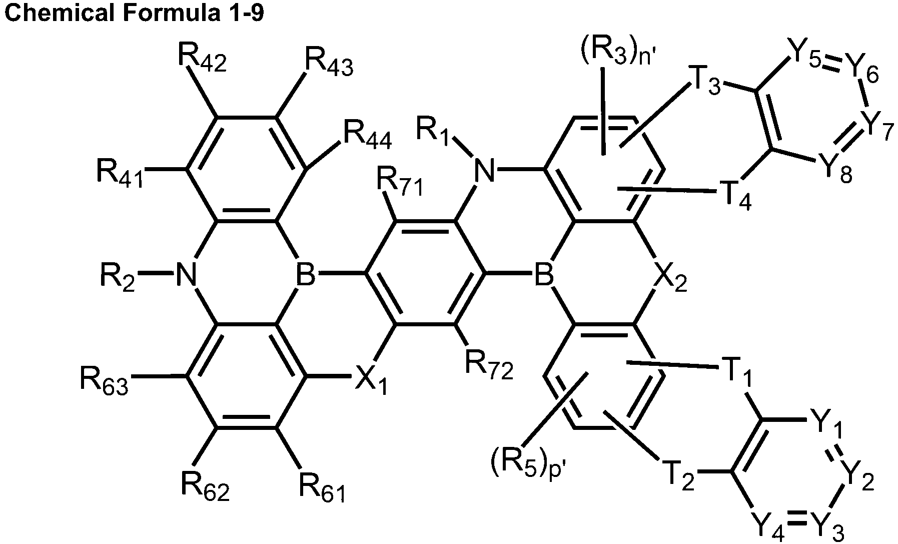

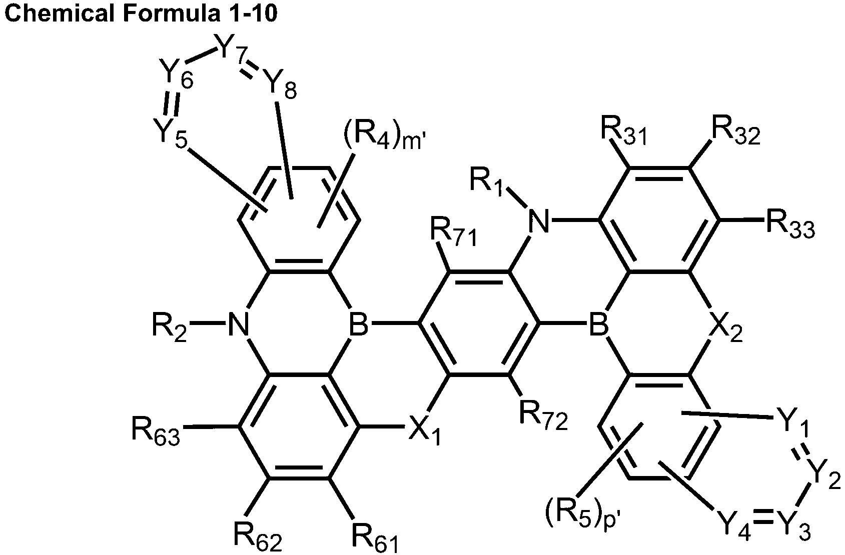

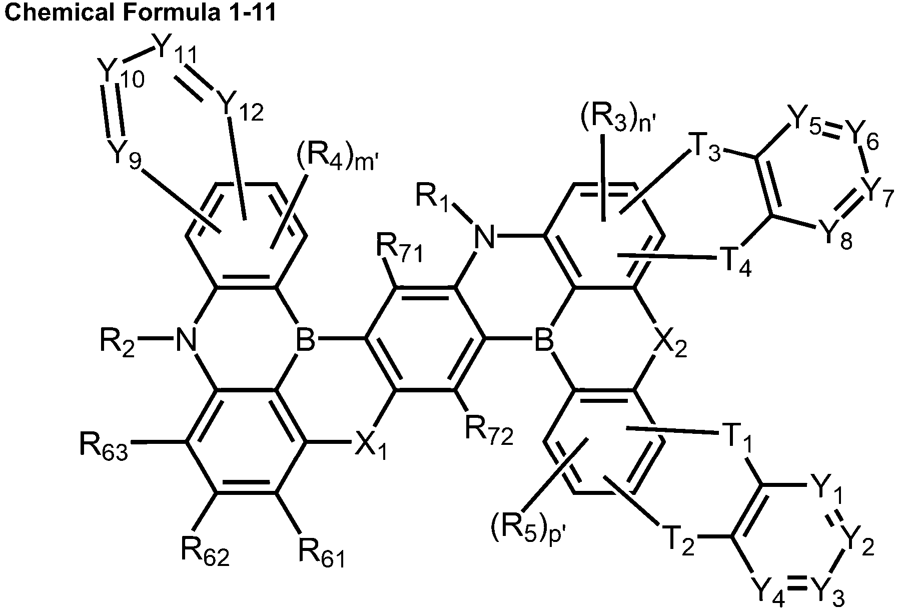

In Chemical Formulae 1-1 to 1-11, X₁, X₂, and R₁ to R₆ are each independently the same as those defined in Chemical Formulae 1 and 2. R₃₁ to R₃₃ are each as described in connection with R₃, R₄₁ to R₄₄ are each as described in connection with R₄, R₅₁ to R₅₄ are each as described in connection with R₅, R₆₁ to R₆₃ are each as described in connection with R₆, and R₇₁ and R₇₂ are each as described in connection with R₇. In Chemical Formulae 1-1 to 1-11, m' is 0 to 2, n' is 0 or 1, p' is 0 to 2, and q' is 0 or 1. When m' and p' are each 2, two selected from among respective R₄(s) and R₅(s) may each independently be the same as or different from each other. In Chemical Formulae 1-1 to 1-11, Y₁ is C(Z₁) or N, Y₂ is C(Z₂) or N, Y₃ is C(Z₃) or N, Y₄ is C(Z₄) or N, Y₅ is C(Z₅) or N, Y₆ is C(Z₆) or N, Y₇ is C(Z₇) or N, Y₈ is C(Z₈) or N, Y₉ is C(Z₉) or N, Y₁₀ is C(Z₁₀) or N, Y₁₁ is C(Z₁₁) or N, Y₁₂ is C(Z₁₂) or N,
T₁ to T₄ are each independently a single bond, O, S or Se, and
Z₁ to Z₁₂ are each as described in connection with R₃.

In one or more embodiments, in Chemical Formula 1, at least two selected from among R₃ to R₆ may be the same.

In one or more embodiments, in Chemical Formulae 1 and 2, R₃ to R₁₀ may each independently be hydrogen, deuterium, a substituted or unsubstituted C₁-C₆₀ alkyl group, a substituted or unsubstituted C₆-C₂₀ aryl group or a substituted or unsubstituted C₂-C₁₅ heteroaryl group.

In one or more embodiments, in Chemical Formula 1, n, m, p, and q may each independently be 0 to 2 (e.g., 0, 1, or 2).

In one or more embodiments, in Chemical Formula 2, s, t, and u may each independently be 0 or 1.

In one or more embodiments, in Chemical Formulae 1 and 2, R₃ to R₁₀ may each independently be hydrogen, deuterium, a C₄-C₁₅ tert-alkyl group substituted or unsubstituted with deuterium, a phenyl group substituted or unsubstituted with deuterium, a C₇-C₂₀ alkylphenyl group substituted or unsubstituted with deuterium, a biphenyl group substituted or unsubstituted with deuterium, a terphenyl group substituted or unsubstituted with deuterium, a naphthalene group substituted or unsubstituted with deuterium, a carbazole group substituted or unsubstituted with deuterium, a dibenzofuran group substituted or unsubstituted with deuterium, or a pyridine group substituted or unsubstituted with deuterium.

In one or more embodiments, the condensed heterocyclic compound may be any one selected from among compounds represented by chemical formulae as explained herein.

According to one or more embodiments of the present disclosure, a light-emitting device includes: a first electrode; a second electrode; and an intermediate layer between the first electrode and the second electrode. The intermediate layer includes an emission layer that includes a condensed heterocyclic compound represented by Chemical Formula 1.

In one or more embodiments, the emission layer may include a host and a dopant, and the condensed heterocyclic compound may be included as a thermally activated delayed fluorescence (TADF) dopant.

In one or more embodiments, the dopant may further include a phosphorescent dopant.

In one or more embodiments, the host may include a hole transporting host represented by Chemical Formula HT, which will be explained later, and an electron transporting host represented by Chemical Formula ET, which will be explained later.

In one or more embodiments, the intermediate layer may further include: a hole transport layer between the emission layer and the first electrode; and an electron transport layer between the emission layer and the second electrode.

In one or more embodiments, the intermediate layer may further include: an electron blocking layer between the hole transport layer and the emission layer; and a hole blocking layer between the emission layer and the electron transport layer.

In one or more embodiments, the hole transport layer or the electron blocking layer may include a compound represented by Chemical Formula HT.

In one or more embodiments, the electron transport layer or the hole blocking layer may include a compound represented by Chemical Formula ET.

In one or more embodiments, the emission layer may be to emit a green light, and a maximum emission wavelength (e.g., wavelength at the maximum emission intensity or peak emission wavelength) of the green light may be in a range from about 510 nanometers (nm) to about 540 nm.

According to one or more embodiments of the present disclosure, an electronic device including the light-emitting device is provided.

The electronic apparatus may be at least one of a flat panel display, a curved display, a computer monitor, a medical monitor, a television, a billboard, an indoor light, an outdoor light, a light for signaling, a head-up display, a fully transparent display, a partially transparent display, a flexible display, a rollable display, a foldable display, a stretchable display, a laser printer, a phone, a mobile phone, a tablet, a phablet, a personal information terminal (PDA), a wearable device, a laptop computer, a digital camera, a camcorder, a viewfinder, a micro display, a 3D display, a virtual reality display, an augmented reality display, a vehicle, a video wall including multiple displays tiled together, a theater screen, a stadium screen, a phototherapy device, or a signage.

At least some of the above and other features of the invention are set out in the claims.

The condensed heterocyclic compound according to one or more embodiments of the disclosure includes a Z-shape condensed ring structure of a core that is a multi-resonance region. Accordingly, the condensed heterocyclic compound may form HOMO (highest occupied molecular orbital) and LUMO (lowest unoccupied molecular orbital) cross-regions, and may thus provide improved optical properties.

The condensed heterocyclic compound may include boron atoms bonded to a central benzene ring in a para position, and nitrogen and chalcogen atoms bonded to a para position in the multi-resonance region. Multiple resonances in the region may be weakened, and thus a portion where HOMOs are adjacent to each other or LUMOs are adjacent to each other may be generated.

The condensed heterocyclic compound may include a terphenyl moiety bonded to a nitrogen atom. Accordingly, Dexter energy transfer (DET) phenomenon may be suppressed or reduced, and planarity of a molecule may be lowered to increase an intermolecular distance, thereby reducing intermolecular interaction and protecting a p orbital of boron.

Accordingly, the condensed heterocyclic compound may have a low HOMO energy level, and may have improved luminous efficiency. The low HOMO energy level is for reducing the energy barrier for hole injection, thereby enhancing the overall efficiency of the light-emitting device. Improved luminous efficiency means that the device may produce brighter light with less power consumption, making it more energy-efficient and cost-effective. This characteristic is beneficial for applications in display technologies, where high brightness and low power consumption are desired for prolonged battery life and better user experience.

The condensed heterocyclic compound may have a three-dimensionally bulky chemical structure, thereby increasing a distance to a host and reducing a side reaction due to interaction between molecules. This bulky structure minimizes or reduces the likelihood of aggregation and quenching, which may degrade the performance of the light-emitting device. By maintaining a greater distance between molecules, the compound ensures stable and consistent light emission. Thus, a light-emitting device that has improved life-span properties by including the condensed heterocyclic compound may be implemented.

The condensed heterocyclic compound has a balanced chemical structure for a chalcogen element, so that a light-emitting device that has more improved efficiency and life-span properties by including such condensed heterocyclic compound(s) may be provided. The balanced chemical structure enhances interaction between the chalcogen element and other components of the compound, leading to enhanced charge transport and light emission properties. This balance contributes to the overall stability and efficiency of the light-emitting device, making it suitable for high-performance applications such as OLED displays and lighting systems. Additionally, the inclusion of chalcogen elements may provide unique optical properties, such as specific emission wavelengths and improved color purity, further enhancing the device's performance.

### BRIEF DESCRIPTION OF THE DRAWINGS

The accompanying drawings are included to provide a further understanding of the present disclosure and are incorporated in and constitute a part of this disclosure. The drawings illustrate embodiments of the present disclosure and, together with the description, serve to explain principles of the disclosure. Above and/or other aspects of the disclosure should become apparent and appreciated from the following description of embodiments taken in conjunction with the accompanying drawings.
FIGS. 1 - 6 are each a schematic cross-sectional view illustrating a light-emitting device in accordance with one or more embodiments of the present disclosure.
FIG. 7 is a schematic cross-sectional view illustrating a display device in accordance with one or more embodiments of the present disclosure.
FIG. 8 is a schematic cross-sectional view illustrating a display device in accordance with one or more embodiments of the present disclosure.
FIG. 9 is a schematic cross-sectional view illustrating a stack construction of light-emitting structure in a display device in accordance with one or more embodiments of the present disclosure.
FIG. 10 is a schematic cross-sectional view illustrating a display device in accordance with one or more embodiments of the present disclosure.
FIG. 11 is a schematic cross-sectional view illustrating a display device in accordance with one or more embodiments of the present disclosure.
FIG. 12 is a block diagram of an electronic device in accordance with one or more embodiments of the present disclosure.
FIG. 13 is a schematic diagram illustrating electronic devices in accordance with various embodiments of the present disclosure.
FIG. 14 is a schematic exploded perspective view illustrating an electronic device in accordance with one or more embodiments of the present disclosure.
FIG. 15 is a schematic cross-sectional view illustrating an electronic device in accordance with one or more embodiments of the present disclosure.

### DETAILED DESCRIPTION

According to the present disclosure, a condensed heterocyclic compound includes a terphenyl structure bonded to nitrogen forming a condensed ring. Further, a light-emitting device and an electronic device including the condensed heterocyclic compound are provided.

### Definition of Terminology

In the present disclosure, the term "substituted or unsubstituted" may refer to being substituted or unsubstituted by one or more substituent selected from the group consisting of deuterium, a halogen, a cyano group, a nitro group, an amino group, a silyl group, an oxy group, a thio group, a sulfinyl group, a sulfonyl group, a carbonyl group, an ester group, boron, a phosphine oxide group, a phosphine sulfide group, an alkyl group (e.g., a C₁-C₆₀ alkyl group, a C₁-C₁₀ alkyl group), an alkenyl group (e.g., a C₂-C₆₀ alkenyl group, a C₂-C₁₀ alkenyl group), an alkynyl group (e.g., a C₂-C₆₀ alkynyl group, a C₂-C₁₀ alkynyl group), an alkoxy group (e.g., a C₁-C₆₀ alkoxy group, a C₁-C₁₀ alkoxy group), a hydrocarbon ring group, an aryl group (e.g., a C₆-C₆₀ aryl group), and a heterocyclic group (e.g., a C₁-C₆₀ heterocyclic group). For example, the term "substituted alkyl group" may refer to a group in which at least one of hydrogen atoms of the alkyl group is substituted with the above-described substituent, and thus the substituent is bonded to a carbon atom of the alkyl group.

The substituent may include a combination of substituents selected from among the groups described above. For example, at least one hydrogen atom in the alkyl group, the aryl group, and/or the like, included as a substituent may be substituted with deuterium, a halogen, a cyano group, a nitro group, an amino group, a silyl group, an oxy group, a thio group, a sulfinyl group, a sulfonyl group, a carbonyl group, an ester group, boron, a phosphine oxide group, a phosphine sulfide group, an alkyl group, an alkenyl group, an alkynyl group, a hydrocarbon ring group, an aryl group, a heterocyclic group, or a (e.g., any suitable) combination thereof.

In the substituents described above, a multivalent substituent such as an amino group, a phosphine sulfide group, a phosphine oxide group, a sulfinyl group, a sulfonyl group, an oxy group, a carbonyl group, an ester group, and/or the like, may each independently be substituted with a C₁-C₁₀ alkyl group, a C₁-C₁₀ alkenyl group, a C₁-C₁₀ alkynyl group, and/or a C₆-C_{1O} aryl group.

In the disclosure, regarding the term "substituted or unsubstituted Cₐ-C_{b} Y group," the range of a to b refers to the number of carbon atoms in an unsubstituted Y group, and may not include (e.g., may exclude) the number of carbon atoms of its substituent.

In the disclosure, an alkyl group may be a monovalent hydrocarbon group in which one hydrogen atom is removed from a linear or branched hydrocarbon group. Non-limiting examples of an alkyl group may include a methyl group, an ethyl group, a propyl group, a sec-butyl group, a tert-butyl group, an iso-butyl group, a pentyl group, a neopentyl group, a 2-ethyl butyl group, a 3,3-dimethyl butyl group, a hexyl group, a heptyl group, an octyl group, and/or the like.

In the disclosure, an alkylene group may be a divalent hydrocarbon group in which two hydrogen atoms are removed from a linear or branched hydrocarbon group.

In the disclosure, an alkenyl group may have substantially the same skeleton as that of an alkyl group, and may be a monovalent hydrocarbon group that includes at least one carbon-carbon double bond. In the disclosure, an alkenylene group may be a divalent hydrocarbon group in which one hydrogen atom is further removed from an alkenyl group.

In the disclosure, an alkynyl group may have substantially the same skeleton as that of an alkyl group, and may be a monovalent hydrocarbon group that includes at least one carbon-carbon triple bond. In the disclosure, an alkynylene group may be a divalent hydrocarbon group in which one hydrogen atom is further removed from an alkynyl group.

In the disclosure, an aryl group may be a monovalent hydrocarbon group in which one hydrogen atom is removed from a hydrocarbon group having an aromatic structure. The definition of an aryl group may also encompass a group in which multiple aromatic rings are directly connected, such as a biphenyl group. Non-limiting examples of an aryl group may include, e.g., a phenyl group, a naphthyl group, an anthracenyl group, a phenanthrenyl group, a pyrenyl group, a fluorenyl group, a tetracenyl group, a biphenyl group, a terphenyl group, a quaterphenyl group, a chrysenyl group, and/or the like.

In the disclosure, a group in which two or more aryl rings are condensed to each other or linked to each other by an alicyclic hydrocarbon ring, such as a fluorenyl group, may be encompassed in the definition of an aryl group.

For example, a biphenyl group may be interpreted as an aryl group, or may be interpreted as a phenyl group that is substituted with a phenyl group.

In the disclosure, an arylene group may be a divalent hydrocarbon group in which one hydrogen atom is further removed from an aryl group.

In the disclosure, a heteroaryl group may be a monovalent group having an aromatic structure that includes at least one heteroatom such as B, O, P, S, and/or Si as a ring-forming atom. In the disclosure, a heteroarylene group may be a divalent group having an aromatic structure that includes at least one heteroatom such as B, O, P, S, and/or Si as a ring-forming atom. When a heteroaryl group or a heteroarylene group includes two or more heteroatoms, the two or more heteroatoms may be the same as or different from each other.

In the disclosure, a group in which two or more aryl rings are condensed or linked to a non-aromatic heterocyclic ring, such as a carbazole group, may also be encompassed in the definition of a heteroaryl group.

In the disclosure, the term "cyclic group" may encompass a monocyclic group or a polycyclic group, and may also encompass an alicyclic ring or an aromatic ring.

In the disclosure, the term "polycyclic group" may be a group in which two or more rings are connected to each other or condensed with each other through one or more atoms. For example, a polycyclic structure may include a bicyclic structure through a bridge carbon, a spiro structure, a fused structure, and/or the like.

In the disclosure, the term "condensed group" or "condensed ring structure" may each be a group in which two or more adjacent rings share two or more atoms among the above-described polycyclic structures. Non-limiting examples of a condensed ring structure may include naphthalene, anthracene, phenanthrene, fluorene, pyrene, benzopyrene, pentacene, polyacene, helicene, and/or the like.

In the disclosure, the terms "cycloalkyl group" and "cycloalkenyl group" are a saturated cyclic group and an unsaturated cyclic group, respectively, in which ring-forming atoms include (e.g., consist of) carbons. The heterocyclic group (e.g., a C₁-C₆₀ heterocyclic group) may be a cyclic group that further include a heteroatom as ring-forming atom(s) in addition to carbons.

Each of the cycloalkyl, cycloalkenyl, and heterocyclic groups may be a monocyclic group including (e.g., consisting of) one (exactly one) ring or a polycyclic group in which two or more rings are condensed with each other.

### Condensed Heterocyclic Compound

According to one or more embodiments, a condensed heterocyclic compound represented by Chemical Formula 1 is provided.

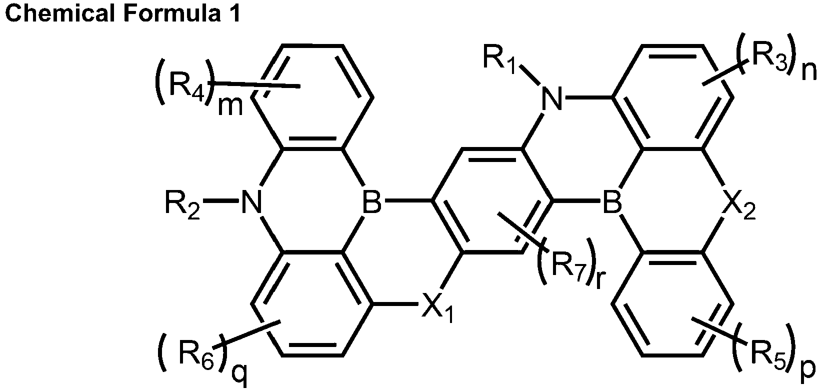

In Chemical Formula 1, X₁ and X₂ are each independently O, S or Se. In one or more embodiments, X₁ and X₂ may be the same as or different from each other.

In one or more embodiments, X₁ and X₂ may each be O. In one or more embodiments, X₁ and X₂ may each be S. In one or more embodiments, X₁ and X₂ may each be Se. In one or more embodiments, X₁ may be O, and X₂ may be S. In one or more embodiments, X₁ may be O, and X₂ may be Se. In one or more embodiments, X₁ may be S, and X₂ may be O. In one or more embodiments, X₁ may be S, and X₂ may be Se. In one or more embodiments, X₁ may be Se, and X₂ may be O. In one or more embodiments, X₁ may be Se, and X₂ may be S.

R₁ and R₂ are each independently a group represented by Chemical Formula 2.

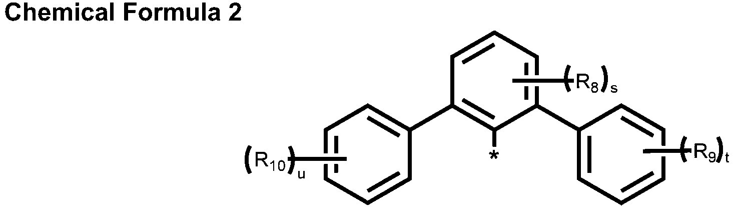

In Chemical Formulae 1 and 2, R₃ to R₁₀ are each independently hydrogen, deuterium, a halogen, a hydroxyl group, a cyano group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, a substituted or unsubstituted C₈-C₆₀ condensed polycyclic group, - SiRR'R", -P(=O)RR', -NRR', -BRR', -C(=O)R, or -S(=O)₂R.

In one or more embodiments, R₃ to R₁₀ may each independently be hydrogen, deuterium, a halogen, a hydroxyl group, a cyano group, an amidino group, a hydrazine group, a hydrazone group, a substituted or unsubstituted C₁-C₂₀ alkyl group, a substituted or unsubstituted C₂-C₂₀ alkenyl group, a substituted or unsubstituted C₂-C₂₀ alkynyl group, a substituted or unsubstituted C₁-C₂₀ alkoxy group, a substituted or unsubstituted C₃-C₄₀ cycloalkyl group, a substituted or unsubstituted C₅-C₄₀ cycloalkenyl group, a substituted or unsubstituted C₃-C₄₀ heterocycloalkyl group, a substituted or unsubstituted C₃-C₄₀ heterocycloalkenyl group, a substituted or unsubstituted C₆-C₄₀ aryl group, a substituted or unsubstituted C₂-C₄₀ heteroaryl group, a substituted or unsubstituted C₆-C₄₀ aryloxy group, a substituted or unsubstituted C₆-C₄₀ arylthio group, a substituted or unsubstituted C₈-C₄₀ condensed polycyclic group, - SiRR'R", -P(=O)RR', -NRR', -BRR', -C(=O)R, or -S(=O)₂R.

In one or more embodiments, R₃ to R₁₀ may each independently be hydrogen, deuterium, a cyano group, an amidino group, a hydrazine group, a hydrazone group, a substituted or unsubstituted C₁-C₁₀ alkyl group, a substituted or unsubstituted C₂-C₁₀ alkenyl group, a substituted or unsubstituted C₂-C₁₀ alkynyl group, a substituted or unsubstituted C₁-C₁₀ alkoxy group, a substituted or unsubstituted C₃-C₂₀ cycloalkyl group, a substituted or unsubstituted C₅-C₂₀ cycloalkenyl group, a substituted or unsubstituted C₃-C₂₀ heterocycloalkyl group, a substituted or unsubstituted C₃-C₂₀ heterocycloalkenyl group, a substituted or unsubstituted C₆-C₂₀ aryl group, a substituted or unsubstituted C₂-C₂₀ heteroaryl group, a substituted or unsubstituted C₆-C₂₀ aryloxy group, a substituted or unsubstituted C₆-C₂₀ arylthio group, a substituted or unsubstituted C₈-C₂₀ condensed polycyclic group, - SiRR'R", or -NRR'.

R, R', and R" are each independently hydrogen, deuterium, a halogen, a hydroxyl group, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, or a substituted or unsubstituted C₈-C₆₀ condensed polycyclic group.

In one or more embodiments, R₃ to R₁₀ may each independently be hydrogen, deuterium, a C₄-C₁₅ tert-alkyl group substituted or unsubstituted with deuterium (e.g., a tert-butyl group substituted or unsubstituted with deuterium), a phenyl group substituted or unsubstituted with deuterium, a C₇-C₂₀ alkylphenyl group substituted or unsubstituted with deuterium (e.g., a methylphenyl group substituted or unsubstituted with deuterium, a di-tert-butylphenyl group substituted or unsubstituted with deuterium, a trimethylphenyl group substituted or unsubstituted with deuterium, and/or the like), a biphenyl group substituted or unsubstituted with deuterium, a terphenyl group substituted or unsubstituted with deuterium, a naphthalene group substituted or unsubstituted with deuterium, a carbazole group substituted or unsubstituted with deuterium, a dibenzofuran group substituted or unsubstituted with deuterium, or a pyridine group substituted or unsubstituted with deuterium.

In one or more embodiments, R₃ to R₁₀ may each independently be hydrogen, deuterium, an amidino group, a hydrazine group, a hydrazone group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group. These may be unsubstituted or substituted with the above-mentioned substituent.

In one or more embodiments, R₃ to R₁₀ may each independently be hydrogen, deuterium, a substituted or unsubstituted C₁-C₆₀ alkyl group, a substituted or unsubstituted C₆-C₂₀ aryl group or a substituted or unsubstituted C₂-C₁₅ heteroaryl group. For example, in one or more embodiments, R₃ to R₁₀ may each independently be a C₆-C₂₀ aryl group substituted with deuterium or an unsubstituted C₆-C₂₀ aryl group, or a C₂-C₁₅ heteroaryl group substituted with deuterium or an unsubstituted C₂-C₁₅ heteroaryl group.

Accordingly, the condensed heterocyclic compound may substantially include (e.g., consist of) an aryl structure, and resonance and electron transport properties of the condensed heterocyclic compound may be improved. Additionally, an outer reaction site of the condensed heterocyclic compound where a luminescence transition occurs may be protected, and a side reaction (e.g., Dexter energy transfer) may be suppressed or reduced.

In Chemical Formulae 1 and 2, two or more selected from among R₃ to R₁₀ may be combined with to each other to form a ring. A remainder thereof that may not form a ring may be selected from among those listed groups.

In one or more embodiments, two or more selected from among R₃ to R₁₀ may be combined with each other to form a substituted or unsubstituted C₃-C₆₀ cycloalkyl ring, a substituted or unsubstituted C₅-C₆₀ cycloalkenyl ring, a substituted or unsubstituted C₃-C₆₀ heterocycloalkyl ring, a substituted or unsubstituted C₃-C₆₀ heterocycloalkenyl ring, a substituted or unsubstituted C₆-C₆₀ aryl ring, or a substituted or unsubstituted C₂-C₆₀ heteroaryl ring.

In one or more embodiments, two or more selected from among R₃ to R₁₀ may be combined with each other to form a substituted or unsubstituted C₃-C₄₀ cycloalkyl ring, a substituted or unsubstituted C₅-C₄₀ cycloalkenyl ring, a substituted or unsubstituted C₃-C₄₀ heterocycloalkyl ring, a substituted or unsubstituted C₃-C₄₀ heterocycloalkenyl ring, a substituted or unsubstituted C₆-C₄₀ aryl ring, or a substituted or unsubstituted C₂-C₄₀ heteroaryl ring. For example, in one or more embodiments, if (e.g., when) two or more selected from among R₃ to R₁₀ are combined to form a ring, a substituted or unsubstituted C₂-C₄₀ condensed heteroaryl ring may be formed.

In one or more embodiments, if (e.g., when) each of R₃ to R₁₀ are present in plural, adjacent ones may be optionally combined to form a ring, or non-adjacent ones may be optionally combined to form a ring.

For example, if (e.g., when) R₃ is present in plural, multiple R₃ may be optionally combined to form a ring. If (e.g., when) R₄ is present in plural, multiple R₄ may be optionally combined to form a ring. If (e.g., when) R₅ is present in plural, multiple R₅ may be optionally combined to form a ring.

For example, R₄ and R₅ may be combined to form a ring.

In Chemical Formulae 1 and 2, n, q, and s are each independently 0 or an integer from 1 to 3. For example, in one or more embodiments, n, q, and s may each independently be 0, 1 or 2.

When each of n, q, and s is 2 or greater, multiple R₃, multiple R₆ and multiple R₅ may each independently be the same as or different from each other.

In Chemical Formula 1, m and p are each independently 0 or an integer from 1 to 4. For example, in one or more embodiments, m and p may each independently be 0, 1 or 2.

When m and p are each 2 or greater, two or more selected from among respective R₄(s) and R₅(s) may each be independently the same as or different from each other.

In Chemical Formula 1, r is 0, 1 or 2. For example, in one or more embodiments, r may be 0 or 1.

When r is 2, multiple R₇(s) may be the same as or different from each other.

In Chemical Formula 2, t and u are each independently an integer of 0 to 5. For example, in one or more embodiments, t and u may each independently be 0 or 1.

When t and u are each 2 or greater, two or more selected from among respective R₉(s) and R₁₀(s) may each independently be the same as or different from each other.

In Chemical Formula 2, * refers to a bonding position, and may also indicate a bonding position in descriptions below.

In one or more embodiments, at least one selected from among R₃ to R₁₀ may be deuterium.

In one or more embodiments, the group represented by Chemical Formula 2 may be represented by Chemical Formula 2-1 or Chemical Formula 2-2.

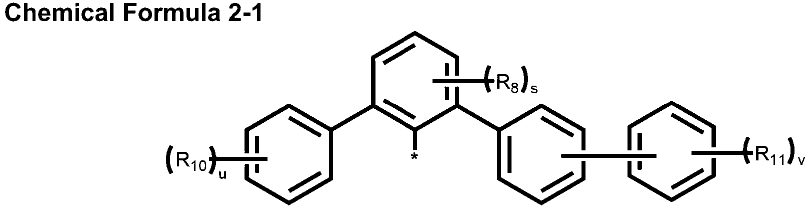

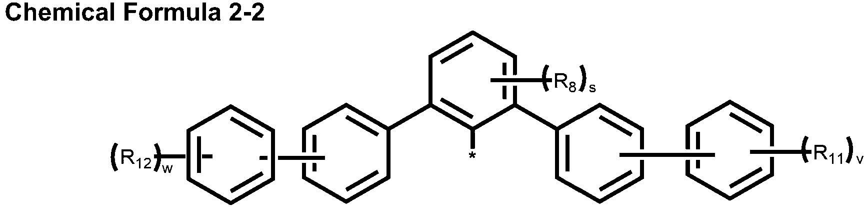

In Chemical Formulae 2-1 and 2-2, the above definitions of R₈, R₁₀, s, and u are equally applied.

In Chemical Formulae 2-1 and 2-2, R₁₁ and R₁₂ are each independently hydrogen, deuterium, a halogen, a cyano group, a hydroxyl group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, a substituted or unsubstituted C₈-C₆₀ condensed polycyclic group, -SiRR'R", -P(=O)RR', -NRR', -BRR', -C(=O)R, or -S(=O)₂R. The above definitions of R, R', and R" are equally applied.

v and w are each independently 0 to 5. For example, in one or more embodiments, v and w may each independently be 0 or 1.

When v and w are each 2 or greater, two or more selected from among respective R₁₁(s) and R₁₂(s) may each independently be the same as or different from each other.

The condensed heterocyclic compound according to one or more embodiments may be represented by Chemical Formulae 1-1 to 1-11.

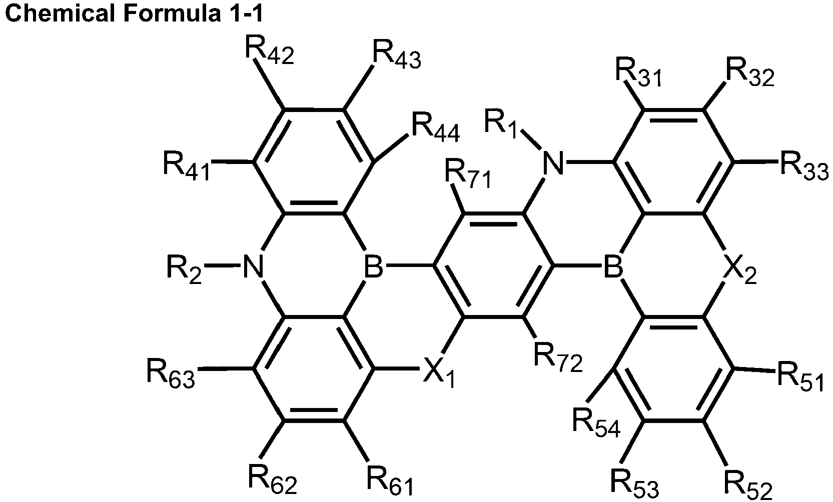

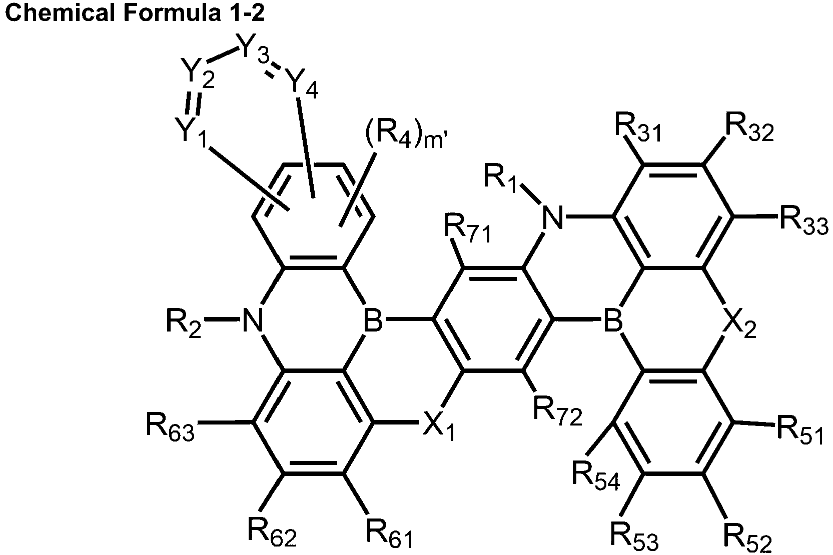

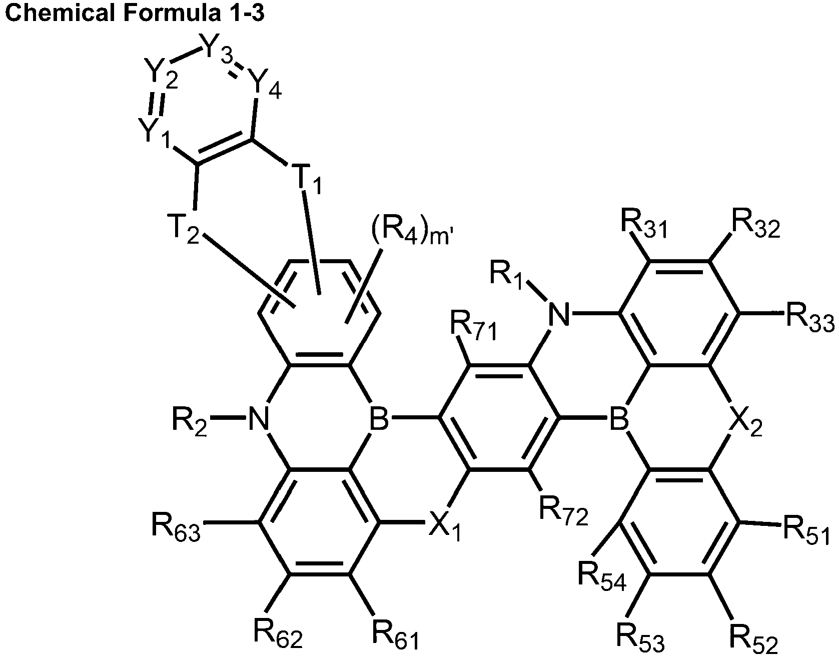

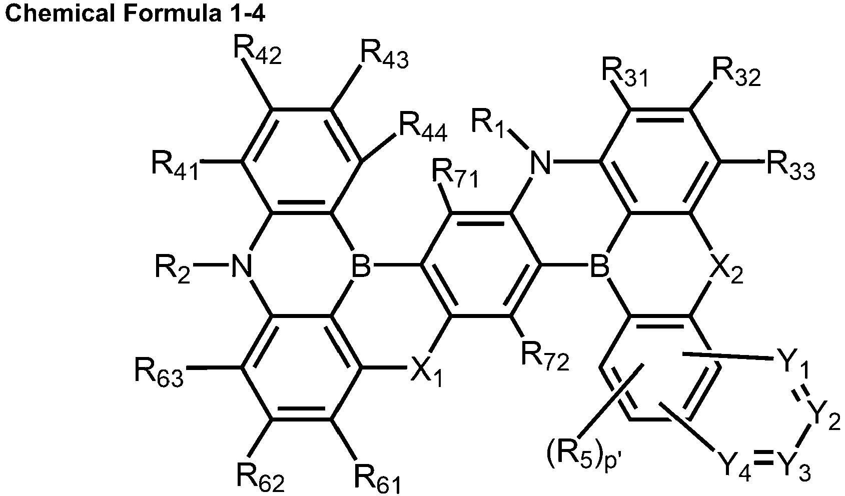

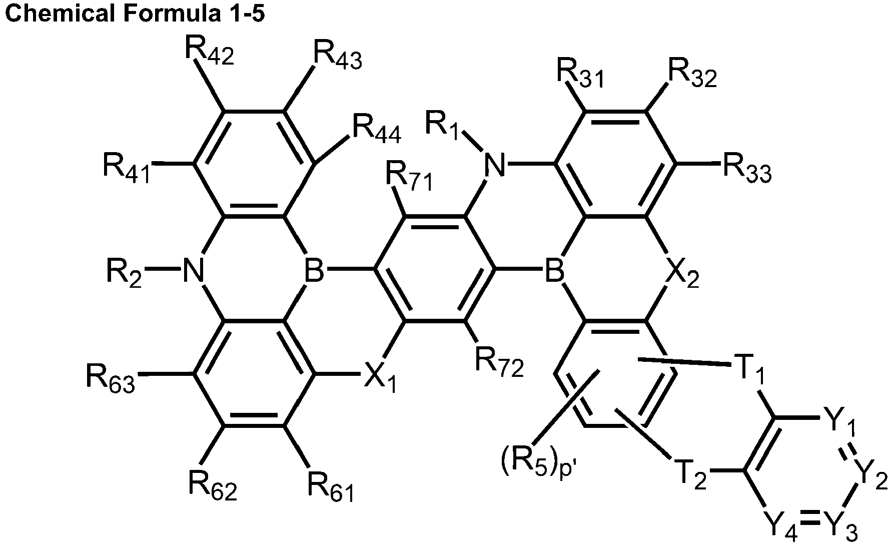

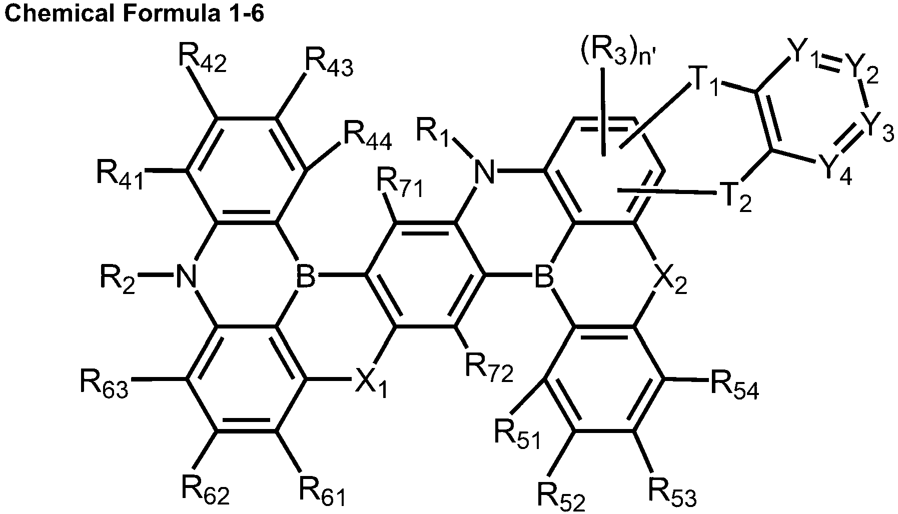

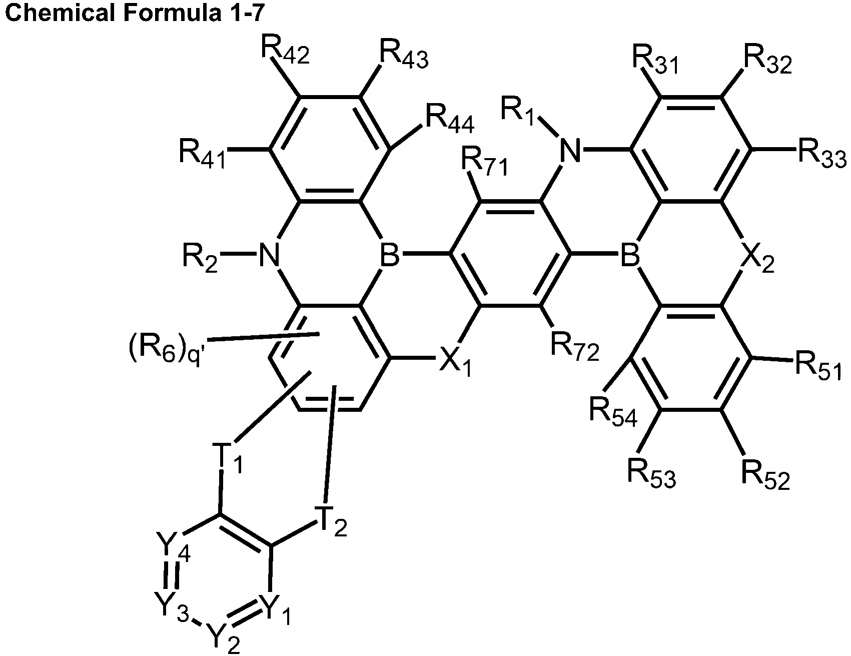

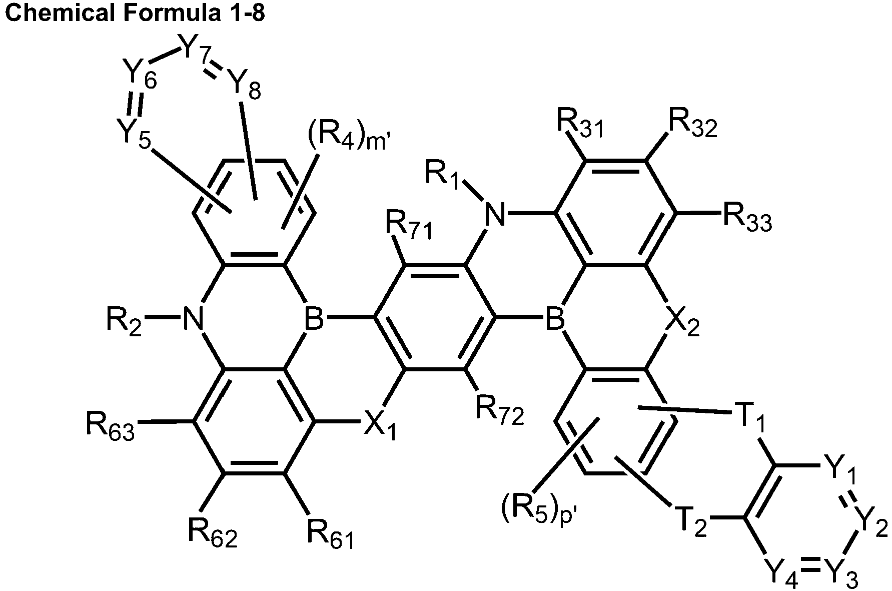

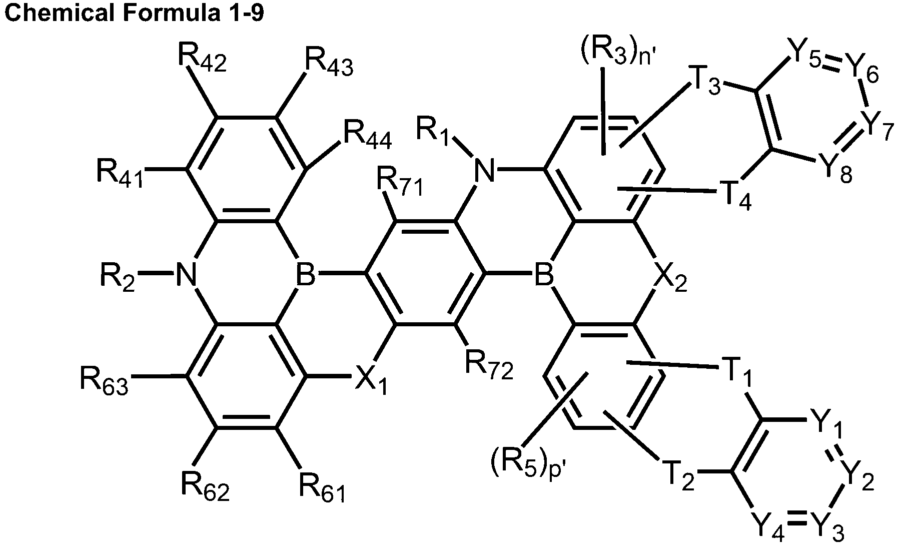

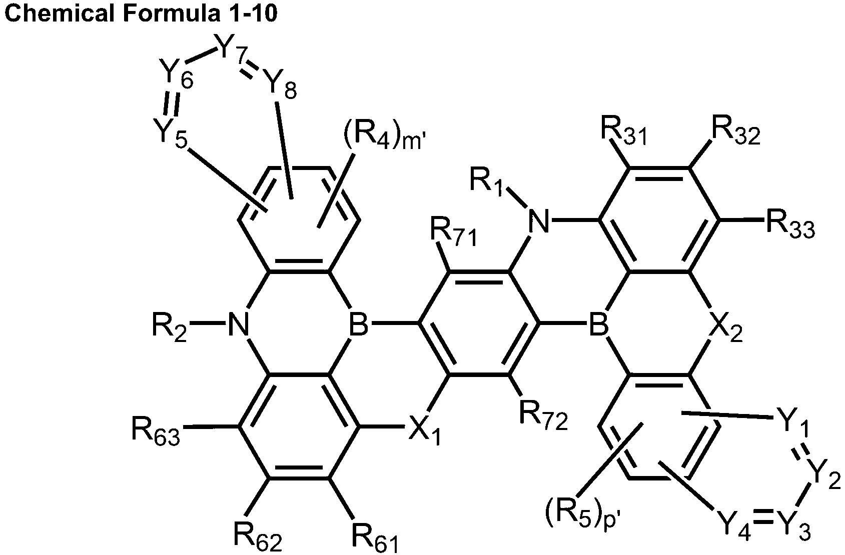

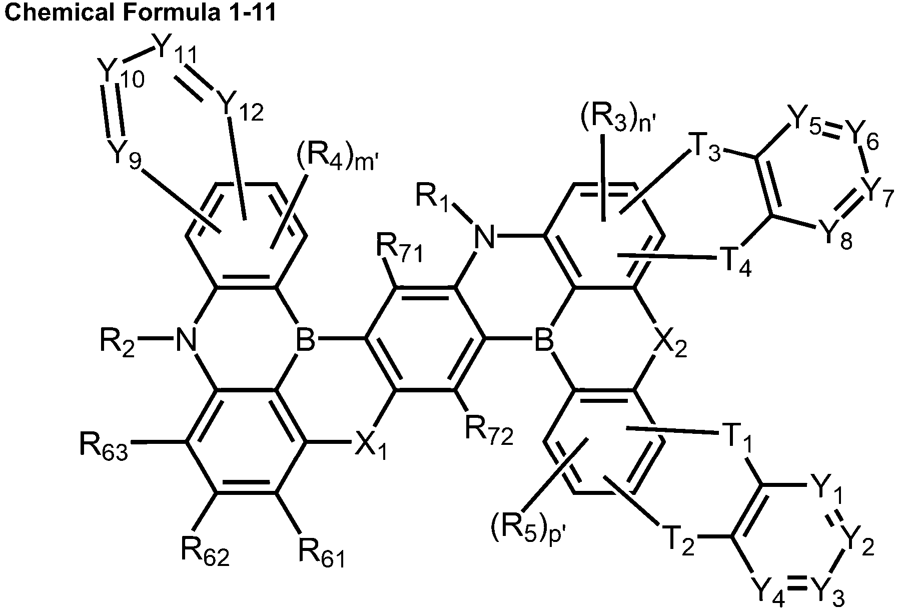

In Chemical Formulae 1-1 to 1-11, the above definitions of X₁, X₂, and R₁ to R₆ are equally applied, R₃₁ to R₃₃ are each as described in connection with R₃, R₄₁ to R₄₄ are each as described in connection with R₄, R₅₁ to R₅₄ are each as described in connection with R₅, R₆₁ to R₆₃ are each as described in connection with R₆, and R₇₁ and R₇₂ are each as described in connection with R₇.

In Chemical Formulae 1-1 to 1-11, m' is 0 to 2, n' is 0 or 1, p' is 0 to 2, and q' is 0 or 1.

When m' and p' are each 2, two or more selected from among respective R₄(s) and R₅(s) may each independently be the same as or different from each other.

In Chemical Formulae 1-1 to 1-11, Y₁ is C(Z₁) or N, Y₂ is C(Z₂) or N, Y₃ is C(Z₃) or N, Y₄ is C(Z₄) or N, Y₅ is C(Z₈) or N, Y₆ is C(Z₆) or N, Y₇ is C(Z₇) or N, Y₈ is C(Z₈) or N, Y₉ is C(Z₉) or N, Y₁₀ is C(Z₁₀) or N, Y₁₁ is C(Z₁₁) or N, Y₁₂ is C(Z₁₂) or N, T₁ to T₄ are each independently a single bond, O, S or Se, and Z₁ to Z₁₂ are each as described in connection with R₃.

In one or more embodiments, in Chemical Formula 1, at least two selected from among R₃ to R₆ may be the same. In one or more embodiments, at least three selected from among R₃ to R₆ may be the same.

In one or more embodiments, in Chemical Formula 1, at least two selected from among R₃ to R₆ may each independently be hydrogen, deuterium, a C₄-C₁₅ tert-alkyl group substituted or unsubstituted with deuterium (e.g., a tert-butyl group substituted or unsubstituted with deuterium), a phenyl group substituted or unsubstituted with deuterium, a C₇-C₂₀ alkylphenyl group substituted or unsubstituted with deuterium (e.g., a methylphenyl group substituted or unsubstituted with deuterium, a di-tert-butylphenyl group substituted or unsubstituted with deuterium, a trimethylphenyl group substituted or unsubstituted with deuterium), a biphenyl group substituted or unsubstituted with deuterium, a terphenyl group substituted or unsubstituted with deuterium, a naphthalene group substituted or unsubstituted with deuterium, a carbazole group substituted or unsubstituted with deuterium, a dibenzofuran group substituted or unsubstituted with deuterium, or a pyridine group substituted or unsubstituted with deuterium.

A degree of deuterium substitution of the condensed heterocyclic compound according to one or more embodiments may be in a range from 0% to 100%. The degree of deuterium substitution may be a value calculated as a percentage of the number of deuterium atoms relative to the sum of the number of hydrogen atoms and the number of deuterium atoms included in the compound. For example, the degree of deuterium substitution of a benzene substituted with 5 deuterium atoms may be about 83.33%.

The degree of deuterium substitution of the condensed heterocyclic compound according to one or more embodiments may be in a range from about 1% to 100%, from about 5% to 100%, from about 20% to 100%, from about 30% to 100%, from about 40% to 100%, or from about 50% to 100%.

The degree of deuterium substitution of the condensed heterocyclic compound according to one or more embodiments may be in a range from 0% to about 90%, from 0% to about 80%, from 0% to about 70%, from 0% to about 60%, or from 0% to about 50%.

The condensed heterocyclic compound according to one or more embodiments may be any one selected from among compounds represented by the following chemical formulae.

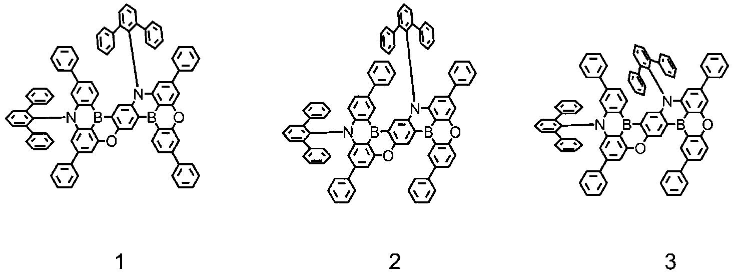

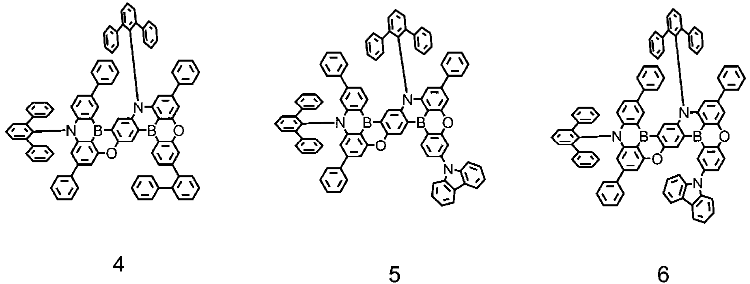

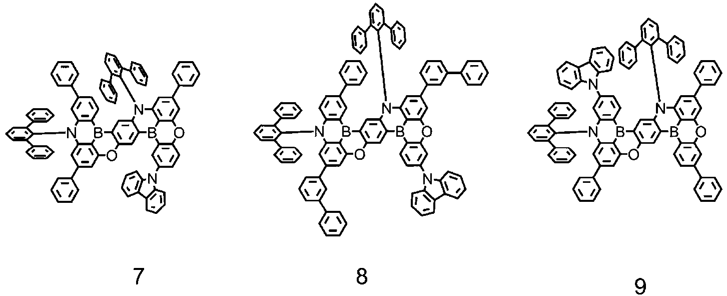

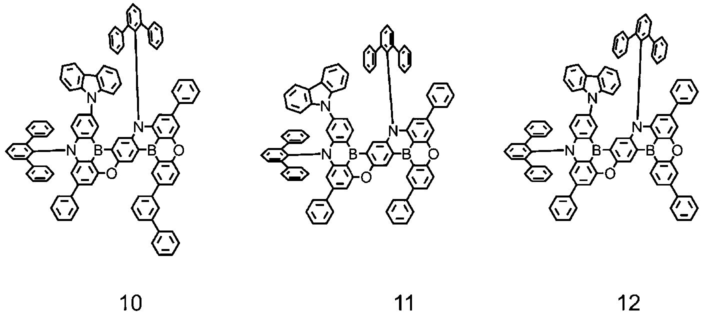

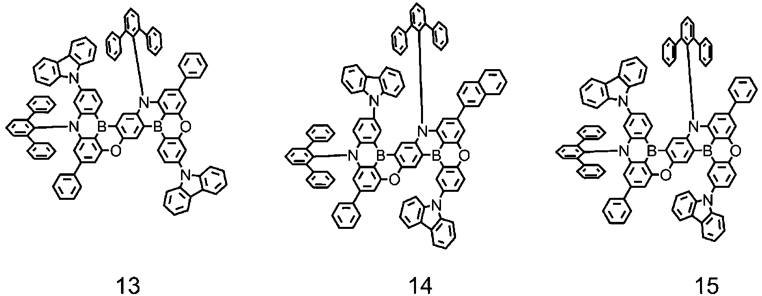

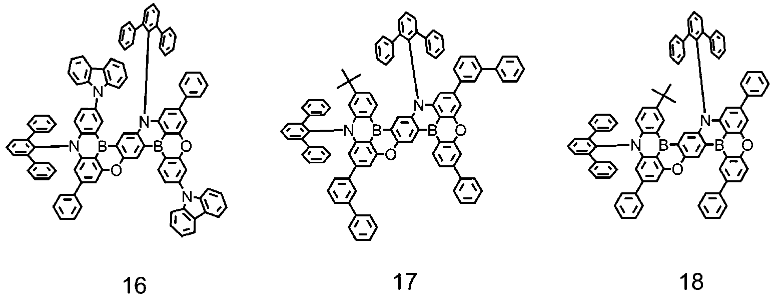

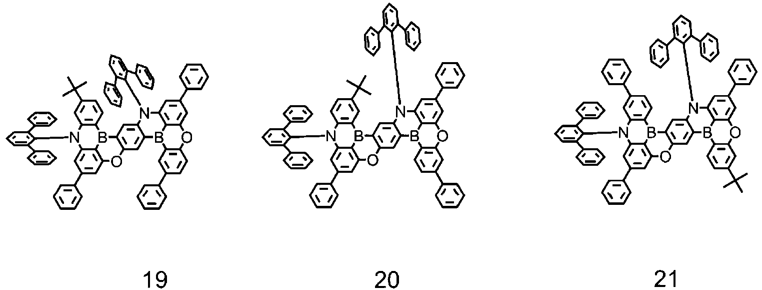

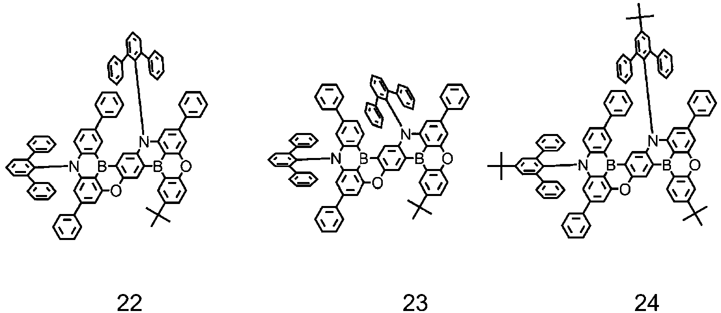

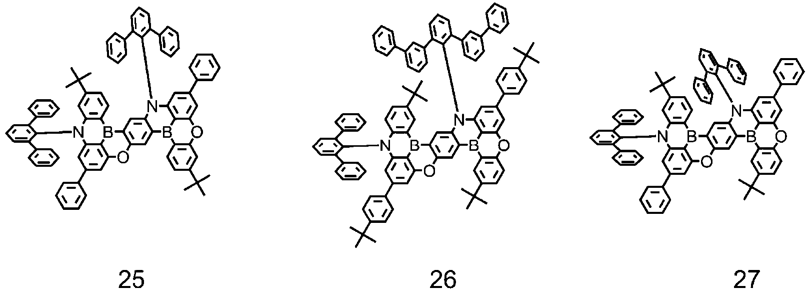

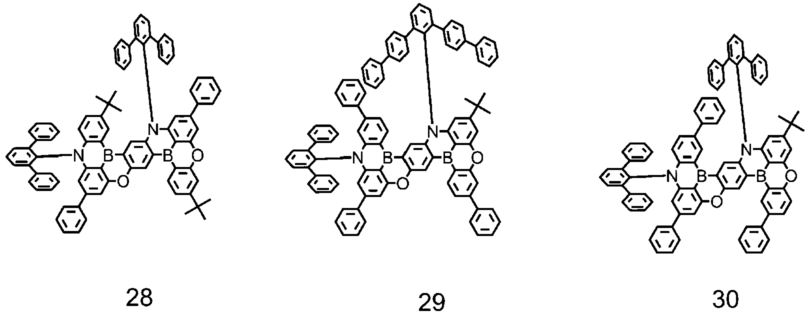

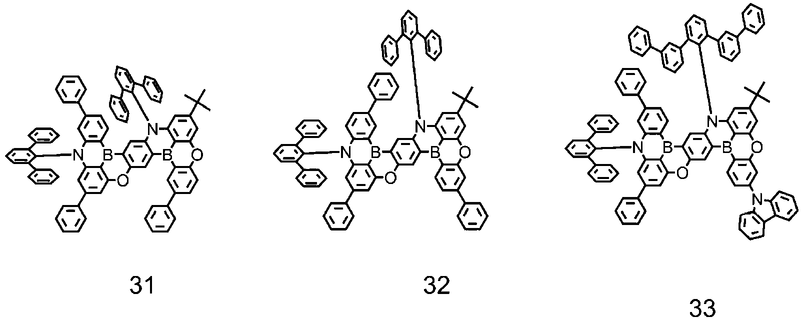

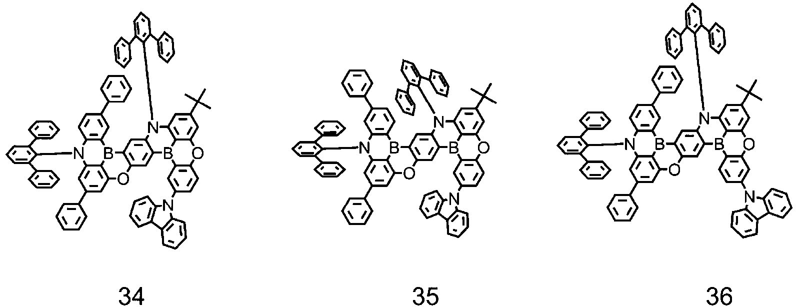

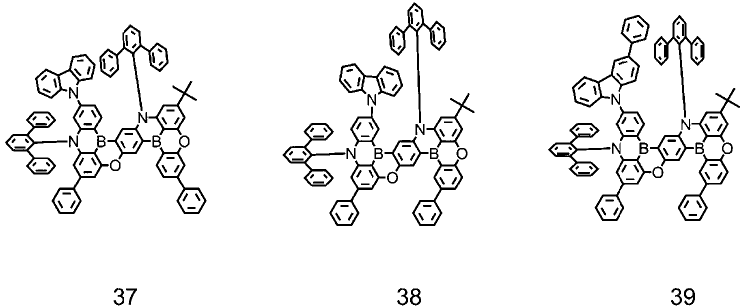

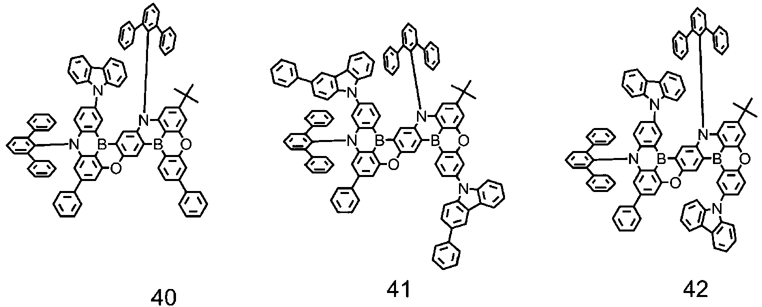

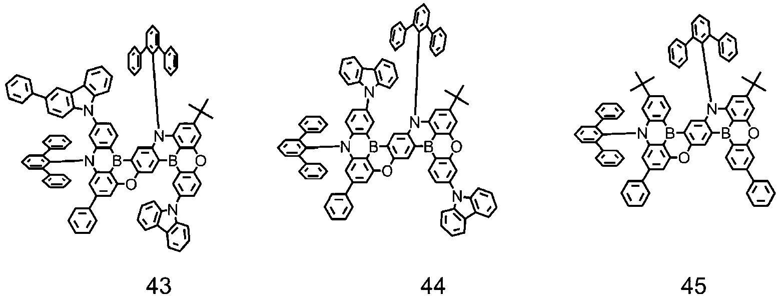

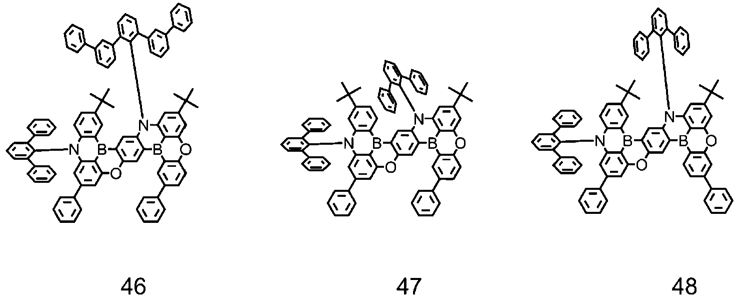

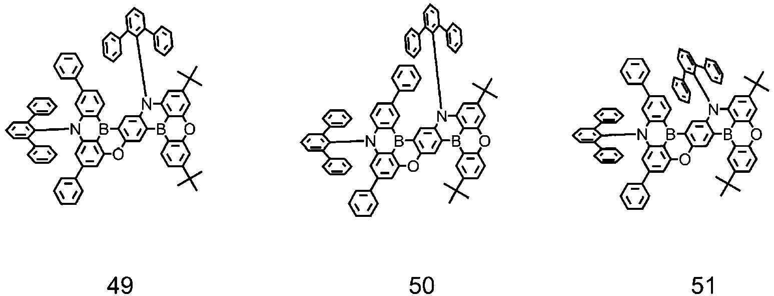

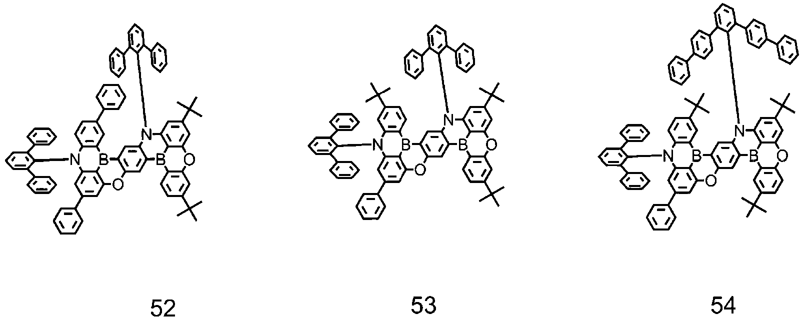

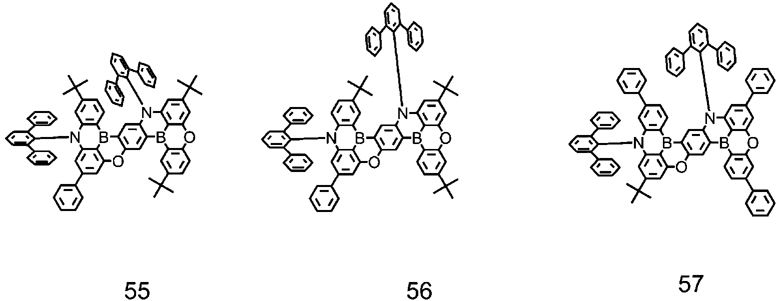

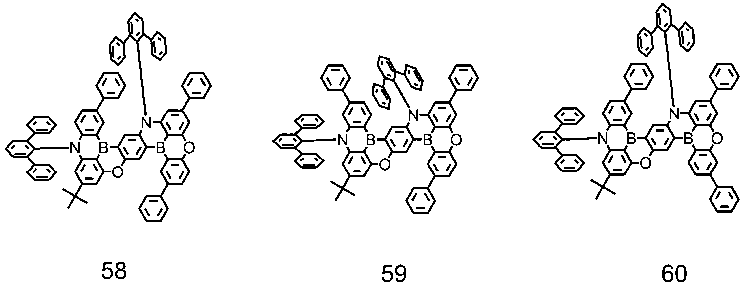

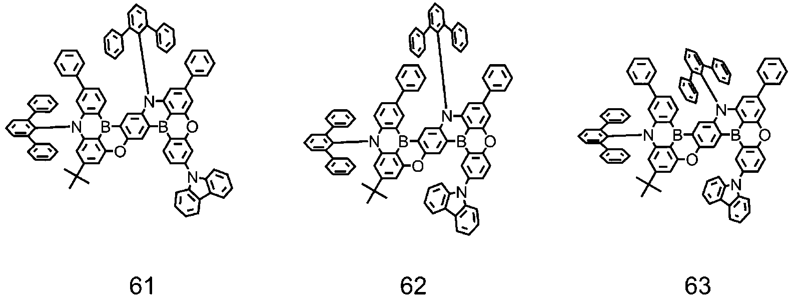

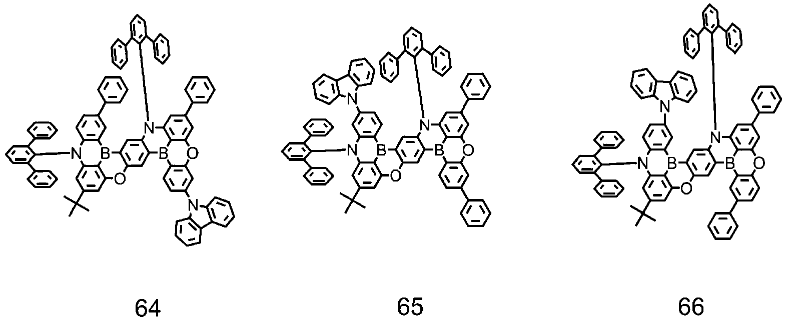

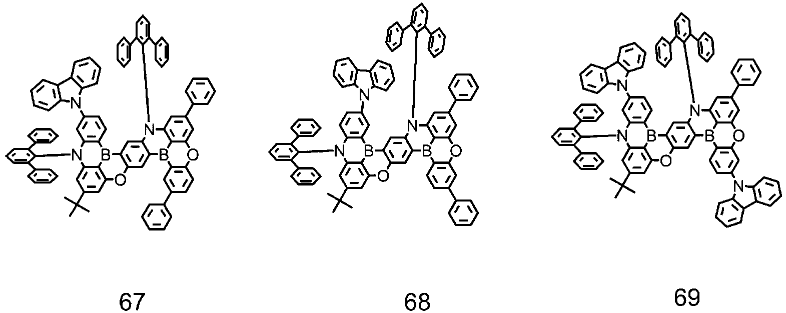

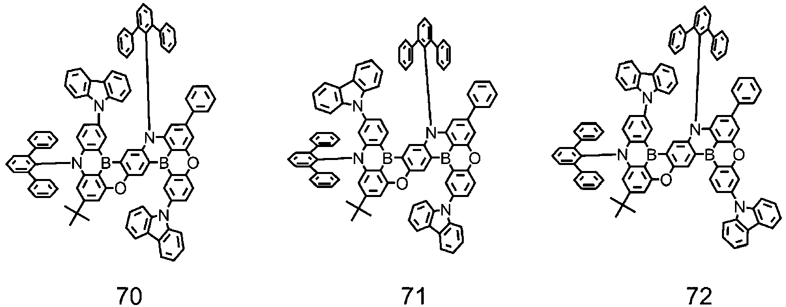

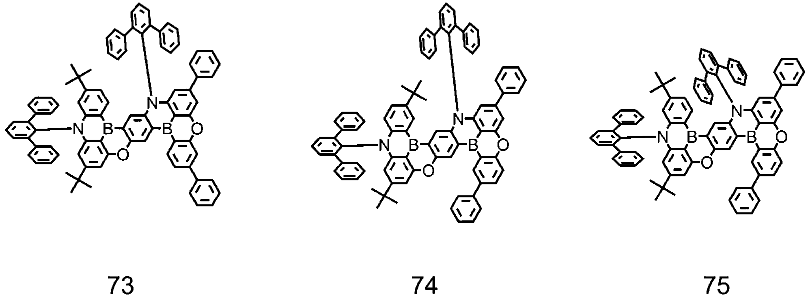

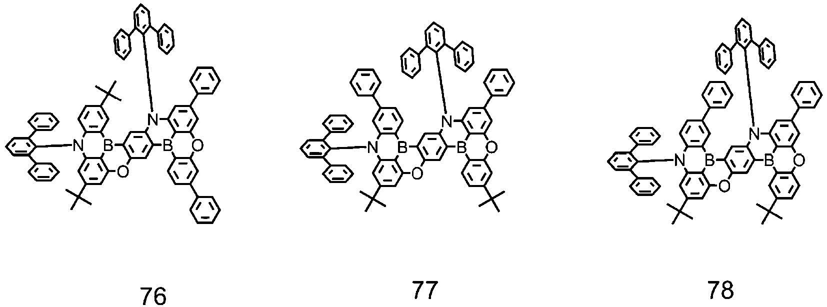

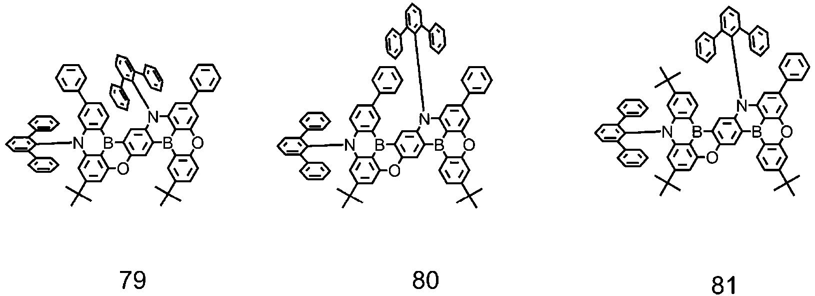

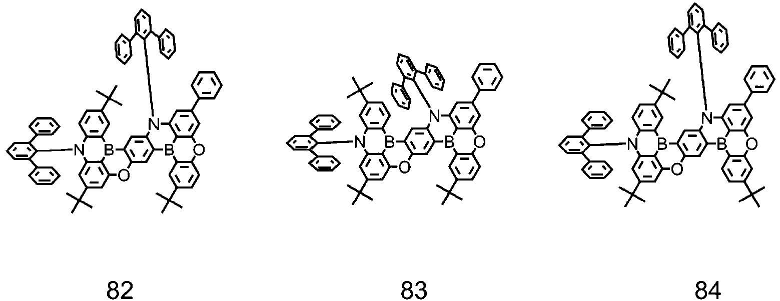

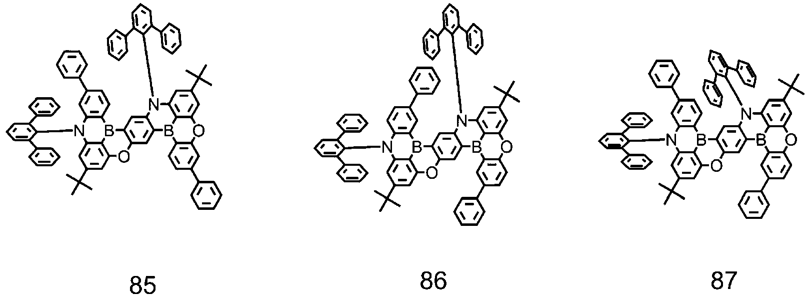

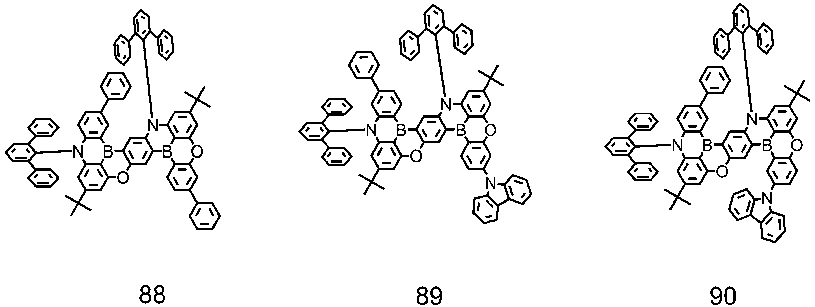

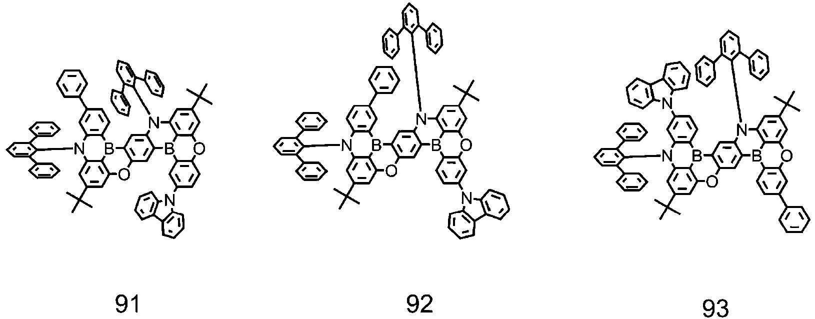

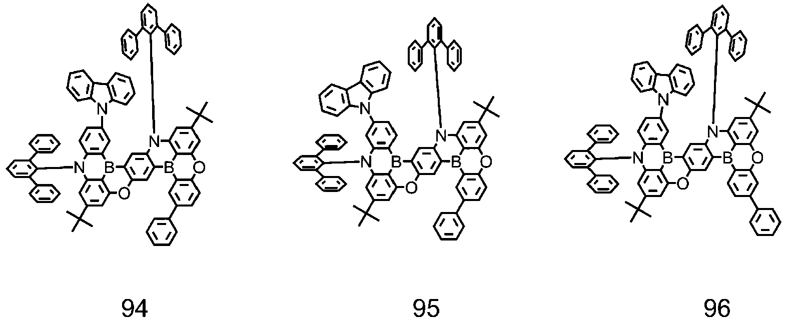

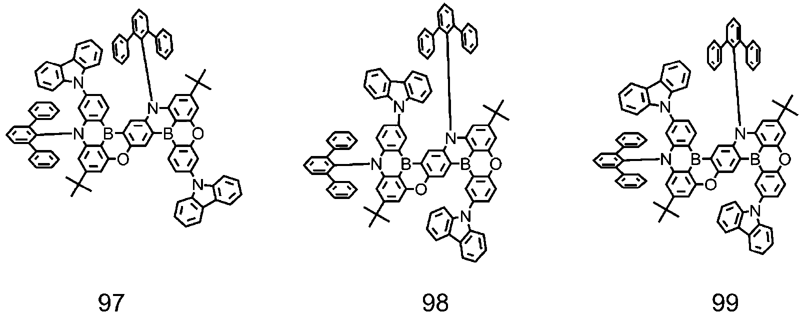

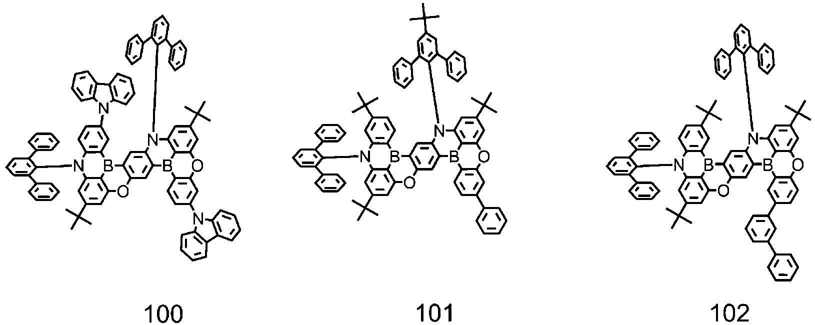

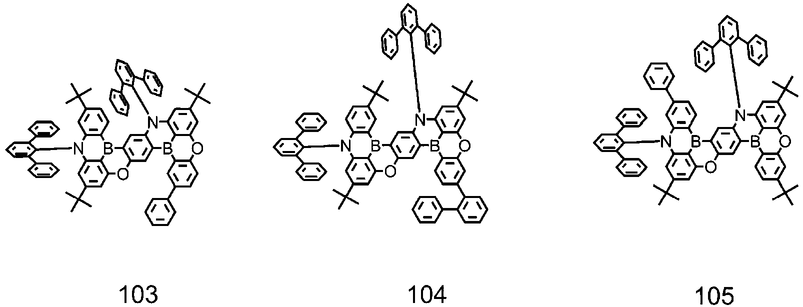

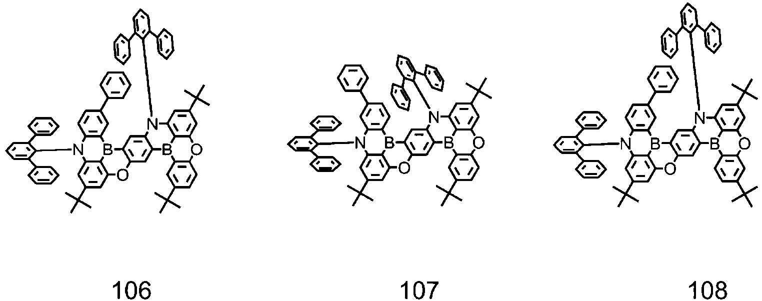

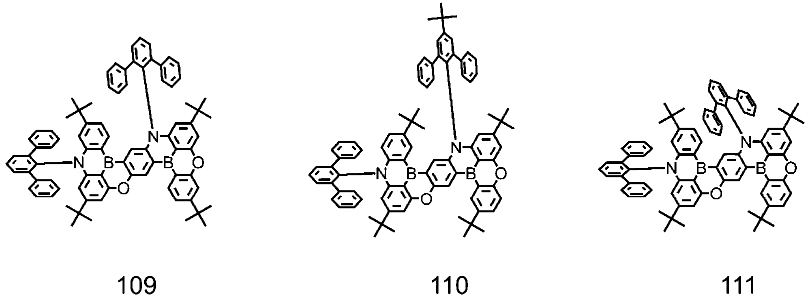

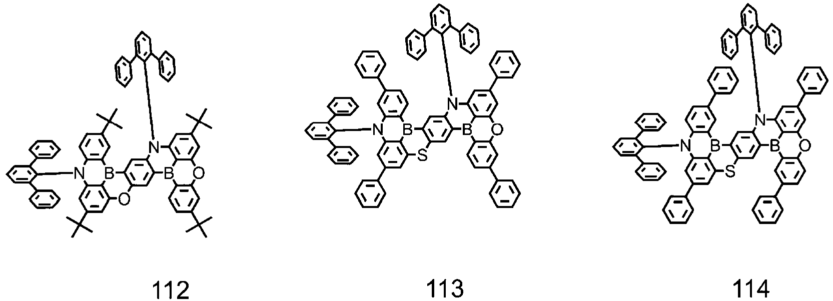

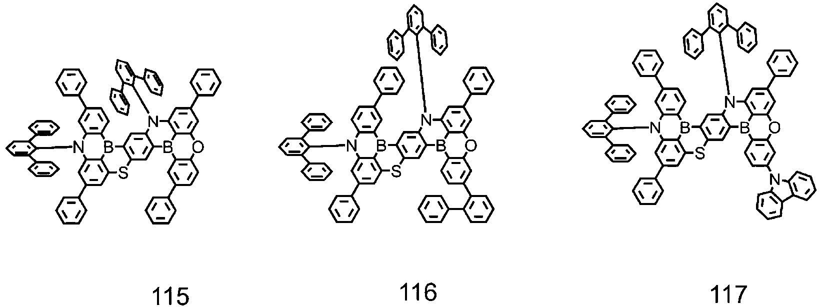

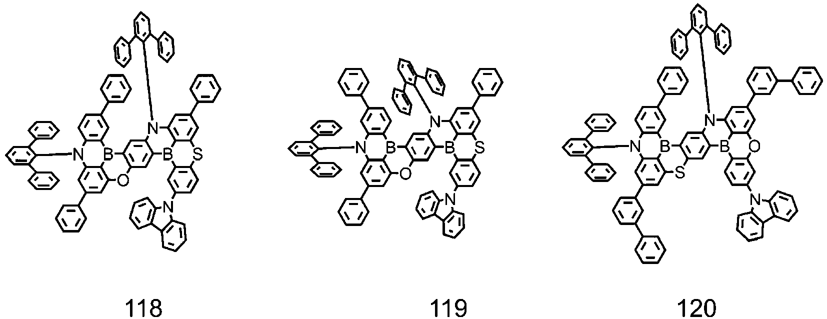

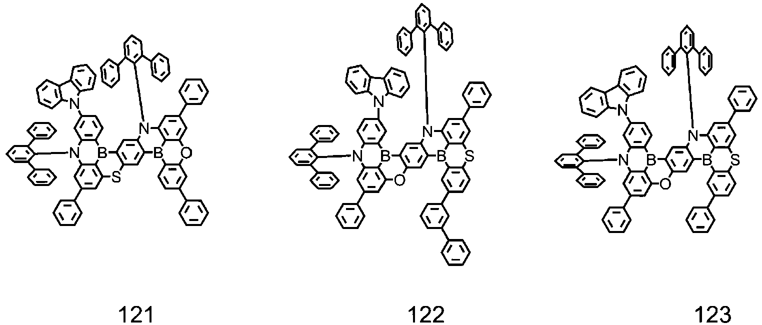

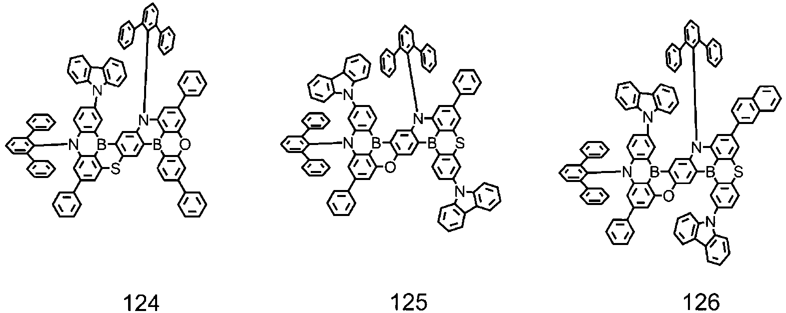

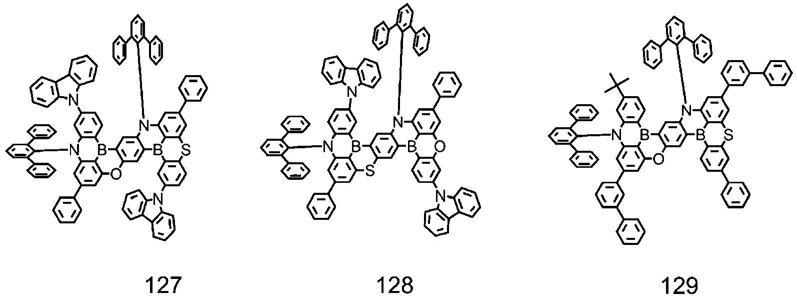

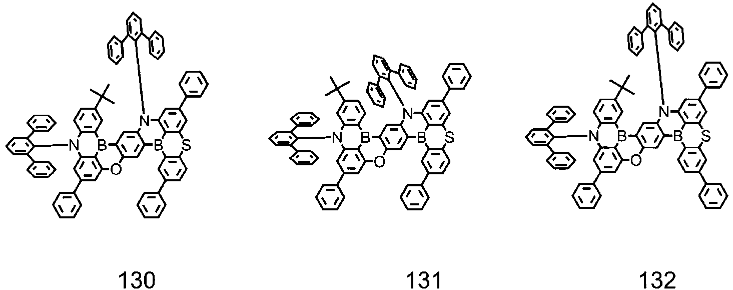

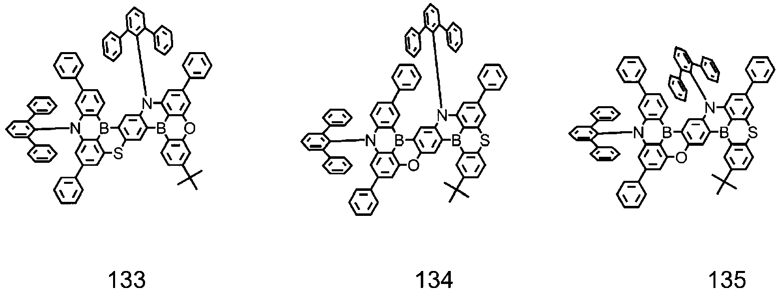

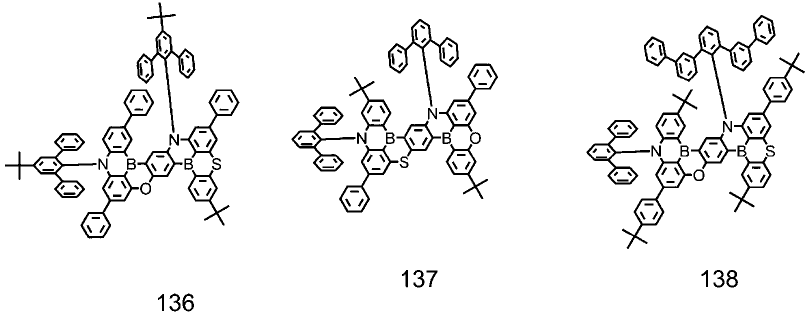

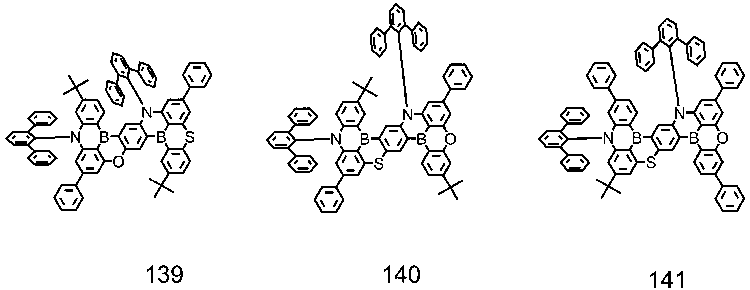

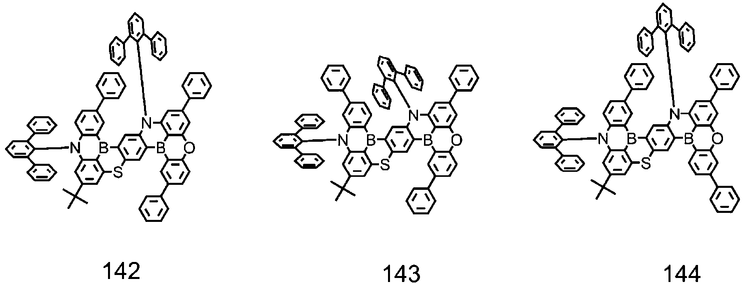

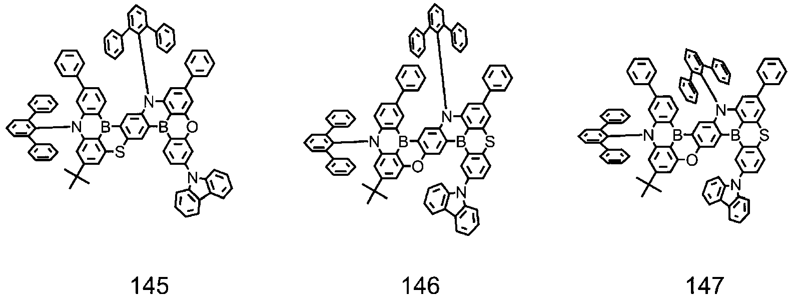

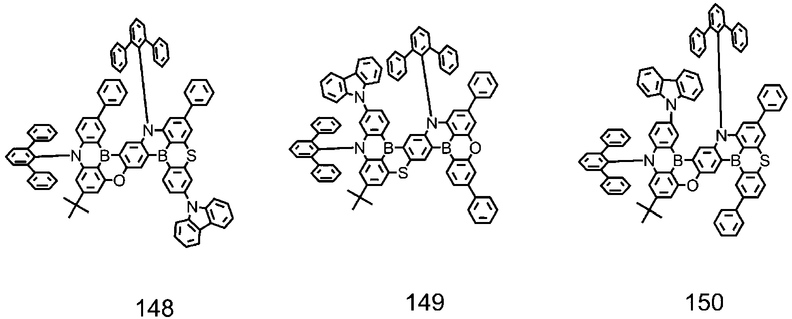

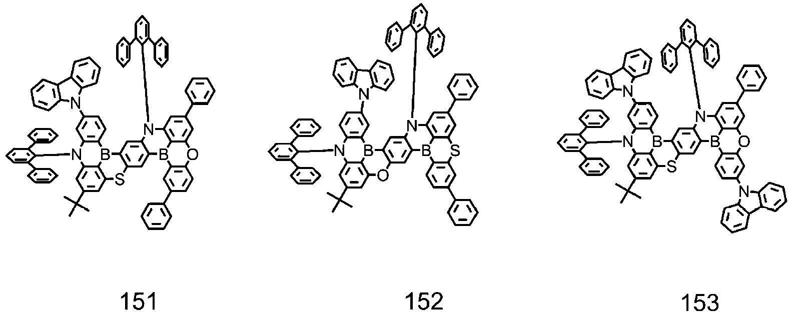

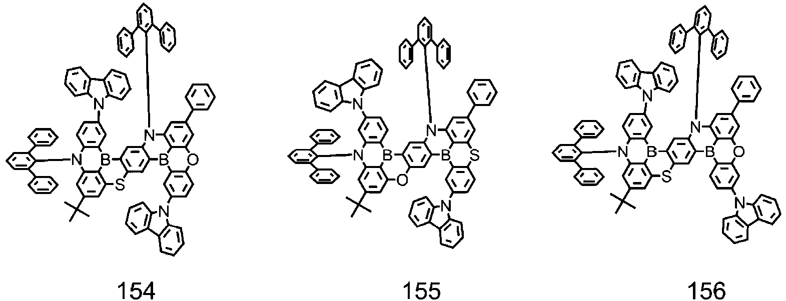

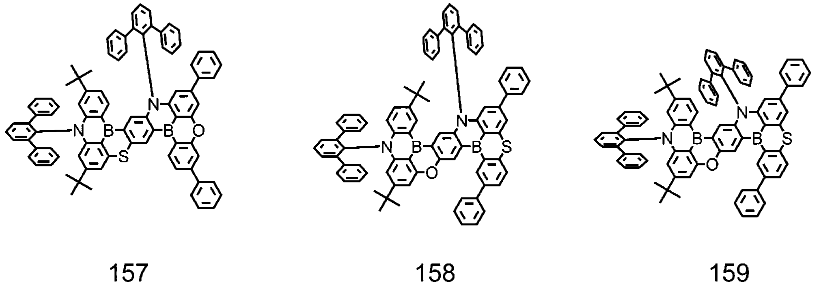

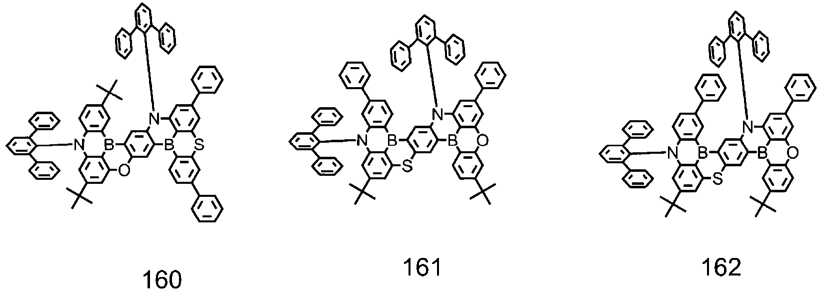

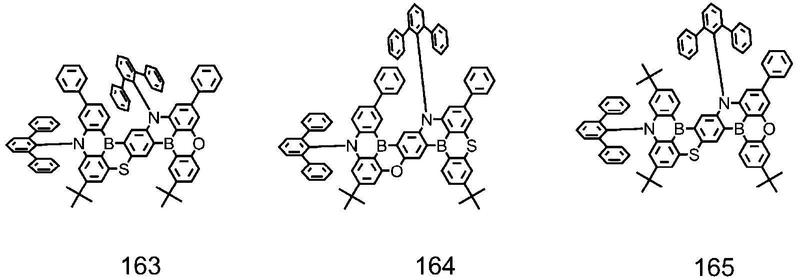

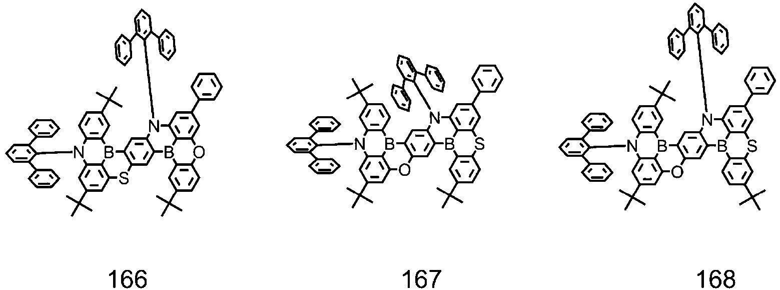

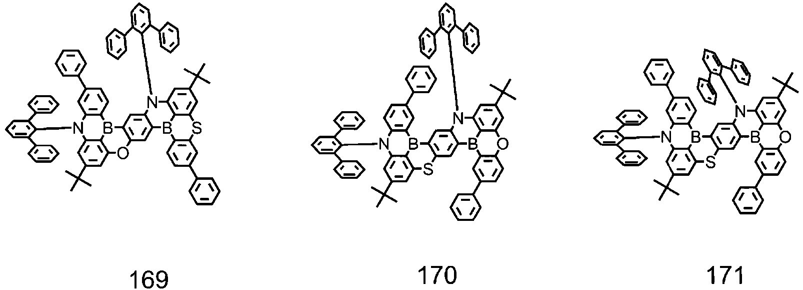

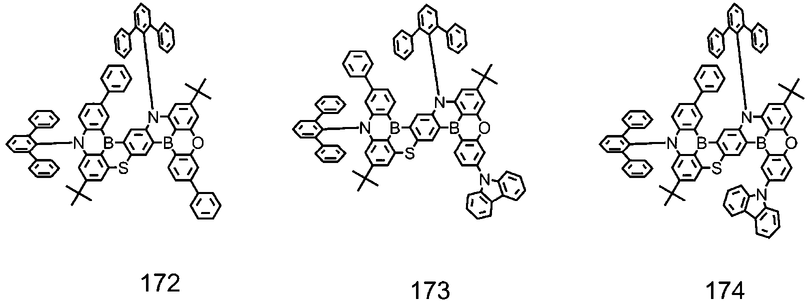

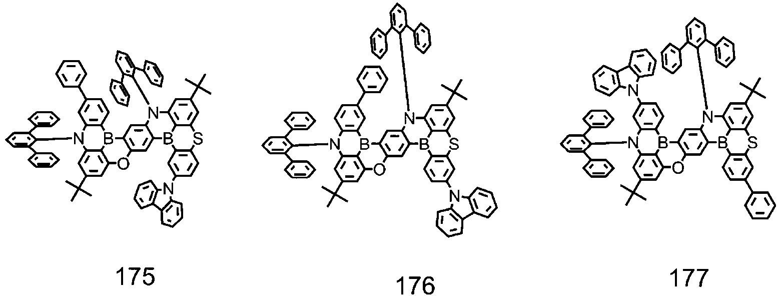

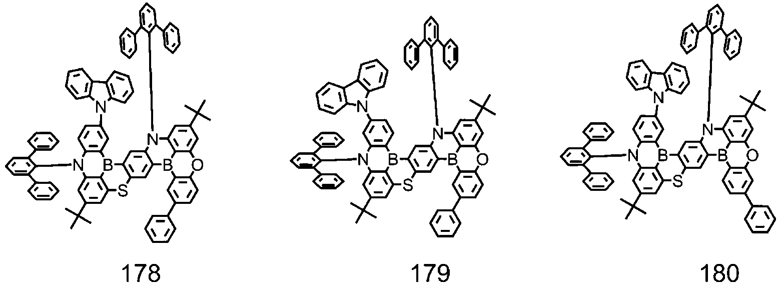

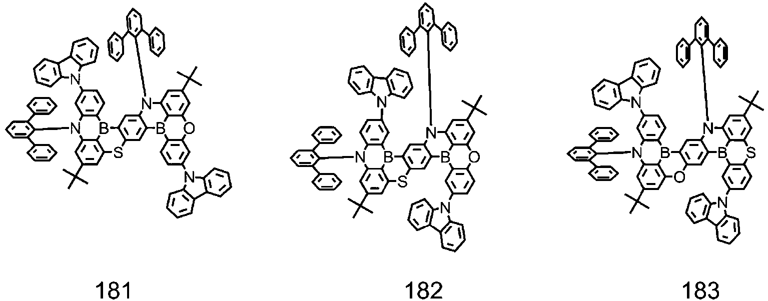

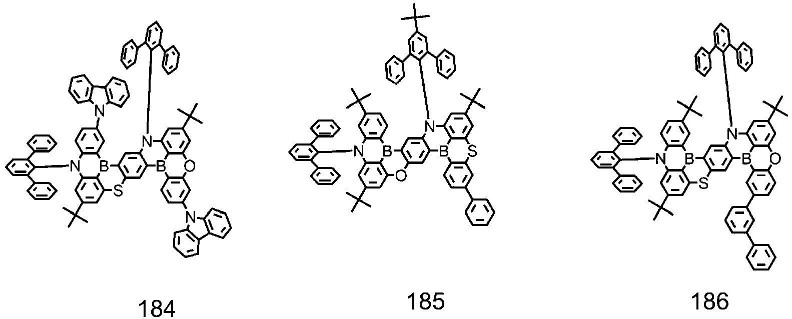

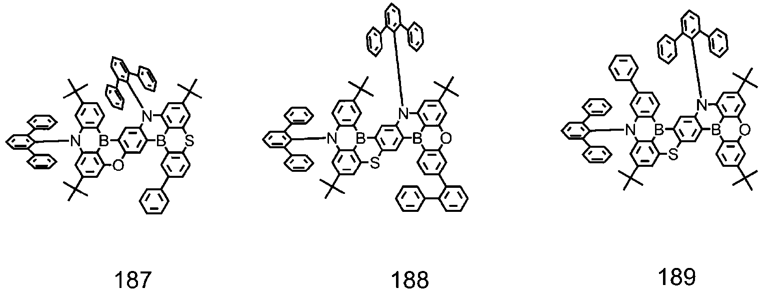

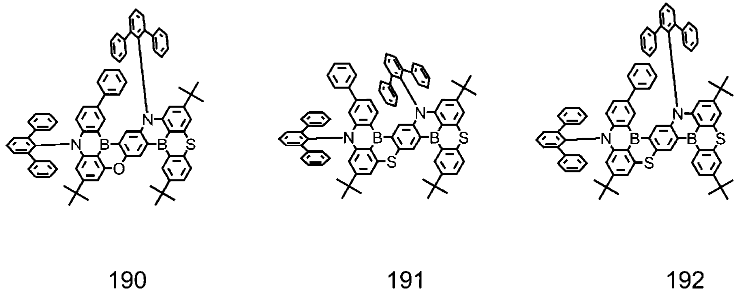

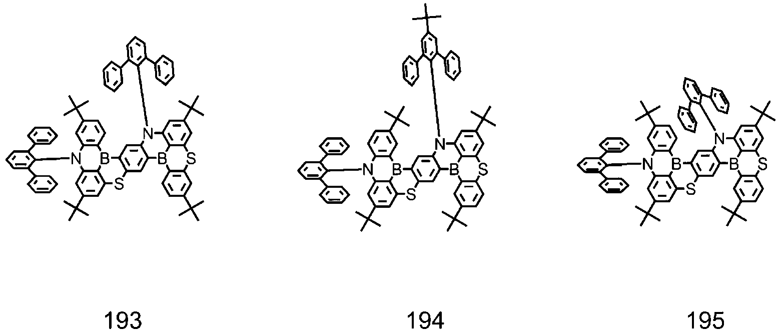

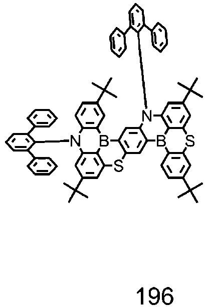

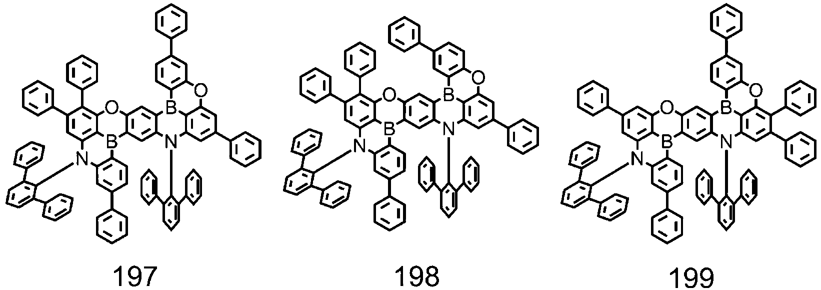

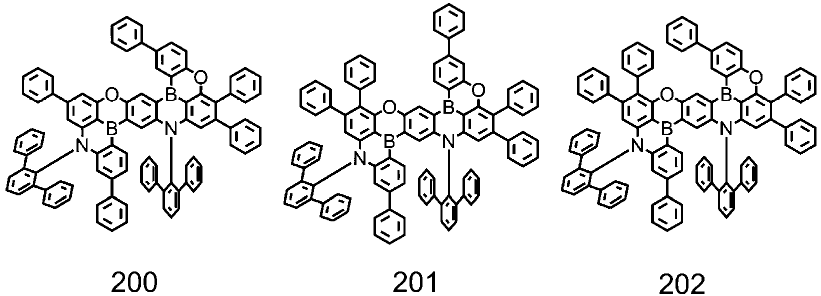

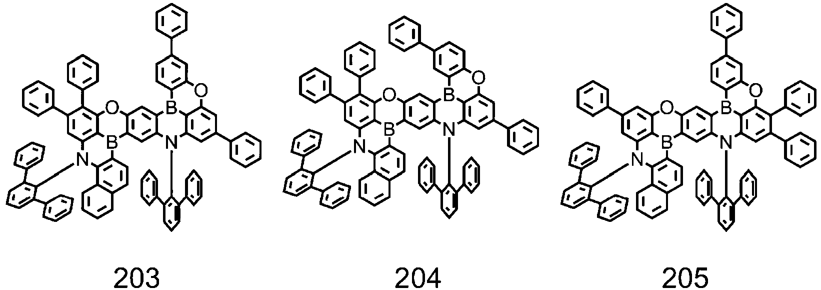

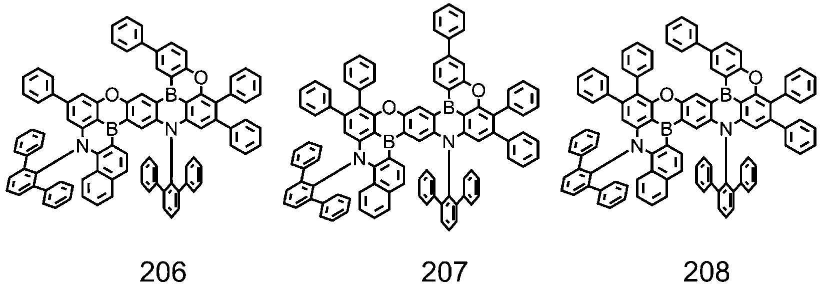

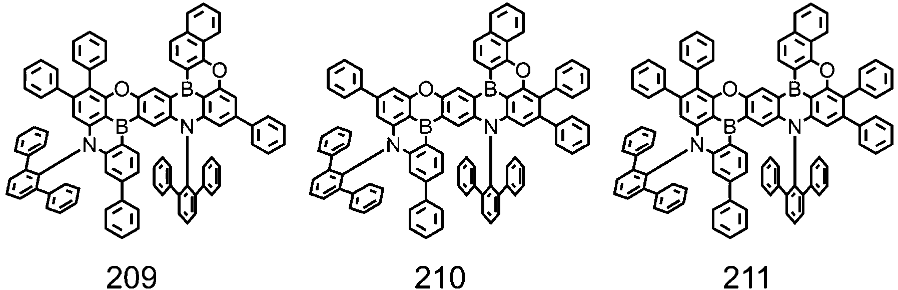

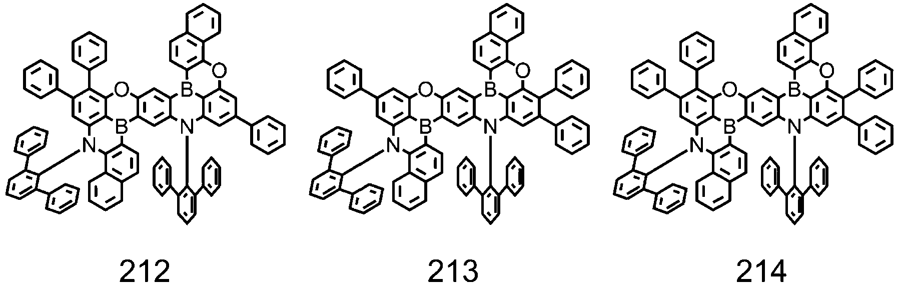

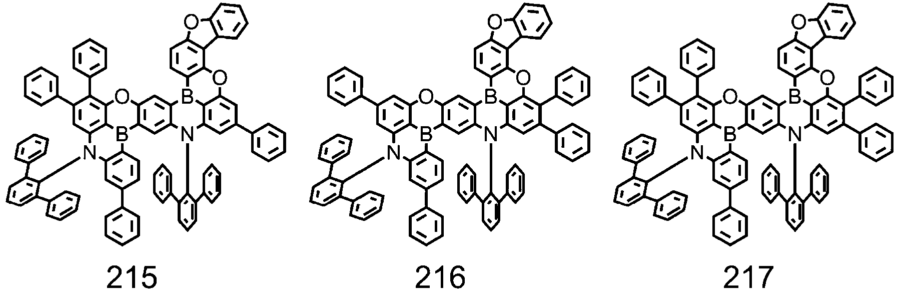

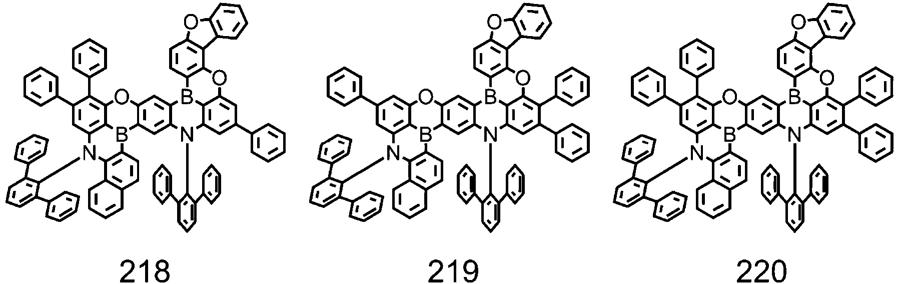

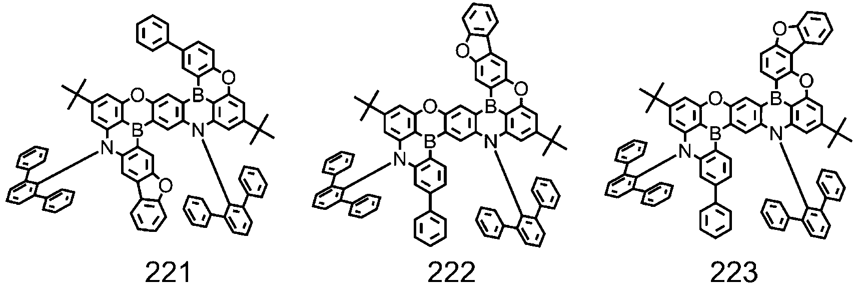

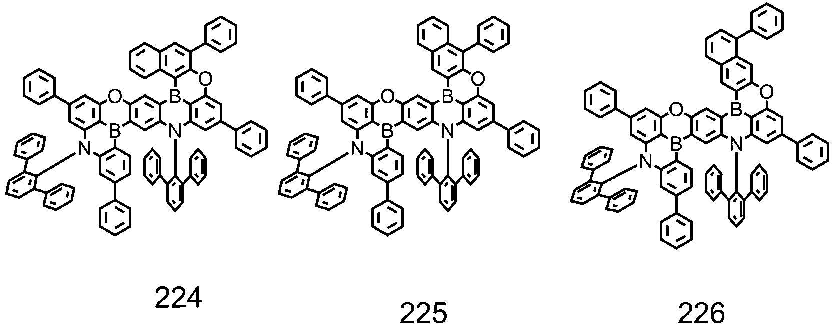

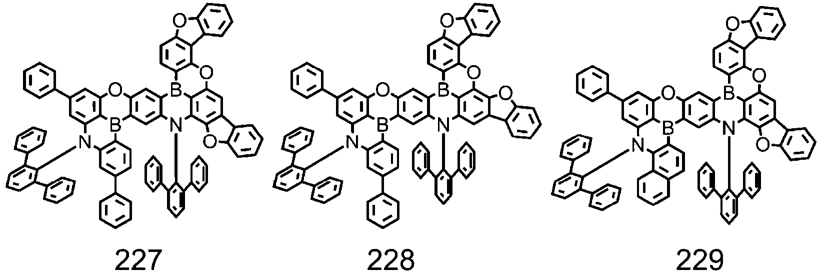

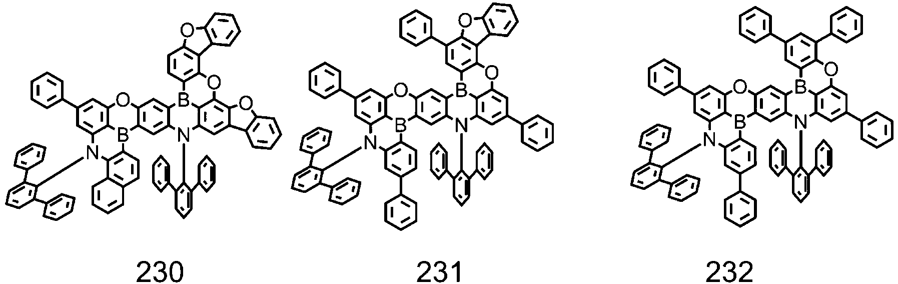

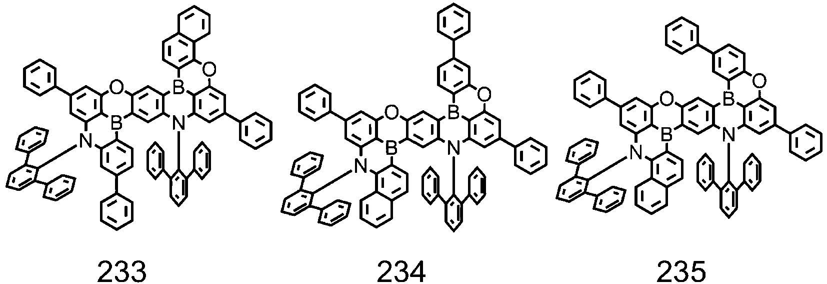

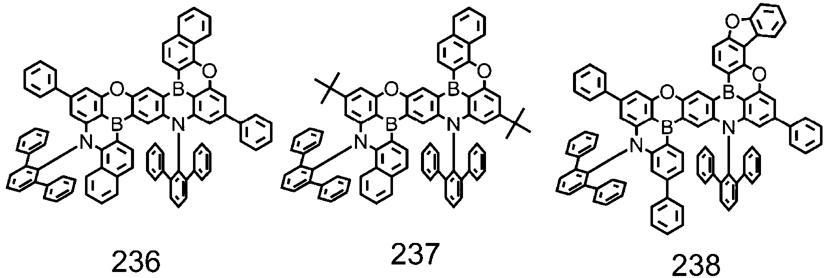

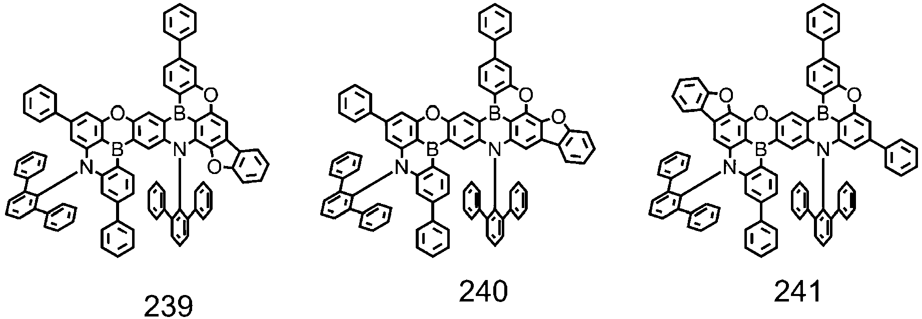

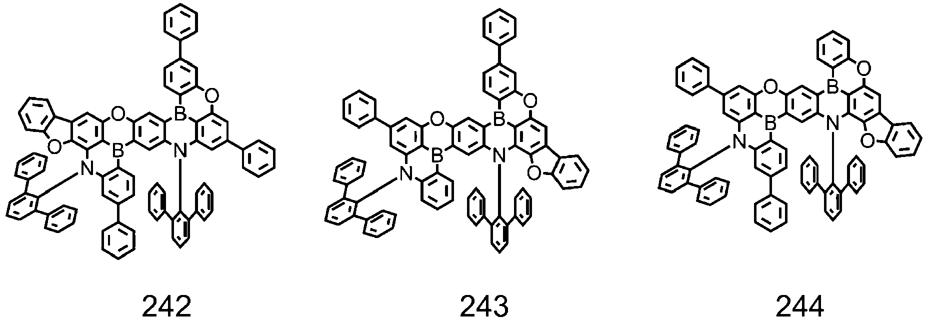

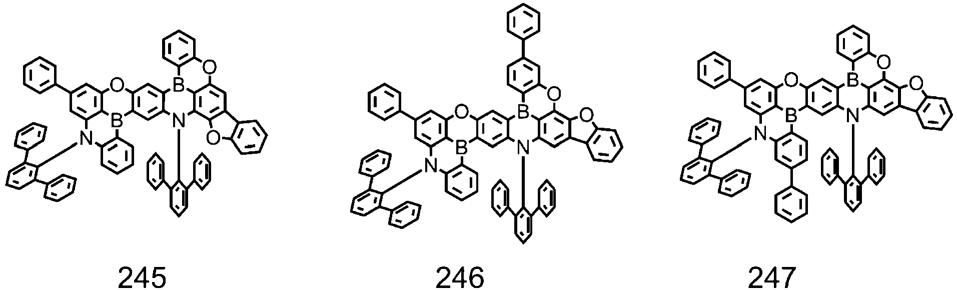

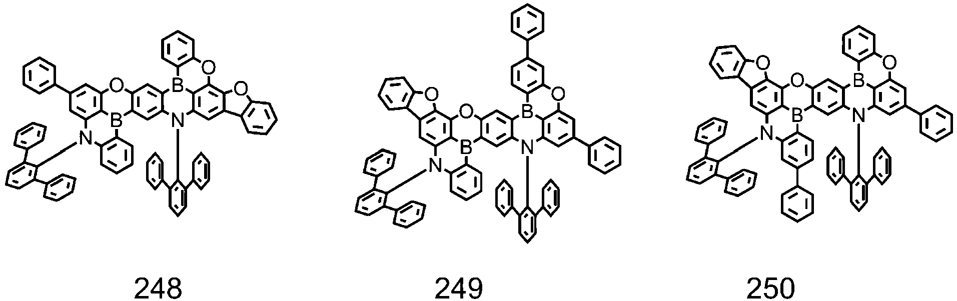

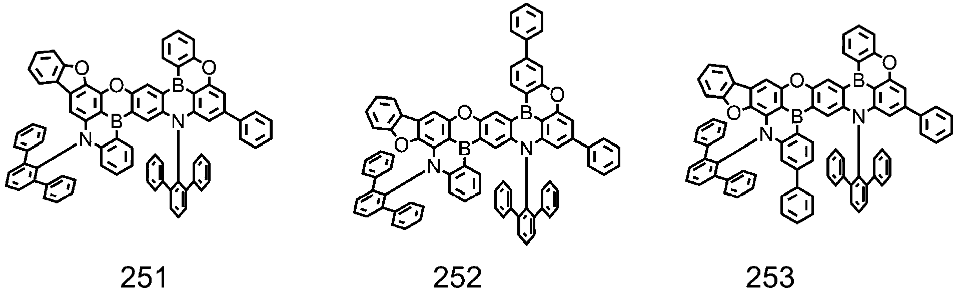

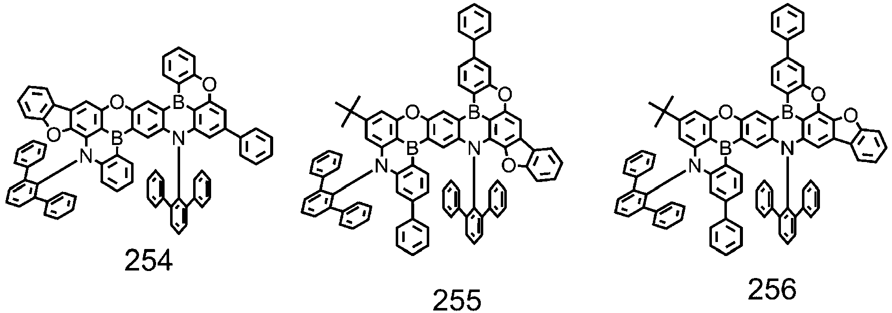

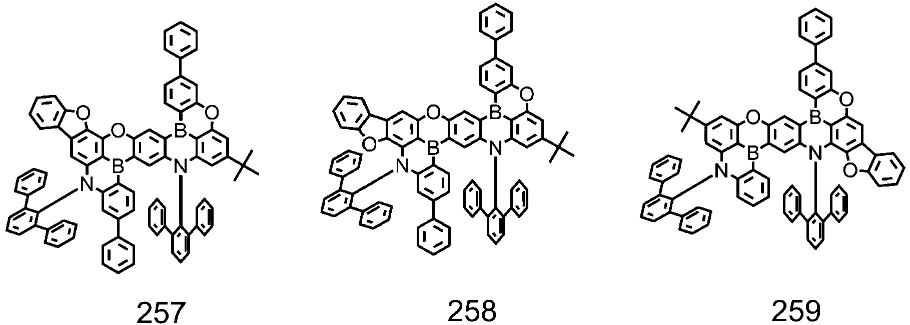

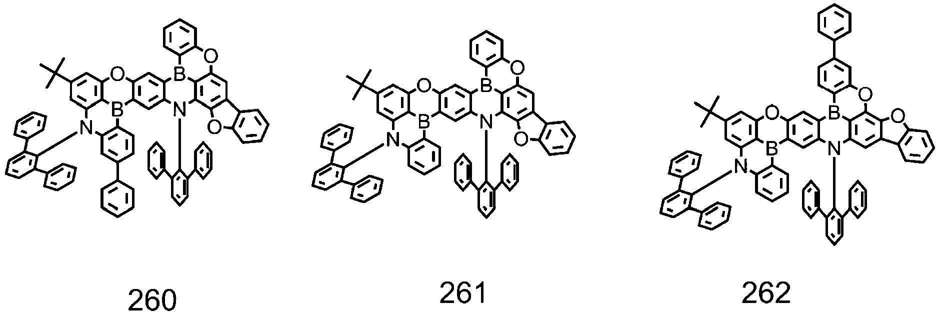

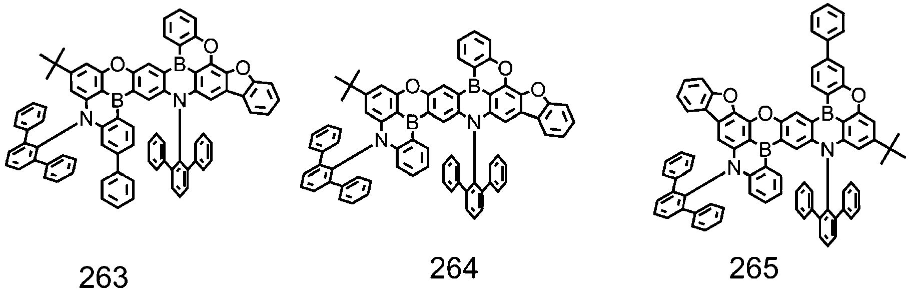

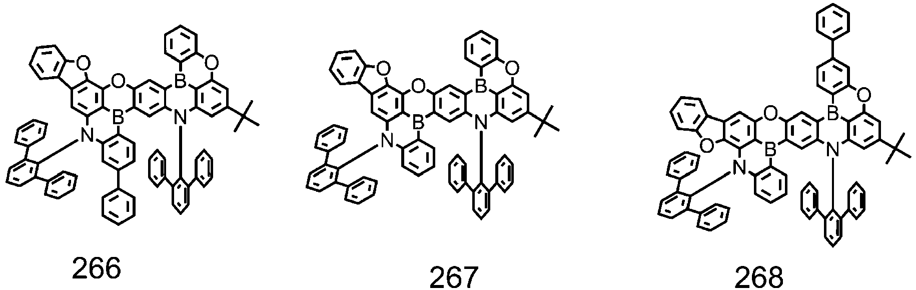

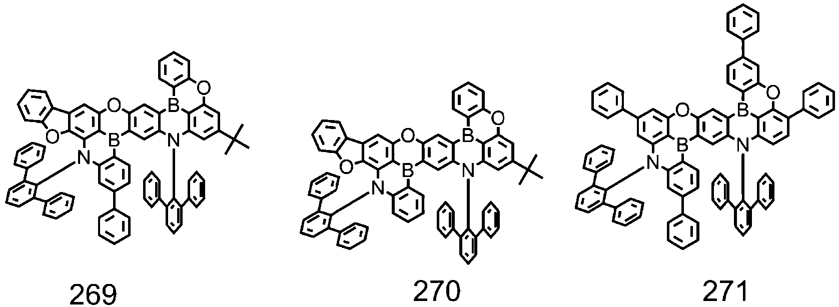

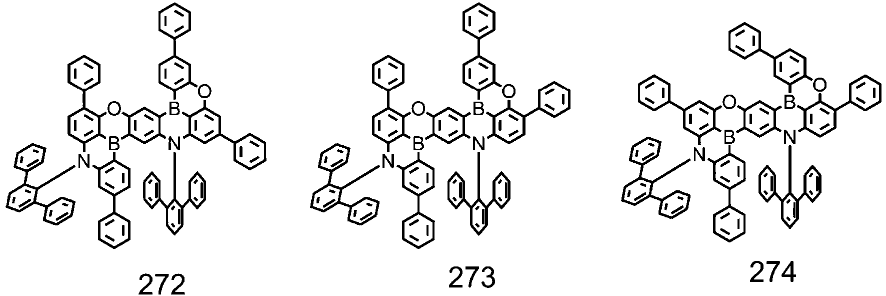

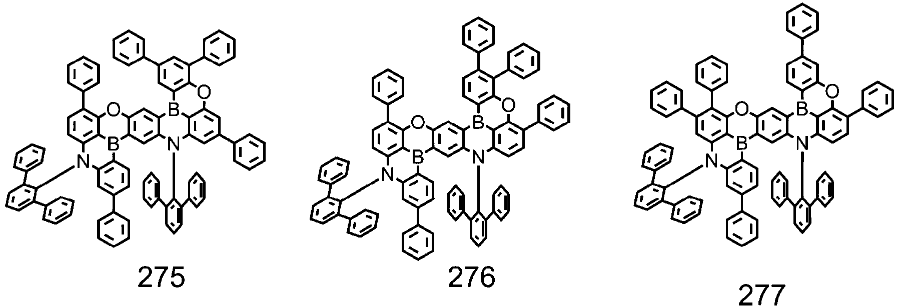

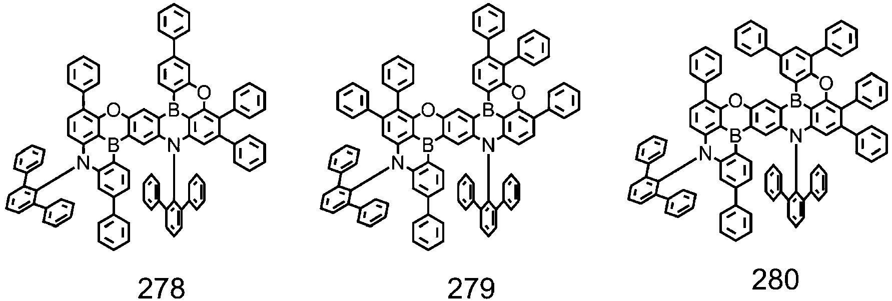

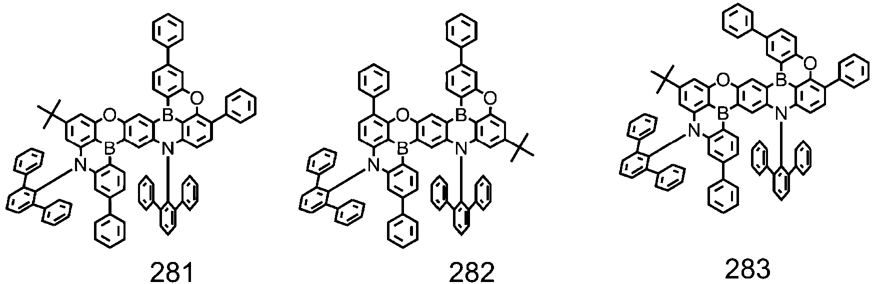

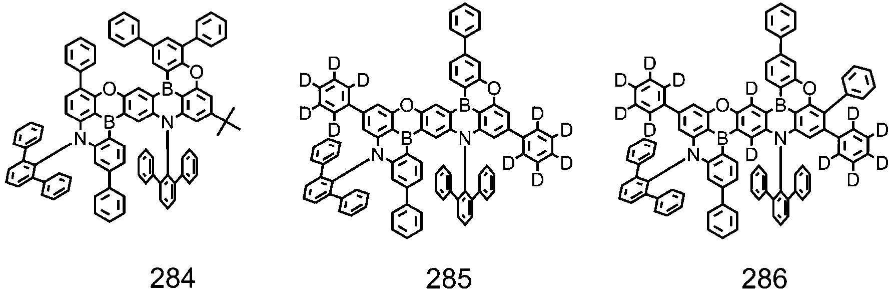

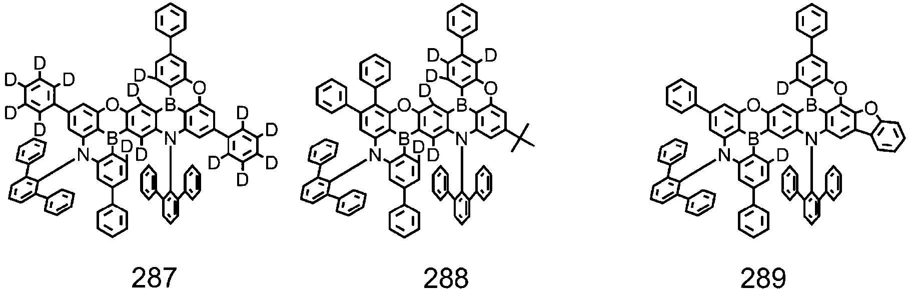

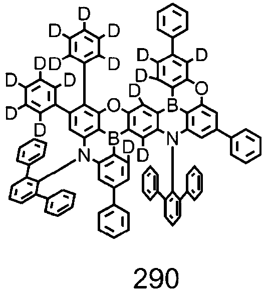

The condensed heterocyclic compound may have a heterocyclic core structure including boron, nitrogen and a chalcogen atom such as O and/or S, and may include an ortho-terphenyl moiety bonded to nitrogen. A nitrogen atom includes an unshared/lone electron pair, so that the ortho-terphenyl group may faces in a vertical direction based on a light-emitting core plane of the compound. Accordingly, a distance between the core plane of the condensed heterocyclic compound and a host may be increased, and a side reaction of a boron atom (e.g., Dexter energy transfer) due to intermolecular interaction may be reduced, thereby improving life-span properties of a light-emitting device including the compound.

Additionally, the condensed heterocyclic compound may include two nitrogen atoms and may include ortho-terphenyl moieties bonded to each of the nitrogen atoms. Accordingly, the condensed heterocyclic compound may have a balanced molecular structure, and as a result, the compound decay due to exciton or polaron may be prevented or reduced.

In one or more embodiments, the condensed heterocyclic compound may be included as a dopant in the emission layer of the light-emitting device that will be described in more detail later.

In the light-emitting device, the condensed heterocyclic compound may be used as a green light-emitting dopant.

In one or more embodiments, a maximum emission wavelength (e.g., peak emission wavelength) of the green light may be in a range from about 500 nm to about 540 nm, from about 515 nm to about 555 nm, from about 510 nm to about 550 nm, from about 520 nm to about 540 nm, or from about 520 nm to about 530 nm.

### Light-Emitting Device

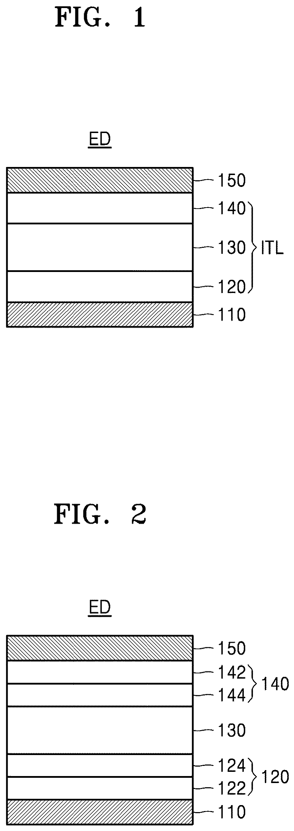

FIGS. 1 to 6 are each a schematic cross-sectional view illustrating light-emitting devices in accordance with one or more embodiments of the present disclosure.

Referring to FIG. 1, a light-emitting device ED includes a first electrode 110, a second electrode 150, and an intermediate layer ITL interposed between the first electrode 110 and the second electrode 150. The intermediate layer ITL includes an emission layer 130. The intermediate layer ITL may further include a hole transfer region 120 and an electron transfer region 140.

The first electrode 110 may be an anode or a cathode. In one or more embodiments, the first electrode 110 may be an anode, and may serve as a pixel electrode. In these embodiments, the first electrode 110 may include a conductive material with a high work function that promotes hole injection.

In one or more embodiments, the first electrode 110 may be a transmissive electrode. The first electrode 110 may include a transparent conductive oxide such as indium tin oxide (ITO), indium zinc oxide (IZO), zinc oxide (ZnO), indium tin zinc oxide (ITZO), and/or the like.

In one or more embodiments, the first electrode 110 may be a translucent electrode or a reflective electrode. The first electrode 110 may include at least one selected from among silver (Ag), magnesium (Mg), copper (Cu), aluminium (Al), platinum (Pt), palladium (Pd), gold (Au), nickel (Ni), neodymium (Nd), iridium (Ir), chromium (Cr), lithium (Li), calcium (Ca), lithium fluoride (LiF), molybdenum (Mo), titanium (Ti), tungsten (W), indium (In), tin (Sn), zinc (Zn), and an alloy containing at least two selected therefrom. For example, in one or more embodiments, the first electrode 110 may include Li, Ca, LiF/Ca (a stacked structure of LiF and Ca), LiF/Al (a stacked structure of LiF and Al), a mixture of Ag and Mg, and/or the like.

The first electrode 110 may have a single-layered structure or a multi-layered structure. For example, in one or more embodiments, the first electrode 110 may have a triple-layered structure of ITO/Ag/ITO.

A thickness of the first electrode 110 may be in a range of about 700 angstroms (Å) to about 10,000 Å. For example, in one or more embodiments, the thickness of the first electrode 110 may be in a range of about 1,000 Å to about 3,000 Å.

The second electrode 150 may be a cathode or an anode. In one or more embodiments, the second electrode 150 may serve as an electron injection electrode or as a cathode. The second electrode 150 may include a metal, an alloy, an electrically conductive compound, and/or the like, having a low work function.

For example, in one or more embodiments, the second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, and/or the like. The second electrode 150 may include one of the aforementioned materials, or a (e.g., any suitable) combination thereof.

The second electrode 150 may be a transmissive electrode, a translucent electrode, or a reflective electrode. The second electrode 150 may have a single-layered structure or a multi-layered structure.

The emission layer 130 includes the above-described condensed heterocyclic compound. In one or more embodiments, the condensed heterocyclic compound may serve as a fluorescent dopant. For example, in one or more embodiments, the condensed heterocyclic compound may serve as a thermally activated delayed fluorescence (TADF) dopant.

In one or more embodiments, the condensed heterocyclic compound may be included as a green light-emitting dopant. For example, the condensed heterocyclic compound may be included as a light-emitting material having an emission central wavelength in a range of about 520 nm to about 540 nm.

In one or more embodiments, the emission layer 130 may further include a dopant represented by Chemical Formula FD. For example, a compound represented by Chemical Formula FD may be used as a fluorescent dopant.

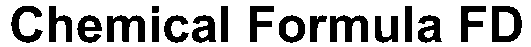

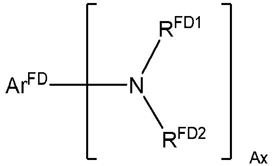

In Chemical Formula FD, Ar^{FD}, R^{FD1}, and R^{FD2} may each independently be a substituted or unsubstituted C₃-C₆₀ carbocyclic group or a substituted or unsubstituted C₁-C₆₀ heterocyclic group. Ax may be an integer from 1 to 6.

In one or more embodiments, Ar^{FD} may include a condensed ring structure in which three or more aryl rings or benzene rings are condensed together (e.g., an anthracene group, a chrysene group, a pyrene group, and/or the like).

In one or more embodiments, the emission layer 130 may include a phosphorescent dopant. The phosphorescent dopant may include an organometallic compound that includes a central metal and at least one ligand bonded to the central metal via a coordinate bond. The central metal may include, e.g., a transition metal, and the ligand may include, e.g., a monodentate ligand, a bidentate ligand, a tridentate ligand, a tetradentate ligand, a pentadentate ligand, a hexadentate ligand, and/or a (e.g., any suitable) combination thereof.

In one or more embodiments, the phosphorescent dopant may include, e.g., a compound represented by Chemical Formula PD.

**Chemical Formula PD** **M(L_{d}¹)_{dx1}(Ld²)_{dx2}**

In Chemical Formula PD, M may be a transition metal, e.g., iridium (Ir), platinum (Pt), palladium (Pd), osmium (Os), titanium (Ti), gold (Au), hafnium (Hf), europium (Eu), terbium (Tb), rhodium (Rh), rhenium (Re), ruthenium (Ru), copper (Cu), or thulium (Tm).

In Chemical Formula PD, L_{d}¹ may be a ligand represented by Chemical Formula LD1.

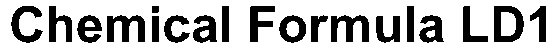

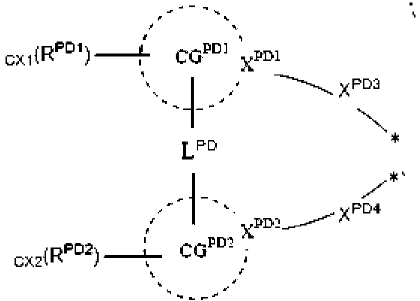

In Chemical Formula LD1, X^{PD1} and X^{PD2} may each independently be C or N.

In one or more embodiments, one of X^{PD1} and X^{PD2} may be C and the other may be N. In one or more embodiments, X^{PD1} and X^{PD2} may each be N.

In Chemical Formula LD1, CG^{PD1} and CG^{PD2} may each independently be a substituted or unsubstituted C₃-C₆₀ carbocyclic group or a substituted or unsubstituted C₁-C₆₀ heterocyclic group.

For example, CG^{PD1} and CG^{PD2} may each independently be a pyrrole group, a pyrazole group, an imidazole group, a triazole group, an oxazole group, an isoxazole group, a thiazole group, an isothiazole group, an oxadiazole group, a thiadiazole group, a benzene group, a pyridine group, a pyrimidine group, a naphthalene group, a dibenzofuran group, a dibenzothiophene group, a carbazole group, a fluorene group, a dibenzosilole group, a naphthobenzofuran group, a naphthobenzothiophene group, a benzocarbazole group, a benzofluorene group, a naphthobenzosilole group, a dinaphthofuran group, a dinaphthothiophene group, a dibenzocarbazole group, a dibenzofluorene group, a dinaphthosilole group, an azadibenzofuran group, an azadibenzothiophene group, an azacarbazole group, an azafluorene group, an azadibenzosilole group, an azanaphthobenzofuran group, an azanaphthobenzothiophene group, an azabenzocarbazole group, an azabenzofluorene group, an azanaphthobenzosilole group, an azadinapthofuran group, an azadinapthothiophene group, an azadibenzocarbazole group, an azadibenzofluorene group, or an azadinapthosilole group.

In Chemical Formula LD1, L^{PD} may be a single bond, a substituted or unsubstituted methylene group, a substituted or unsubstituted ethylene group, *-O-*', *-S-*', *-C(=O)-*', *-N(R^{PD3})-*', *-C(R^{PD4})=*', or *=C(R^{PDS})-*'.

In Chemical Formula LD1, X^{PD3} and X^{PD4} may each independently be a chemical bond, O, S, N(R^{PD6}), B(R^{PD7}), P(R^{PD8}), C(R^{PD8})(R^{PD9}), or Si(R^{PD10})(R^{PD11}). The chemical bond may be, e.g., a covalent bond or a coordinate bond.

In Chemical Formula LD1, R^{PD1} and R^{PD2} may each independently be hydrogen, deuterium, -F, -Cl, -Br, -I, -OH, -CN, -NO₂, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, a substituted or unsubstituted C₈-C₆₀ condensed polycyclic group, a substituted or unsubstituted silyl group, a substituted or unsubstituted amine group, a substituted or unsubstituted aniline group, -B(R^{PD12})(R^{PD13}), -C(=O)(R^{PD14}), - S(=O)₂(R^{PD15}), or -P(=O)(R^{PD16})(R^{PD17}). The silyl group may be represented by - Si(R^{sa})(R^{sb})(R^{sc}), as explained herein, and R^{sa}, R^{sb}, and R^{sc} may each independently be hydrogen, a halogen, a hydroxyl group, a C₁-C₆₀ alkyl group, a C₁-C₆₀ alkoxy group, a C₆-C₆₀ aryl group or a C₂-C₃₀ heteroaryl group.

R^{PD3} to R^{PD17} may each independently be hydrogen, deuterium, -F, -Cl, -Br, - I, -OH, -CN, -NO₂, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, or a substituted or unsubstituted C₈-C₆₀ condensed polycyclic group.

In Chemical Formula LD1, cx1 and cx2 may each independently be an integer from 0 to 10. When at least one of cx1 or cx2 is 2 or greater, two or more of R^{PD1} (s) and/or two or more of R^{PD2}(s) may be the same as or different from each other.

The symbols -* and -*' each represent a binding site where the ligand represented by Chemical Formula LD1 bonds to M.

In Chemical Formula PD, dx1 may be an integer from 1 to 3. When dx1 is 2 or 3, two or three of L_{d}¹(s) may be the same as or different from each other. Among two or three of L_{d}¹(s), CG^{PD1} and/or CG^{PD2} adjacent to each other may be connected to each other through a connecting group such as L^{PD1}, L^{PD2}, and/or the like. The connecting group such as L^{PD1} L^{PD2} and/or the like, may each independently be the same as defined with respect to L^{PD}

In Chemical Formula PD, L_{d}² may be an organic ligand. L_{d}² may include, e.g., a halogen, CO, NO, CS, picolinate, acetate, oxalate, a diketone group, an isonitrile group, isothiocyanato-N, thiosulphato-S, an alkyl phosphine, phenylphosphine, an aryl phosphine, phosphine oxide, phosphite, or a (e.g., any suitable) combination thereof.

In Chemical Formula PD, dx2 is an integer of 0 to 4. When dx2 is 2 or greater, two or more of L_{d}²(s) may be the same as or different from each other.

In one or more embodiments, the emission layer 130 may include one or more selected from among a styryl derivative (e.g., 1,4-bis[2-(3-N-ethylcarbazolyl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (NBDAVBi), and/or the like), 4,4'-bis[2-(4-(N,N-diphenylamino)phenyl)vinyl]biphenyl (DPAVBi), perylene or a derivative thereof (e.g., 2,5,8,11-etra-t-butylperylene (TBP)), pyrene or a derivative thereof (e.g., 1,1-dipyrene, 1,4-dipyrenylbenzene, 1,4-bis(N,N-diphenylamino)pyrene), and/or the like), and/or the like, as a fluorescent dopant material.

In one or more embodiments, the emission layer 130 may include a metal complex that includes iridium (Ir), platinum (Pt), osmium (Os), gold (Au), titanium (Ti), zirconium (Zr), hafnium (Hf), europium (Eu), terbium (Tb), or thulium (Tm) as a phosphorescent dopant, in addition to one or more of the materials described above. For example, Flrpic (iridium(III) bis(4,6-difluorophenylpyridinato-N,C2')picolinate), Flr6 (bis(2,4-difluorophenylpyridinato)-tetrakis(1-pyrazolyl)borate iridium(III)), PtOEP (platinum octaethyl porphyrin), and/or the like, may be used as a phosphorescent dopant.

The above-described dopant materials may be used alone or in a combination of two or more selected therefrom.

The emission layer 130 may include a host that may interact with the above-described dopant. For example, in one or more embodiments, the emission layer 130 may include a host material widely suitable in the related art, such as an anthracene derivative, a pyrene derivative, a fluoranthene derivative, a chrysene derivative, a dihydrobenzanthracene derivative, a triphenylene derivative, and/or the like.

In one or more embodiments, the emission layer 130 may include, e.g., a host material represented by Chemical Formula FH. For example, the compound represented by Chemical Formula FH may be used as a fluorescent host material. 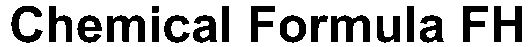 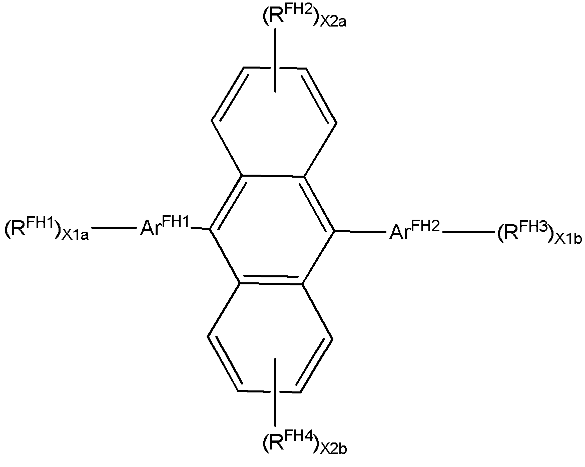 In Chemical Formula FH, R^{FH1} to R^{FH4} may each independently be hydrogen, deuterium, a halogen, a substituted or unsubstituted silyl group, a substituted or unsubstituted thio group, a substituted or unsubstituted oxy group, a substituted or unsubstituted C₁-C₁₀ alkyl group, a substituted or unsubstituted C₂-C₁₀ alkenyl group, a substituted or unsubstituted C₆-C₃₀ aryl group, a substituted or unsubstituted C₆-C₃₀ heteroaryl group, or a cyclic group formed through a combination thereof. In one or more embodiments, in Chemical Formula FH, at least one selected from among R^{FH1} to R^{FH4} may form a condensed ring with a bonded benzene ring.

In Chemical Formula FH, Ar^{FH1} and Ar^{FH2} may each independently be a substituted or unsubstituted C₆-C₃₀ arylene group, a substituted or unsubstituted C₂-C₃₀ heteroarylene group, or a divalent cyclic group formed by thereof.

In Chemical Formula FH, x1a and x1b may each independently be an integer from 0 to 5; and x2a and x2b may each independently be an integer from 0 to 4. When x1a, x1b, x2a, and x2b are each 2 or greater, two or more selected from among respective R^{FH1}(s) to R^{FH4}(s) may be the same as or different from each other.

In one or more embodiments, the emission layer 130 may include, e.g., a host material represented by Chemical Formula PH. For example, the compound represented by Chemical Formula PH may be used as a host material for a phosphorescent device (e.g., for a phosphorescent dopant).

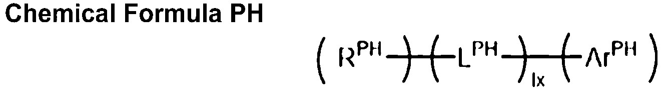

In Chemical Formula PH, R^{PH} may be a substituted or unsubstituted carbazole group. L^{PH} may be a direct linkage, a substituted or unsubstituted C₆-C₃₀ arylene group, or a substituted or unsubstituted C₂-C₃₀ heteroarylene group. Ar^{PH} may be a substituted or unsubstituted C₆-C₃₀ aryl group or a substituted or unsubstituted C₂-C₃₀ heteroaryl group.

As described above in the definition of terminology, the term "C₆-C₃₀ aryl group" may encompass a group in which multiple aryl rings are condensed or bonded through a cyclic group (e.g., an alicyclic hydrocarbon ring). For example, a C₆-C₃₀ aryl group may be a fluorenyl group.

As described above in the definition of terminology, the term "C₂-C₃₀ heteroaryl group" may encompass a group in which multiple aryl rings are condensed or bonded through a heterocyclic ring. For example, a C₂-C₃₀ heteroaryl group may be a carbazole group, a dibenzofuran group, a dibenzothiophene group, and/or the like. In one or more embodiments, a C₂-C₃₀ heteroaryl group may be a group in which multiple aryl rings are condensed or bonded to each other through the same or different heterocyclic rings.

In one or more embodiments, a substituent included in Ar^{PH} may be a silyl group represented by -Si(R^{sa})(R^{sb})(R^{sc}); and R^{sa}, R^{sb}, and R^{sc} may each independently be hydrogen, a halogen, a hydroxyl group, a C₁-C₆₀ alkyl group, a C₁-C₆₀ alkoxy group, a C₆-C₆₀ aryl group, or a C₂-C₃₀ heteroaryl group. At least one selected from among R^{sa}, R^{sb}, and R^{sc} may be a C₆-C₆₀ aryl group or a C₂-C₃₀ heteroaryl group. For example, in one or more embodiments, R^{sa}, R^{sb}, and R^{sc} may each independently be a C₆-C₆₀ aryl group or a C₂-C₃₀ heteroaryl group.

In Chemical Formula PH, Ix may be an integer from 0 to 10. When Ix is 2 or greater, two or more of L^{PH}(s) may be the same as or different from each other.

In one or more embodiments, the emission layer 130 may include, e.g., BCPDS (bis (4-(9H-carbazol-9-yl) phenyl) diphenylsilane), POPCPA ((4-(1-(4-(diphenylamino) phenyl) cyclohexyl) phenyl) diphenyl-phosphine oxide), DPEPO (bis[2-(diphenylphosphino)phenyl] ether oxide), mCBP (3,3'-di(9H-carbazol-9-yl)-1,1'-biphenyl), CBP (4,4'-bis(N-carbazolyl)-1,1'-biphenyl), mCP (1,3-bis(carbazol-9-yl)benzene), PPF (2,8-bis(diphenylphosphoryl) dibenzo[b,d]furan), TCTA (4,4',4"-tris(carbazol-9-yl)-triphenylamine), TPBi (1,3,5-tris(1-phenyl-1H-benzo[d]imidazol-2-yl)benzene), Alq3 (tris(8-hydroxyquinolinato) aluminium), ADN (9,10-di(naphthalen-2-yl)anthracene), TBADN (2-tert-butyl-9,10-di(naphth-2-yl)anthracene), DSA (distyrylarylene), CDBP (4,4'-bis(9-carbazolyl)-2,2'-dimethyl-biphenyl), MADN (2-methyl-9,10-bis(naphthalen-2-yl)anthracene), CP1 (hexaphenyl cyclotriphosphazene), UGH2 (1,4-bis(triphenylsilyl)benzene), DPSiO3 (hexaphenylcyclotrisiloxane), DPSiO4 (octaphenylcyclotetrasiloxane), and/or the like, as a host material.

In one or more embodiments, in the emission layer 130, the host may include one of the materials described above, or any combination thereof.

In one or more embodiments, the emission layer 130 may include two or more host materials. For example, in one or more embodiments, the emission layer 130 may include a hole transporting host and an electron transporting host. In these embodiments, the emission layer 130 may include a hole transporting host, an electron transporting host, a photosensitive agent, and a dopant. In one or more embodiments, the hole transporting host and the electron transporting host may form an exciplex, and energy may be transferred from the exciplex to the photosensitive agent and from the photosensitive agent to the dopant, thereby inducing a light emission.

Non-limiting examples of the hole transporting host may include a compound represented by Chemical Formula HT.

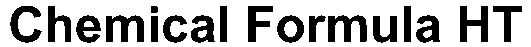

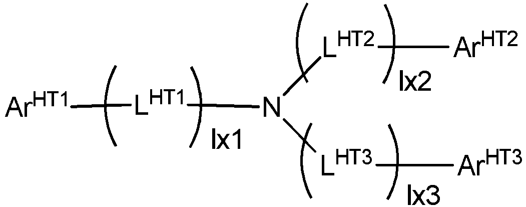

In Chemical Formula HT, L^{HT1}, L^{HT2}, and L^{HT3} are each independently a direct linkage, a substituted or unsubstituted C₆-C₃₀ arylene group, or a substituted or unsubstituted C₂-C₃₀ heteroarylene group.

In Chemical Formula HT, Ix1 to Ix3 are each independently an integer from 0 to 10. When Ix1, Ix2, or Ix3 is 2 or greater, two or more selected from among respective L^{HT1}(s), L^{HT2}(s), or L^{HT3}(s), may be directly connected by, e.g., carbon atoms (e.g., sp² carbons) of each aryl ring, to form a substituted or unsubstituted C₆-C₃₀ arylene group or a substituted or unsubstituted C₂-C₃₀ heteroarylene group. For example, when Ix1, Ix2, or Ix3 is 2 or greater, two or more of the respective L^{HT1}(s), L^{HT2}(s), or L^{HT3}(s) may be directly connected by carbon atoms (such as sp² carbons) of each aryl ring, forming a substituted or unsubstituted C₆-C₃₀ arylene group or a substituted or unsubstituted C₂-C₃₀ heteroarylene group. For example, when Ix1 is 2 or greater, two or more of L^{HT1}(s) may be directly connected by, e.g., carbon atoms (e.g., sp² carbons) of each aryl ring, to form a substituted or unsubstituted C₆-C₃₀ arylene group or a substituted or unsubstituted C₂-C₃₀ heteroarylene group. When lx2 is 2 or greater, two or more of L^{HT2}(s) may be directly connected by, e.g., carbon atoms (e.g., sp² carbons) of each aryl ring, to form a substituted or unsubstituted C₆-C₃₀ arylene group or a substituted or unsubstituted C₂-C₃₀ heteroarylene group. When Ix3 is 2 or greater, two or more of L^{HT3}(s) may be directly connected by, e.g., carbon atoms (e.g., sp² carbons) of each aryl ring, to form a substituted or unsubstituted C₆-C₃₀ arylene group or a substituted or unsubstituted C₂-C₃₀ heteroarylene group.

In Chemical Formula HT, Ar^{HT1} and Ar^{HT2} are each independently a substituted or unsubstituted C₆-C₃₀ aryl group or a substituted or unsubstituted C₂-C₃₀ heteroaryl group. Ar^{HT3} is a substituted or unsubstituted C₆-C₃₀ aryl group.

In one or more embodiments, the compound represented by Chemical Formula HT may be a monoamine compound. In one or more embodiments, the compound represented by Chemical Formula HT may be a diamine compound in which at least one selected from among Ar^{HT1} to Ar^{HT3} includes an amine group as a substituent.

In one or more embodiments, the compound represented by Chemical Formula HT may be a carbazole-based compound in which at least one of Ar^{HT1} or Ar^{HT2} includes a substituted or unsubstituted carbazole group, or a fluorene-based compound in which at least one of Ar^{HT1} or Ar^{HT2} includes a substituted or unsubstituted fluorene group.

In one or more embodiments, two adjacent groups among Ar^{HT1} to Ar^{HT3} may be condensed together to form a ring.

In a non-limiting example. the electron transporting host may include a compound represented by Chemical Formula ET.

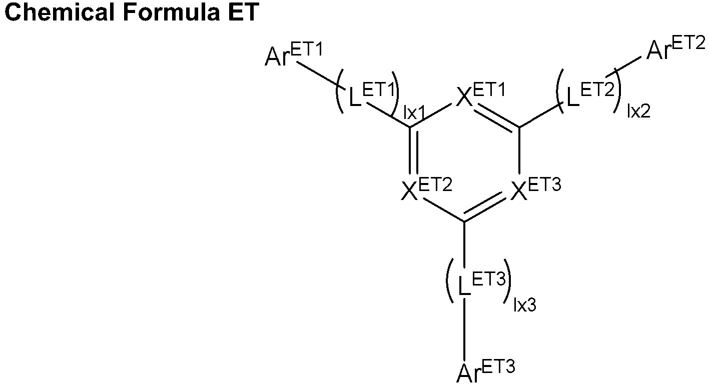

In Chemical Formula ET, at least one selected from among X^{ET1} to X^{ET3} is N, and the remainder of X^{ET1} to X^{ET3} are each independently C(R^{ET}). R^{ET} is hydrogen, deuterium, a substituted or unsubstituted C₁-C₂₀ alkyl group, a substituted or unsubstituted C₆-C₆₀ aryl group, or a substituted or unsubstituted C₂-C₆₀ heteroaryl group.

When one selected from among X^{ET1} to X^{ET3} is N, the compound represented by Chemical Formula ET may include a pyridine group. When two selected from among X^{ET1} to X^{ET3} are N, the compound represented by Chemical Formula ET may include a pyrimidine group. When X^{ET1} to X^{ET3} are each N, the compound represented by Chemical Formula ET may include a triazine group.

In Chemical Formula ET, Ix1 to Ix3 are each independently an integer from 0 to 10. L^{ET1} to L^{ET3} are each independently a direct linkage, a substituted or unsubstituted C₆-C₃₀ arylene group, or a substituted or unsubstituted C₂-C₃₀ heteroarylene group.

When Ix1, Ix2, or Ix3 is 2 or more, two or more selected from among respective L^{ET1}(s), L^{ET2}(s), or L^{ET3}(s), may be directly linked together, e.g., by carbon atoms of each aryl ring (e.g., sp² carbons), to form a substituted or unsubstituted C₆-C₃₀ arylene group or a substituted or unsubstituted C₂-C₃₀ heteroarylene group. For example, when Ix1, Ix2, or Ix3 is 2 or more, two or more of the respective L^{ET1}(s), L^{ET2}(s), or L^{ET3}(s) may be directly linked by carbon atoms of each aryl ring (such as sp² carbons), forming a substituted or unsubstituted C₆-C₃₀ arylene group or a substituted or unsubstituted C₂-C₃₀ heteroarylene group. For example, when Ix1 is 2 or greater, two or more of L^{ET1}(s) may be directly linked together, e.g., by carbon atoms of each aryl ring (e.g., sp₂ carbons), to form a substituted or unsubstituted C₆-C₃₀ arylene group or a substituted or unsubstituted C₂-C₃₀ heteroarylene group. When lx2 is 2 or greater, two or more of L^{ET2}(s) may be directly linked together, e.g., by carbon atoms of each aryl ring (e.g., sp² carbons), to form a substituted or unsubstituted C₆-C₃₀ arylene group or a substituted or unsubstituted C₂-C₃₀ heteroarylene group. When Ix3 is 2 or greater, two or more of L^{ET3}(s) may be directly linked together, e.g., by carbon atoms of each aryl ring (e.g., sp₂ carbons), to form a substituted or unsubstituted C₆-C₃₀ arylene group or a substituted or unsubstituted C₂-C₃₀ heteroarylene group.

In Chemical Formula ET, Ar^{ET1} to Ar^{ET3} are each independently hydrogen, deuterium, a substituted or unsubstituted C₁-C₂₀ alkyl group, a substituted or unsubstituted C₆-C₃₀ aryl group, or a substituted or unsubstituted C₂-C₃₀ heteroaryl group. For example, in one or more embodiments, Ar^{ET1} to Ar^{ET3} may each independently be a substituted or unsubstituted phenyl group, a substituted or unsubstituted carbazole group, a substituted or unsubstituted fluorene group, or a substituted or unsubstituted silyl group. The silyl group may be represented by - Si(R^{sa})(R^{sb})(R^{sc}), as explained above.

In one or more embodiments, the emission layer 130 may include quantum dots. A quantum dot may include a Group II-VI compound, a Group III-VI compound, a Group I-III-VI compound, a Group III-V group compound, a Group III-II-V group compound, a Group IV-VI compound, a Group IV element, a Group IV compound, and/or a (e.g., any suitable) combination thereof.

The quantum dot may include a core that includes the compound described above, and a shell around (e.g., surrounding) the core. The shell may include an inorganic oxide or a semiconductor compound. Examples of the semiconductor compound as a shell may include CdS, CdSe, CdTe, ZnS, ZnSe, ZnTe, ZnSe, ZnTeS, GaAs, GaP, GaSb, HgS, HgSe, HgTe, InAs, InP, InGaP, InSb, AlAs, AIP, AISb, and/or the like.

In one or more embodiments, a color of light from a quantum dot may be adjusted according to a particle size of the quantum dot. The quantum dot may be a blue quantum dot that is to emit blue light, a red quantum dot that is to emit red light, or a green quantum dot that is to emit green light.

The hole transfer region 120 may be formed between the first electrode 110 and the emission layer 130. The hole transfer region 120 may have a single-layered structure or a multi-layered structure including different materials.

The hole transfer region 120 may include a hole injection layer, a hole transport layer, and/or an electron blocking layer, and may further include an auxiliary emission layer.

In one or more embodiments, as illustrated in FIG. 2, the hole transfer region 120 may include a hole injection layer 122 and a hole transport layer 124, sequentially stacked from the first electrode 110.

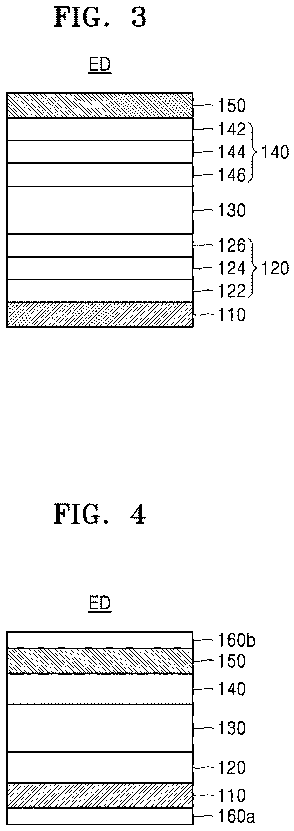

In one or more embodiments, as illustrated in FIG. 3, the hole transfer region 120 may include a hole injection layer 122, a hole transport layer 124, and an electron blocking layer 126, sequentially stacked from the first electrode 110. The electron blocking layer 126 may block electrons from the electron transfer region 140 to the hole transfer region 120. Accordingly, the generation of excitons in the emission layer 130 may be increased, and light-emission efficiency may be further increased.

For example, in one or more embodiments, the hole transfer region 120 may include the above-described compound represented by Chemical Formula HT.

For example, in one or more embodiments, the hole transfer region 120 may include one or more selected from among m-MTDATA (4,4',4"-[tris(3-methylphenyl)phenylamino] triphenylamine), TDATA (4,4'4"-tris(N,N-diphenylamino)triphenylamine), 2-TNATA (4,4',4"-tris[N(2-naphthyl)-N-phenylamino]-triphenylamine), NPB (N,N'-di(naphthalen-1-yl)-N,N'-diphenyl-benzidine), TPD (N,N'-bis(3-methylphenyl)-N,N'-diphenyl-[1,1'-biphenyl]-4,4'-diamine), Spiro-TPD, Spiro-NPB, DNTPD (N¹,N¹'-([1,1'-biphenyl]-4,4'-diyl)bis(N¹-phenyl-N⁴,N⁴-di-m-tolylbenzene-1,4-diamine), TAPC (4,4'-cyclohexylidene bis[N,N-bis(4-methylphenyl)benzenamine]), HMTPD (4,4'-bis[N,N'-(3-tolyl)amino]-3,3'-dimethylbiphenyl), TCTA (4,4',4"-tris(N-carbazolyl)triphenylamine), PANI/DBSA (polyaniline/dodecylbenzenesulfonic acid), PEDOT/PSS (poly(3,4-ethylenedioxythiophene)/poly(4-styrenesulfonate)), PANI/CSA(Polyaniline/Camphor sulfonicacid), PANI/PSS (polyaniline/poly(4-styrenesulfonate)), a phthalocyanine compound, a carbazole compound (N-phenylcarbazole, polyvinylcarbazole, and/or the like), a fluorene compound, and/or the like. The hole transfer region 120 may include one of the hole transfer materials described above, or a (e.g., any suitable) combination thereof.

The hole transfer materials described above may be included in at least one of the hole injection layer 122, the hole transport layer 124, or the electron blocking layer 126.

In one or more embodiments, the hole transfer region 120 may further include a charge generating material. The charge generating material may be a dopant material such as a p-dopant, so that conductivity of the hole transfer region 120 may be improved.

Non-limiting examples of dopant materials may include a halogenated metal compound (e.g., a metal halide) such as LiF, NaCl, CsF, RbCl, Rbl, Cul, and Kl; a quinone derivative such as TCNQ (tetracyanoquinodimethane), F4-TCNQ (2,3,5,6-tetrafluoro-7,7,8,8-tetracyanoquinodimethane), and/or the like; a cyano-containing compound such as HATCN (dipyrazino[2,3-f: 2',3'-h] quinoxaline-2,3,6,7,10,11-hexacarbonitrile), NDP9 (4-[[2,3-bis[cyano-(4-cyano-2,3,5,6-tetrafluorophenyl)methylidene]cyclopropylidene]-cyanomethyl]-2,3,5,6-tetrafluorobenzonitrile), and/or the like; a tungsten (W) oxide; a molybdenum (Mo) oxide; and/or the like. The hole transfer region 120 may include one of the dopant materials described above, or a (e.g., any suitable) combination thereof.

A thickness of the hole transfer region 120 may be in a range of about 100 Å to about 10,000 Å. For example, in one or more embodiments, the thickness of the hole transfer region 120 may be in a range of about 100 Å to about 1,500 Å.

When the hole transfer region 120 includes the hole injection layer 122 and/or the hole transport layer 124, a thickness of the hole injection layer 122 may be in a range from about 100 Å to about 9,000 Å, from about 100 Å to about 3,000 Å, or from about 100 Å to about 1,000 Å. A thickness of the hole transport layer 124 may be in a range from about 50 Å to about 2,000 Å, from about 100 Å to about 1,500 Å, from about 100 Å to about 1,000 Å, or from about 100 Å to about 600 Å.

Within the thickness ranges described above, hole transfer properties may be enhanced even at a low voltage operation, and a life-span of the device may be further improved.

Each constituent layer of the hole transfer region 120 may be formed by a process such as a vacuum deposition, a spin coating, an inkjet printing, a laser printing, a casting, a laser thermal transfer, and/or the like.

The electron transfer region 140 may be formed between the second electrode 150 and the emission layer 130. The electron transfer region 140 may have a single-layered structure, or a multi-layered structure including different materials.

The electron transfer region 140 may include an electron injection layer, an electron transport layer, and/or a hole blocking layer, and may further include an auxiliary emission layer.

In one or more embodiments, as illustrated in FIG. 2, the electron transfer region 140 may include an electron injection layer 142 and an electron transport layer 144, stacked from the second electrode 150 to the emission layer 130.

In one or more embodiments, as illustrated in FIG. 3, the electron transfer region 140 may include an electron injection layer 142, an electron transport layer 144, and a hole blocking layer 146, stacked from the second electrode 150 to the emission layer 130. The hole blocking layer 146 may block or suppress or reduce holes migrating from the hole transfer region 120 to the electron transfer region 140. Accordingly, emission energy and luminescence efficiency in the emission layer 130 may be further improved.

For example, in one or more embodiments, the electron transfer region 140 may include the above-described compound represented by Chemical Formula ET.

In one or more embodiments, the electron transfer region 140 may include an anthracene compound, Alq3 (tris(8-hydroxyquinolinato) aluminium), 1,3,5-tri[(3-pyridyl)-phen-3-yl] benzene, 2,4,6-tris (3'-(pyridin-3-yl)biphenyl-3-yl)-1,3,5-triazine, 2-(4-(N-phenylbenzimidazol-1-yl)phenyl)-9,10-dinaphthylanthracene, TPBi (1,3,5-tri(1-phenyl-1H-benzo[d]imidazol-2-yl)benzene), BCP (2,9-dimethyl-4,7-diphenyl-1,10-phenanthroline), Bphen (4,7-diphenyl-1,10-phenanthroline), TAZ (3-(biphenyl-4-yl)-4-phenyl-5-tert-butylphenyl-1,2,4-triazole), NTAZ (4-(naphthalen-1-yl)-3,5-diphenyl-4H-1,2,4-triazole), tBu-PBD (2-(biphenyl-4-yl)-5-(4-tert-butylphenyl)-1,3,4-oxadiazole), BAIq (bis(2-methyl-8-quinolinolato-N1,O8)-(1,1'-biphenyl-4-olato)aluminium), Bebq₂ (beryllium bis(benzoquinolin-10-olate)), ADN (9,10-di(naphthalen-2-yl)anthracene), BmPyPhB (1,3-bis[3,5-di(pyridin-3-yl)phenyl]benzene), and/or the like. The electron transfer region 140 may include one of the electron transfer materials described above, or a (e.g., any suitable) combination thereof.

The above-mentioned material may be included in at least one of the electron injection layer 142, the electron transport layer 144, or the hole blocking layer 146.

In one or more embodiments, the electron transfer region 140 may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or a (e.g., any suitable) combination thereof. In one or more embodiments, one or more of the above-mentioned materials may be included electron injection layer 142.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include an oxide, a halide (e.g., a fluoride, a chloride, a bromide, an iodide, and/or the like), a telluride of the alkali metal, the alkaline earth metal, and the rare earth metal, respectively, and/or a (e.g., any suitable) combination thereof.

The alkali metal complex, the alkaline earth metal complex, and the rare earth metal complex may include a respective metal ion such as an alkali metal ion, an alkaline earth metal ion, or a rare earth metal ion, and a ligand bonded to the respective metal ion. The ligand may include, e.g., hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, and/or a (e.g., any suitable) combination thereof.

A thickness of the electron transfer region 140 may be in a range from about 100 Å to about 1,000 Å, e.g., from about 150 Å to about 500 Å.

When the electron transfer region 140 includes an electron injection layer 142 and/or an electron transport layer 144, a thickness of the electron injection layer 142 may be in a range from about 1 Å to about 100 Å, from 1 Å to about 90 Å, or from about 5 Å to about 50 Å, and a thickness of the electron transport layer 144 may be in a range from 10 Å to about 900 Å, from about 10 Å to about 500 Å, or from about 100 Å to about 400 Å.

Within any of the thickness ranges described above, electron injection and electron transport properties may be further improved without an excessive increase in driving voltage, and stability of the electron transfer region 140 may be improved.

Each constituent layer of the electron transfer region 140 may be formed by a process such as a vacuum deposition, a spin coating, an inkjet printing, a laser printing, a casting, a laser thermal transfer, and/or the like.

In one or more embodiments, the light-emitting device ED may further include a capping layer. Light emission efficiency to an outside of the light-emitting device ED may be improved through the capping layer.

As illustrated in FIG. 4, a second capping layer 160b may be formed on an outer surface of the second electrode 150. In one or more embodiments, a first capping layer 160a may be formed on an outer surface of the first electrode 110.

A refractive index of the first capping layer 160a and/or a refractive index of the second capping layer 160b may each be 1.6 or more. For example, in one or more embodiments, the refractive index of the first capping layer 160a and/or the refractive index of the second capping layer 160b may each be 1.6 or more, 1.8 or more, or 2.0 or more for a light in a wavelength range of 550 nm to 660 nm.

The first capping layer 160a and the second capping layer 160b may each be formed as an organic capping layer including an organic material, an inorganic capping layer including an inorganic material, or an organic-inorganic hybrid capping layer including both (e.g., simultaneously) the organic material and the inorganic material.

The first capping layer 160a and/or the second capping layer 160b may each have a single-layered structure or a multi-layered structure including different materials.

In one or more embodiments, the first capping layer 160a and the second capping layer 160b may each independently include a carbocyclic compound, a heterocyclic compound, an amine group-containing compound, a porphine derivative, a phthalocyanine derivative, a naphthalocyanine derivative, an alkali metal complex, an alkaline earth metal complex, and/or the like. The first capping layer 160a and the second capping layer 160b may each independently include one of the aforementioned materials, or a (e.g., any suitable) combination thereof.

In one or more embodiments, the first capping layer 160a and/or the second capping layer 160b may each independently include an amine group-containing compound.

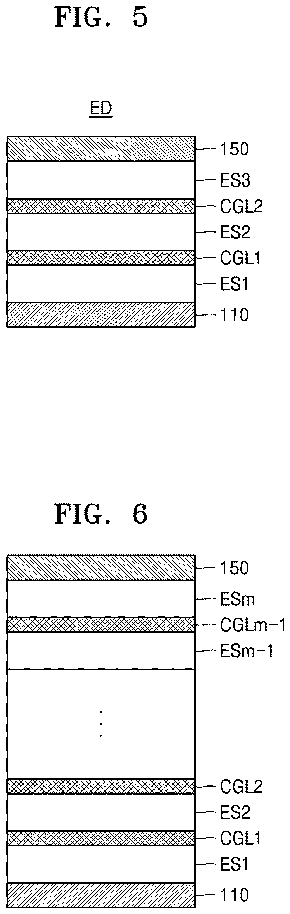

Referring to FIG. 5, in one or more embodiments, the light-emitting device ED may include a plurality of light-emitting structures (e.g., the light-emitting structures ES1, ES2, and ES3). The light-emitting structures ES1, ES2, and ES3 may each include a stacked structure of the hole transfer region 120, the emission layer 130, and the electron transfer region 140, as described with reference to FIGS. 1 to 4. In one or more embodiments, the light-emitting device ED of FIG. 5 may be a light-emitting device having a tandem structure.

Charge generation layers CGL1 and CGL2 may each be respectively arranged between adjacent structures among the light-emitting structures ES1, ES2, and ES3. Charge generation layers CGL1 and CGL2 may each independently include a p-type (kind) charge (e.g., P-charge) generation layer and/or an n-type (kind) charge (e.g., N-charge) generation layer.

The p-type (kind) charge generation layer may include a hole transport host compound, such as NPB. For example, in one or more embodiments, the p-type (kind) charge generation layer may include a compound represented by Chemical Formula HT described above. In one or more embodiments, the p-type (kind) charge generation layer may further include a p-dopant, such as TCNQ.

The n-type (kind) charge generation layer may include an electron transport host compound. For example, in one or more embodiments, the n-type (kind) charge generation layer may include a compound represented by Chemical Formula ET described above. In one or more embodiments, the n-type (kind) charge generation layer may include a phenanthroline-based compound.

The charge generation layers CGL1 and CGL2 may include a first charge generation layer CGL1 arranged between the first light-emitting structure ES1 and the second light-emitting structure ES2, and a second charge generation layer CGL2 arranged between the second light-emitting structure ES2 and the third-light emitting structure ES3.

In one or more embodiments, the first light-emitting structure ES1, the first charge generation layer CGL1, the second light-emitting structure ES2, the second charge generation layer CGL2, the third light-emitting structure ES3, and the second electrode 150 may be sequentially stacked on a top surface of the first electrode 110.

Colors emitted from the first light-emitting structure ES1, the second light-emitting structure ES2, and the third light-emitting structure ES3 may be the same as or different from one another. In one or more embodiments, the first light-emitting structure ES1, the second light-emitting structure ES2, and the third light-emitting structure ES3 may include a red light-emitting layer, a green light-emitting layer and a blue light-emitting layer, respectively, and a white light-emitting structure may be implemented through the tandem structure, but embodiments of the present disclosure are not limited thereto.

In FIG. 5, a 3-stack tandem structure in which three light-emitting structures are stacked is illustrated as an example, but the tandem structure of the light-emitting device of the present disclosure is not limited to the structure illustrated in FIG. 5. For example, a 2-stack structure, a 4-stack structure, a 5-stack structure, or a 6 or more stacked structure which will be described with reference FIG. 6 may also be implemented.

Referring to FIG. 6, as described with reference to FIG. 5, a tandem structure in which a light-emitting structure and a charge generation layer are alternately and repeatedly stacked may be arranged between the first electrode 110 and the second electrode 150.

In one or more embodiments, first to mth light-emitting structures ES1 to ESm may be sequentially stacked from a top surface of the first electrode 110 with a charge generation layer interposed therebetween. The charge generation layer may include a first charge generation layer CGL1 to an (m-1)th charge generation layer CGLm-1 sequentially stacked from the top surface of the first electrode 110.

As illustrated in FIG. 6, the first light-emitting structure ES1, the first charge generation layer CGL1, the second light-emitting structure ES2, the second charge generation layer CGL2, ... , an (m-1)th light-emitting structure ESm-1, an (m-1)th charge generation layer CGLm-1, an mth light-emitting structure ESm, and the second electrode 150 may be sequentially stacked from the top surface of the first electrode 110.

In one or more embodiments, m is 4, and the intermediate layer ITL of the light-emitting device may have a 4-stack tandem structure, and may include first to fourth light-emitting structures ES1, ES2, ES3, and ES4, and first to third charge generation layers CGL1, CGL2, and CGL3. Colors of light generated from the first to fourth light-emitting structures ES1, ES2, ES3, and ES4 may be the same as or different from one another.

In one or more embodiments, the first to fourth light emitting structures ES1, ES2, ES3, and ES4 may include at least one blue light-emitting structure and at least one green-light emitting structure. In a non-limiting example, the first to third light emitting structures ES1, ES2, and ES3 may correspond to the blue light-emitting structure, and the fourth light emitting structure ES4 may correspond to the green-light emitting structure.

In one or more embodiments, m is 5, and the intermediate layer ITL of the light-emitting device may have a 5-stack tandem structure, and may include first to fifth light-emitting structures ES1, ES2, ES3, ES4, and ES5, and first to fourth charge generation layers CGL1, CGL2, CGL3, and CGL4. Colors of light generated from the first to fifth light-emitting structures ES1, ES2, ES3, ES4, and ES5 may be the same as or different from one another.

In one or more embodiments, the first to fifth light-emitting structures ES1, ES2, ES3, ES4, and ES5 may include at least one blue light emitting structure and at least one green light emitting structure. In a non-limiting example, the first to fifth light-emitting structures ES1, ES2, ES3, ES4, and ES5 may include three blue light-emitting structures and two green light-emitting structures. For example, in one or more embodiments, the first, third, and fifth light-emitting structures ES1, ES3, and ES5 may correspond to the blue light-emitting structures, and the second and fourth light-emitting structures ES2 and ES4 may correspond to the green light-emitting structures.

### Electronic Device

The above-described light-emitting device ED may be applied to an electronic device and may be provided as a light-emitting portion or a light-emitting unit of the electronic device.

Examples of the electronic device may include a display device, a billboard, a signboard, a light source, a lighting device, a personal computer such as a laptop computer or a desktop computer, a mobile phone, an electronic book, an electronic dictionary, an electronic notebook, a health-care device including a diagnostic device and one or more suitable sensors, one or more suitable display parts for transportation apparatuses (automobile, aircraft, ship, train, and/or the like).

In one or more embodiments, the light-emitting device ED may be applied to an organic light emitting diode (OLED) display device or a quantum dot (QD)-OLED display device.

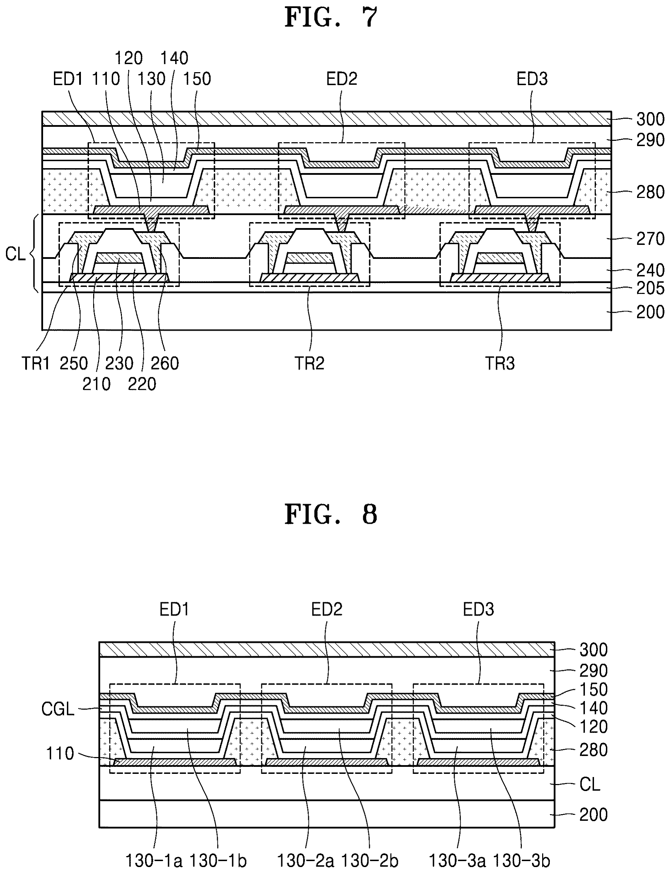

FIG. 7 is a schematic cross-sectional view illustrating a display device in accordance with one or more embodiments of the present disclosure.

Referring to FIG. 7, the display device may include a circuit layer CL arranged on a base substrate 200, and light-emitting devices ED1, ED2, and ED3 each arranged on the circuit layer CL.

The base substrate 200 may serve as a supporting substrate or as a backplane substrate of the display device. The base substrate 200 may be a glass substrate or a plastic substrate.

In one or more embodiments, the base substrate 200 may include a polymer material having transparent and flexible properties. If (e.g., when) the base substrate 200 includes a polymer material, the base substrate 200 may be used in a transparent flexible display device. For example, in one or more embodiments, the base substrate 200 may include a polymer material such as polyimide, polysiloxane, an epoxy resin, an acrylic resin, polyester, and/or the like. In one or more embodiments, the base substrate 200 may include polyimide.

In one or more embodiments, the circuit layer CL may include transistors TR1, TR2, and TR3. The circuit layer CL may include wiring layers and insulating layers that form a thin film transistor array (TFT-Array).

In one or more embodiments, the circuit layer CL may further include a buffer layer 205 on a top surface of the base substrate 200. The buffer layer 205 may block the penetration of moisture through the base substrate 200, and may also block the diffusion of impurities between the base substrate 200 and the structures formed thereon.

The buffer layer 205 may include, e.g., silicon oxide, silicon nitride, and/or silicon oxynitride. The buffer layer 205 may include one of the aforementioned materials, or a (e.g., any suitable) combination thereof. In one or more embodiments, the buffer layer 205 may have a stacked structure that includes a silicon oxide layer and a silicon nitride layer.

The transistors TR1, TR2, and TR3 may be arranged on the buffer layer 205. A first transistor TR1, a second transistor TR2, and a third transistor TR3 may be electrically connected to a first light-emitting device ED1, a second light-emitting device ED2, and a third light-emitting device ED3, respectively.

The transistors TR1, TR2, and TR3 may each include an active layer 210, a gate insulation layer 220, and a gate electrode 230.

The active layer 210 may be arranged on the buffer layer 205, and may be patterned for each pixel. In one or more embodiments, the active layer 210 may include a silicon compound such as amorphous silicon or polysilicon. A p-type (kind) dopant or an n-type (kind) dopant may be doped in a region of the active layer 210, and the active layer 210 may include a source region, a drain region, and a channel region.

In one or more embodiments, the active layer 210 may include an oxide semiconductor, such as indium gallium zinc oxide (IGZO), zinc tin oxide (ZTO), or ITZO.

The gate insulation layer 220 may be formed on the active layer 210, and the gate electrode 230 may be stacked on the gate insulation layer 220. As illustrated in FIG. 7, the gate insulation layer 220 may be patterned to partially cover each active layer 210. In one or more embodiments, the gate insulation layer 220 may extend continuously over multiple pixels or light-emitting regions, and may be provided as a common layer for the first, second, and third transistors TR1, TR2, and TR3.

The gate electrode 230 may overlap the channel region of the active layer 210 in a thickness direction.

An insulating interlayer 240 may be formed on the active layer 210 to cover the gate electrode 230 and the gate insulation layer 220. Connection electrodes 250 and 260 which may be in contact with or electrically connected to the active layer 210 may each be arranged on the insulating interlayer 240.

The connection electrodes 250 and 260 may extend through the insulating interlayer 240 to be in contact with or electrically connected to the active layer 210. When the gate insulation layer 220 is provided as a common layer for multiple light-emitting regions, the connection electrodes 250 and 260 may also extend through the gate insulation layer 220.

The connection electrodes 250 and 260 may include a source electrode 250 that may be in contact with or connected to the source region of the active layer 210, and a drain electrode 260 that may be in contact with or connected to the drain region of the active layer 210.

The gate insulation layer 220 and the insulating interlayer 240 may each independently include silicon oxide, silicon nitride, and/or silicon oxynitride, and may each have a stacked structure that includes a silicon oxide layer and a silicon nitride layer.

The gate electrode 230 and the connection electrodes 250 and 260 may each independently include a metal such as Ag, Mg, Al, W, Cu, Ni, Cr, Mo, Ti, Pt, Ta, Nd, Sc, an alloy thereof, or a nitride thereof.

A via insulation layer 270 may be formed on the insulating interlayer 240 to cover the connection electrodes 250 and 260.

The via insulation layer 270 may accommodate a via structure electrically connecting a first electrode 110 and the drain electrode 260. The via insulation layer 270 may serve as a planarization layer of the circuit layer CL. In one or more embodiments, the via insulation layer 270 may include an organic material such as polyimide, an epoxy resin, an acrylic resin, polyester, and/or the like.

The light-emitting devices ED1, ED2, and ED3 may be arranged on the via insulation layer 270. For example, as described with reference to FIGS. 1 to 4, the light-emitting devices ED1, ED2, and ED3 may each include a first electrode 110, a hole transfer region 120, an emission layer 130, an electron transfer region 140, and a second electrode 150 which are sequentially stacked from the via insulation layer 270.

The first electrode 110 may be electrically connected to the respective transistors TR1, TR2, and TR3 or the respective connection electrodes 250 or 260 in the circuit layer CL through the via structure. As illustrated in FIG. 7, in one or more embodiments, the first electrode 110 may be in contact with or connected to the drain electrode 260 to serve as a pixel electrode patterned for each light-emitting region or pixel.

A pixel defining layer 280 may be formed on the via insulation layer 270 to define each light-emitting region or pixel. A blue light-emitting region, a red light-emitting region, and a green light-emitting region may be separated and defined by the pixel defining layer 280, and the light-emitting devices ED1, ED2, and ED3 may respectively correspond to a blue light-emitting device, a red light-emitting device, and a green light-emitting device.

The pixel defining layer 280 may partially cover the first electrode 110 of each light-emitting region.

As illustrated in FIG. 7, the hole transfer region 120 and the electron transfer region 140 may each be provided as a common layer that continuously extends over the pixel defining layer 280 and the first electrodes 110. The emission layer 130 may be formed within each light emitting-region or pixel, and may be separated by the pixel defining layer 280.

In one or more embodiments, the emission layer 130 may also be provided as a common layer that continuously extends over the light emitting-regions or pixels. In one or more embodiments, the hole transfer region 120, the emission layer 130, and the electron transfer region 140 may each be patterned and separately formed for each light-emitting region or pixel.

The second electrode 150 may be provided as a common electrode that continuously extends over the light-emitting regions or the pixels.

An encapsulation layer 290 may be arranged on the pixel defining layer 280 and the light-emitting devices ED1, ED2, and ED3 to protect the light-emitting devices ED1, ED2, and ED3 from moisture and/or oxygen. The encapsulation layer 290 may be a thin film encapsulation (TFE) having a single-layered structure or multi-layered structure.

The encapsulation layer 290 may include an inorganic layer that includes silicon nitride (SiNₓ), silicon oxide (SiOₓ), indium tin oxide, indium zinc oxide, or any combination thereof; an organic layer that includes polyethylene terephthalate, polyethylene naphthalate, polycarbonate, polyimide, polyethylene sulfonate, polyoxymethylene, polyarylate, hexamethyldisiloxane, an acrylic resin (e.g., polymethylmethacrylate, polyacrylic acid, and/or the like.), an epoxy resin (e.g., an aliphatic glycidyl ether (AGE)), or any combination thereof; or a (e.g., any suitable) combination of the inorganic layer and the organic layer.

The display device may further include a functional layer 300 arranged on the encapsulation layer 290. The functional layer 300 may include a sensor layer such as a touch sensor layer, an optical layer such as a polarizing layer, a color conversion layer, a color filter layer, a window film, or any combination thereof.

FIG. 8 is a schematic cross-sectional view illustrating a display device in accordance with one or more embodiments of the present disclosure. Detailed descriptions of elements and structures substantially the same as or similar to those described with reference to FIG. 7 are omitted or simplified herein for conciseness.

Referring to FIG. 8, each of the light-emitting devices ED1, ED2, and ED3 may have a tandem structure, e.g., a 2-stack tandem structure.

In one or more embodiments, the hole transfer region 120 and the electron transfer region 140 may be continuously and commonly formed and included in an intermediate layer of each light-emitting structure. Additionally, a charge generation layer CGL may continuously extend across a plurality of pixels and may be commonly included in the intermediate layer of each light-emitting structure.

The first light-emitting device ED1 may include a first lower emission layer 130-1a arranged between the hole transfer region 120 and the charge generation layer CGL, and a first upper emission layer 130-1b arranged between the charge generation layer CGL and the electron transfer region 140.

The second light-emitting device ED2 may include a second lower emission layer 130-2a arranged between the hole transfer region 120 and the charge generation layer CGL, and a second upper emission layer 130-2b arranged between the charge generation layer CGL and the electron transfer region 140.

The third light-emitting device ED3 may include a third lower emission layer 130-3a arranged between the hole transfer region 120 and the charge generation layer CGL, and a third upper emission layer 130-3b arranged between the charge generation layer CGL and the electron transfer region 140.

The lower and upper emission layers included in each light-emitting structure (e.g., in each light-emitting tandem structure) may generate light of a same color. In one or more embodiments, each of the first lower emission layer 130-1a and the first upper emission layer 130-1b included in the first light-emitting device ED1 may correspond to a red emission layer. Each of the second lower emission layer 130-2a and the second upper emission layer 130-2b included in the second light-emitting device ED2 may correspond to a green emission layer. Each of the third lower emission layer 130-3a and the third upper emission layer 130-3b included in the third light-emitting device ED3 may correspond to a blue emission layer.

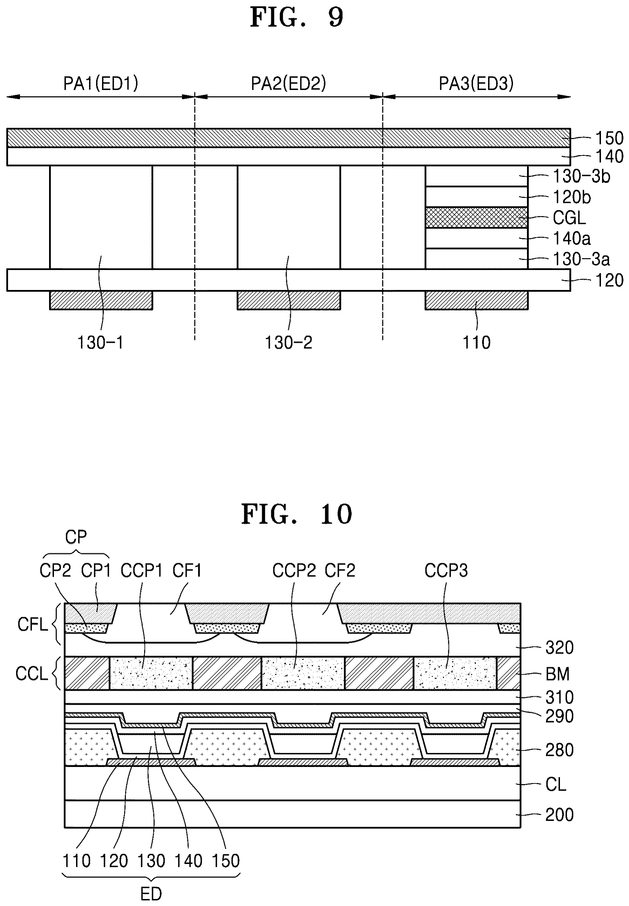

FIG. 9 is a schematic cross-sectional view illustrating a stack construction of light-emitting structure in a display device in accordance with one or more embodiments of the present disclosure. For convenience of illustration and description, illustration of the circuit layer, the base substrate, the pixel defining layer, and/or the like, is omitted from FIG. 9, and a shape of each layer or element in the light-emitting structure is briefly shown as a rectangle.

Referring to FIG. 9, in one or more embodiments, at least one selected from among the light-emitting devices ED1, ED2, and ED3 or selected from among pixel areas PA1, PA2, and PA3 may have a tandem structure including a plurality of emission layers, and at least one selected from among the remainder may have a single emission layer structure.

In one or more embodiments, one selected from among the light-emitting devices ED1, ED2, and ED3 or selected from among the pixel areas PA1, PA2, and PA3 may have a tandem structure, and the remainder may have a single emission layer structure.

As illustrated in FIG. 9, the first light-emitting device ED1, the second light-emitting device ED2, and the third light-emitting device ED3 may be included in the first pixel area PA1, the second pixel area PA2, and the third pixel area PA3, respectively. In one or more embodiments, the first pixel area PA1, the second pixel area PA2, and the third pixel area PA3 may correspond to a red pixel area, a green pixel area, and a blue pixel area, respectively.

The hole transfer region 120, the electron transfer region 140, and the second electrode 150 may each be provided as a common layer continuously extending over the first pixel area PA1, the second pixel area PA2, and the third pixel area PA3.

The first-light emitting device ED1 included in the first pixel area PA1 may include a first emission layer 130-1, and the second light-emitting device ED2 included in the second pixel area PA2 may include a second emission layer 130-2. Each of the first emission layer 130-1 and the second emission layer 130-2 may be a single-layered emission layer.

The third light-emitting device ED3 included in the third pixel area PA3 may have, e.g., a 2-stack tandem structure. The third light-emitting device ED3 may include a third lower emission layer 130-3a and a third upper emission layer 130-3b separated with the charge generation layer CGL interposed therebetween. For example, each of the third lower emission layer 130-3a and the third upper emission layer 130-3b may correspond to a blue emission layer.

A lower electron transfer region 140a may be arranged between the charge generation layer CGL and the third lower emission layer 130-3a. An upper hole transfer region 120b may be arranged between the charge generation layer CGL and the third upper emission layer 130-3b.

Accordingly, a tandem light-emitting structure in which the first electrode 110, the hole transfer region 120, the third lower emission layer 130-3a, the lower electron transfer region 140a, the charge generation layer CGL, the upper hole transfer region 120b, the third upper emission layer 130-3b, the electron transfer region 140, and the second electrode 150 are sequentially stacked may be arranged in the third pixel area PA3.

FIG. 10 is a schematic cross-sectional view illustrating a display device in accordance with one or more embodiments of the present disclosure.

FIG. 10 illustrates a display device having a QD-OLED structure according to one or more embodiments. Detailed descriptions regarding elements and structures that are the same as or substantially similar to those described with reference to FIG. 7 will not be repeated here for conciseness.

Referring to FIG. 10, the pixel defining layer 280 and the light-emitting device ED may be arranged on the circuit layer CL, as described above with reference to FIG. 7. In one or more embodiments, each pixel may be to emit light of the same wavelength region. In one or more embodiments, each light-emitting device ED may be to emit a blue light.

In one or more embodiments, each light-emitting region may include the light-emitting device having the tandem structure, as described above with respect to FIG. 5. In these embodiments, the intermediate layer ITL of each light-emitting device ED may be provided as a common layer that continuously extends over a plurality of the light-emitting regions.

A color control layer CCL may be arranged on the encapsulation layer 290, and the color control layer CCL may include color control portions CCP1, CCP2, and CCP3.

The color control portions CCP1, CCP2, and CCP3 may each include a light transformer such as a quantum dot and/or a phosphor. In each of the color control portions CCP1, CCP2, and CCP3, the light transformer may convert a wavelength of a provided light and emit a resulting light.

The color control portions CCP1, CCP2, and CCP3 may be separated or spaced and/or apart (e.g., spaced apart or separated) from one another by a bank BM. The bank BM may substantially overlap the pixel defining layer 280, and the color control portions CCP1, CCP2, and CCP3 may substantially overlap each of the emission layers 130.

The color control layer CCL may include a first color control portion CCP1 including a first quantum dot that converts a first color light provided from the light-emitting device ED into a second color light, a second color control portion CCP2 including a second quantum dot that converts the first color light into a third color light, and a third color control portion CCP3 that transmits the first color light.

In one or more embodiments, the first color light, the second color light, and the third color light may be a blue light, a red light, and a green light, respectively. The first quantum dot and the second quantum dot may respectively be a red quantum dot and a green quantum dot.

The color control portions CCP1, CCP2, and CCP3 may each further include a scattering material such as inorganic particles. The third color control portion CCP3 may not include (e.g., may exclude any of the) quantum dots and may include the scattering material. The scattering material may include TiO₂, ZnO, Al₂O₃, SiO₂, hollow silica, and/or the like. The scattering material may be one of the aforementioned materials or a (e.g., any suitable) combination thereof.

The color control portions CCP1, CCP2, and CCP3 may each further include a binder resin that disperses the quantum dot and the scattering material. The binder resin may include an acrylic resin, a urethane resin, a silicone resin, an epoxy resin, and/or the like.

A color filter layer CFL that includes color filters CF1 and CF2 and a light-shielding portion CP may be arranged on the color control layer CCL.

The color filter layer CFL may include a first filter CF1 that transmits the second color light, a second filter CF2 that transmits the third color light, and a third filter that transmits the first color light. For example, the first filter CF1 may be a red filter, the second filter CF2 may be a green filter, and the third filter may be a blue filter.

The color filters CF1 and CF2 may each include a photosensitive binder resin and a colorant including a pigment and/or a dye. The first filter CF1 may include a red pigment and/or a red dye, and the second filter CF2 may include a green pigment and/or a green dye.

The light-shielding portion CP may be arranged between the color filters. In one or more embodiments, the light-shielding portion CP may include a first light-shielding portion CP1 and a second light-shielding portion CP2 that include colorants of different colors.

In one or more embodiments, the first light-shielding portion CP1 may include a blue colorant, and the second light-shielding portion CP2 may include a red colorant or a black colorant. In one or more embodiments, in the blue light-emitting region, a portion of the first light-shielding portion CP1 may be provided as a blue color filter and may be exposed between the second light-shielding portions CP2, so that an additional color filter (e.g., the third filter) may not be provided.

A first barrier layer 310 may be arranged between the color control layer CCL and the light-emitting device ED (or the encapsulation layer 290). A second barrier layer 320 may be arranged between the color control layer CCL and the color filter layer CFL.

The barrier layers 310 and 320 may each include at least one inorganic layer. For example, the barrier layers 310 and 320 may each independently include silicon nitride, aluminium nitride, zirconium nitride, titanium nitride, hafnium nitride, tantalum nitride, silicon oxide, aluminium oxide, titanium oxide, tin oxide, cerium oxide, silicon oxynitride, and/or the like.

In one or more embodiments, the barrier layers 310 and 320 may each have a multi-layered structure that further includes an organic layer.

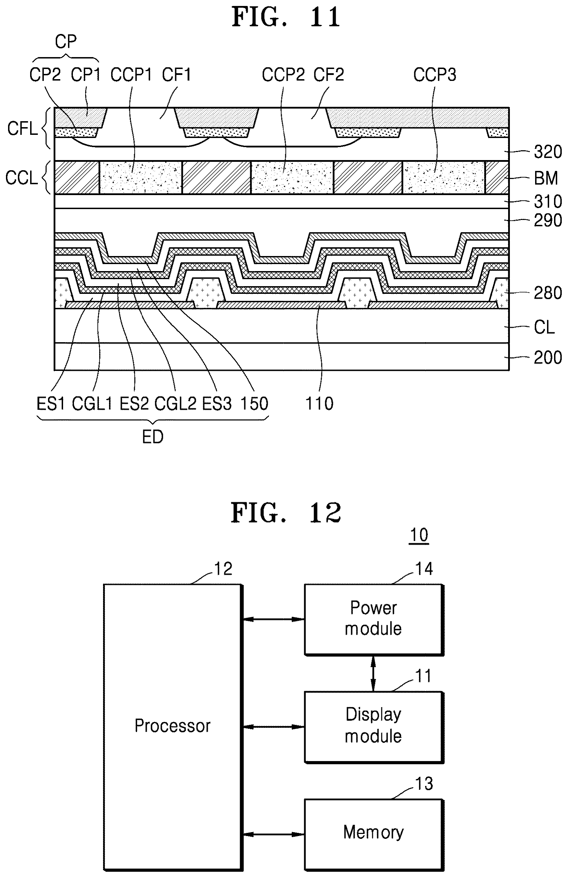

FIG. 11 is a schematic cross-sectional view illustrating a display device in accordance with one or more embodiments of the present disclosure. Detailed descriptions of elements and structures substantially the same as or similar to those described with reference to FIG. 10 are omitted herein.

Referring to FIG. 11, the light-emitting devices ED corresponding to the color control portions CCP1, CCP2, and CCP3 may each be arranged on the first electrode 110 serving as the pixel electrode, and the light-emitting device ED may have a tandem structure.

In one or more embodiments, as described with reference to FIG. 5, the first light-emitting structure ES1, the first charge generation layer CGL1, the second light-emitting structure ES2, the second charge generation layer CGL2, and the third light-emitting structure ES3 may be sequentially stacked between the first electrode 110 and the second electrode 150. In one or more embodiments, the first light-emitting structure ES1, the first charge generation layer CGL1, the second light-emitting structure ES2, the second charge generation layer CGL2, and the third light-emitting structure ES3 may be continuously and commonly formed in a plurality of pixel areas or light-emitting regions.

In one or more embodiments, the first light-emitting structure ES1, the second light-emitting structure ES2, and the third light-emitting structure ES3 may generate different color lights, and the light-emitting device ED may generate a white light (e.g., combined white light). In one or more embodiments, the first light-emitting structure ES1, the second light-emitting structure ES2, and the third light-emitting structure ES3 may all generate blue lights.

In one or more embodiments, as described with reference to FIG. 6, the light-emitting device ED may include a tandem structure of 4-stack, 5-stack, or more of the stacked number.

FIG. 12 is a block diagram of an electronic device in accordance with one or more embodiments of the present disclosure.

Referring to FIG. 12, an electronic device 10 according to one or more embodiments may include a display module 11, a processor 12, a memory 13, and a power module 14.

The processor 12 may include a central processing unit (CPU), an application processor (AP), a graphic processing unit (GPU), a communication processor (CP), an image signal processor (ISP), and/or a controller.

Data information for an operation of the processor 12 and/or the display module 11 may be stored in the memory 13. When the processor 12 executes an application stored in the memory 13, an image data signal and/or an input control signal may be transmitted to the display module 11, and the display module 11 may process the received signal and output image information through a display screen.

The power module 14 may include a power supply module such as a power adapter and/or a battery device, and a power conversion module that converts a power supplied by the power supply module to generate power desired or required for the operation of the electronic device 10.

At least one selected from among components of the electronic device 10 as described above may be included in the display device according to the above-described embodiments. Additionally, some of individual modules functionally included in one module may be included in the display device, and others may be provided separately from the display device. For example, the display module 11 may include the display device, and the processor 12, the memory 13, and the power module 14 may be provided in the form of another device in the electronic device 10 different from the display device.

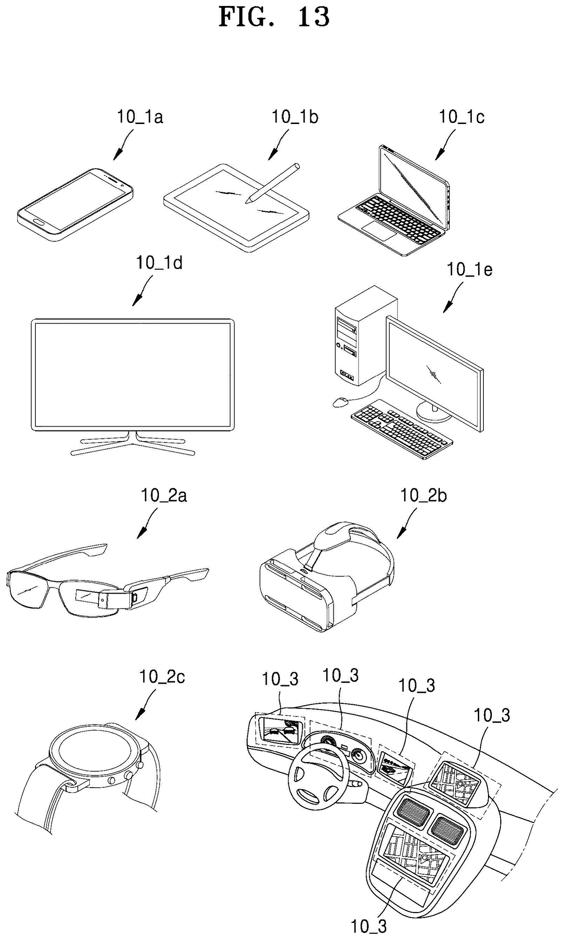

FIG. 13 is a schematic diagram illustrating electronic devices in accordance with various embodiments of the present disclosure.

Referring to FIG. 13, non-limiting examples of one or more suitable electronic devices to which the display device according to the above-described embodiments is applied may include an electronic device for displaying an image such as a smartphone 10_1a, a tablet PC 10_1b, a laptop 10_1c, a TV 10_1d, a desk monitor 10_1e, and/or the like; a wearable electronic device including a display module such as smart glasses 10_2a, a head mounted display 10_2b, a smart watch 10_2c, and/or the like; a vehicle electronic device 10_3 including a display module such as a center information display (CID) arranged at a vehicle instrument panel, a center fascia, a dashboard, and/or the like, a room mirror display, and/or the like. The electronic device may include a virtual reality glass or an augmented reality glass.

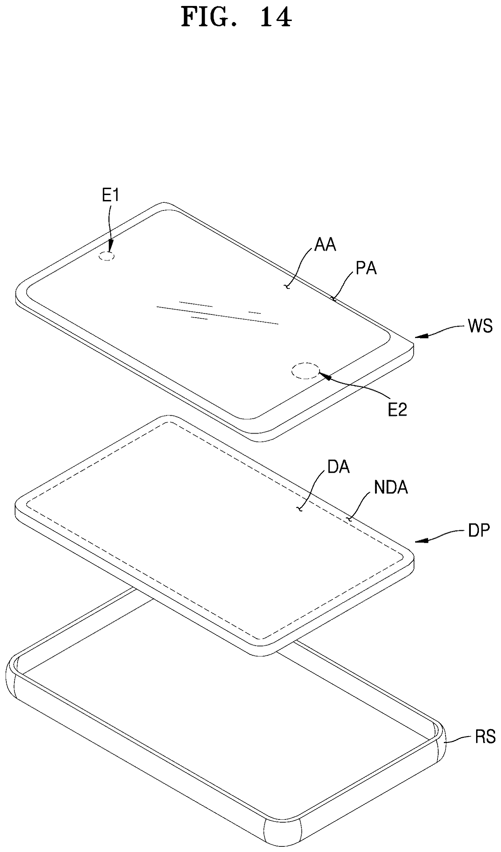

FIG. 14 is a schematic exploded perspective view illustrating an electronic device in accordance with one or more embodiments of the present disclosure.

According to one or more embodiments, the electronic device may be implemented in the form of a mobile phone (smart phone), a tablet, a PC, and/or the like, including the above-described display device.

Referring to FIG. 14, the electronic device may include a window structure WS, a display panel DP, and a rear structure RS.

The window structure WS may provide an external display surface recognized by a user, such as a viewing surface of a mobile phone, and may include a transparent material film. For example, the window structure WS may include glass (e.g., ultra-thin glass (UTG), a hard coating film, a plastic film, and/or the like.

An outer surface of the window structure WS may include an active area AA and a peripheral area PA. The active area AA may provide a surface from which an image of the display device is substantially displayed and to which a user's touch/command is input. The peripheral area PA may substantially correspond to a bezel area of the display device.

The display panel DP may include the above-described display device and may have a display area DA and a non-display area NDA. The display area DA of the display panel DP may substantially correspond to or overlap the active area AA of the window structure WS. The non-display area NDA of the display panel DP may substantially correspond to or overlap the peripheral area PA of the window structure WS.

In one or more embodiments, functional device areas E1 and E2 may be included in the active area AA of the window structure WS. For example, a first functional device area E1 may be included at one end portion of the active area AA and may be implemented, e.g., in the form of a camera hole. The second functional device area E2 may serve as a fingerprint sensing area.

For example, in one or more embodiments, a sensor structure for a touch sensing or a fingerprint sensing may be arranged in the display panel DP or between the window structure WS and the display panel DP.

The rear structure RS may serve as a frame structure or a housing of the display device or the electronic device. A cover panel may be arranged between the rear structure RS and the display panel DP.

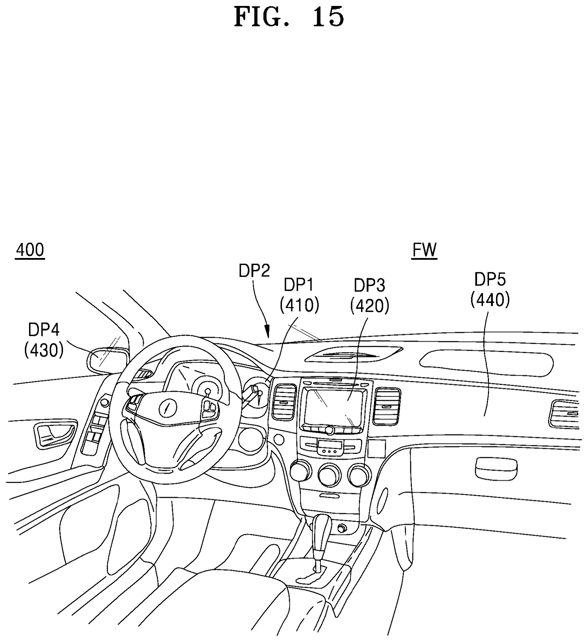

FIG. 15 is a schematic cross-sectional view illustrating an electronic device in accordance with one or more embodiments of the present disclosure.

The electronic device may be installed in, embedded in, attached to, or integrated with a vehicle 400. However, the vehicle 400 is not limited to one or more embodiments illustrated in FIG. 15. Further examples of the vehicle 400 may include a transportation apparatus such as a three-wheeled or four-wheeled vehicle, a construction machine, a two-wheeled vehicle, a motor vehicle, a bicycle, a train, and/or the like. Other examples of the vehicle 400 may also include an electric vehicle, a hybrid vehicle, and/or the like.

Referring to FIG. 15, at least one selected from among first to fifth display devices DP1, DP2, DP3, DP4, and DP5 may be applied to the vehicle 400.

In one or more embodiments, the first display device DP1 may be arranged in a cluster area 410. Driving information such as a driving distance and speed, and one or more suitable warning lights may be displayed in the cluster area 410.

The second display device DP2 may be arranged on a front window FW of the vehicle 400. For example, the second display device DP2 may be installed as a head-up display (HUD).

The third display device DP3 may be arranged on a center fascia 420 of the vehicle 400. In the center fascia 420, a button and/or a switch for controlling an image display or a music player, an air conditioner, a heater, and/or the like, may be displayed, and vehicle information may be displayed thereon.

The fourth display device DP4 may be applied to side mirrors 430 of the vehicle 400. A side mirror 430 may be installed at each of both sides (e.g., two opposite sides) of an exterior of the vehicle 400, and the fourth display device DP4 may be applied to at least one of the side mirrors 430 installed at each of the both sides.

The fifth display device DP5 may be arranged on a passenger seat dashboard 440. Information/image identical to or different from information/image displayed on the cluster area 410 and/or the center fascia 420 may be displayed at the passenger seat dashboard 440.

The above-described light-emitting device ED may be applied to an electronic apparatus, and may serve as a light-emitting portion or a light-emitting unit of the electronic apparatus.

In one or more embodiments, the electronic apparatus may include the above-described electronic device.

The electronic apparatus may include, e.g., a video wall, a flat panel display, a curved display, a computer monitor, a medical monitor, a television, a billboard, an indoor light, an outdoor light, a light for signaling, a head-up display, a fully transparent display, a partially transparent display, a flexible display, a rollable display, a foldable display, a laser printer, a phone, a mobile phone, a tablet, a phablet, a personal information terminal (PDA), a wearable device, a laptop computer, a digital camera, a camcorder, a viewfinder, a micro display, a 3D display, a virtual reality display, an augmented reality display, a vehicle, a video wall including multiple displays tiled together, a theater screen, a stadium screen, a phototherapy device, and/or a signage.

Hereinafter, a condensed heterocyclic compound according to one or more embodiments will be described in more detail with reference to Examples and Comparative Examples. The Examples are provided to assist in understanding the disclosure, but they are provided as non-limiting examples, and the scope of the disclosure is not limited thereto. It will be clear to those skilled in the art that one or more suitable changes and modifications to disclosed examples may be made within the scope of the disclosure.

### Example 1: Synthesis of Compound 1

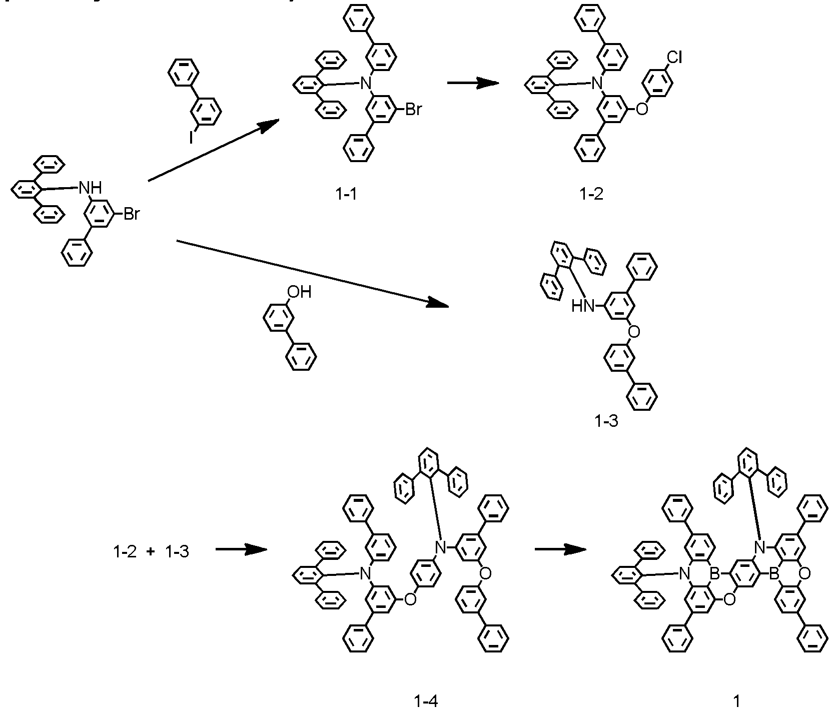

### (1) Synthesis of intermediate 1-1

N-(5-bromo-[1,1'-biphenyl]-3-yl)-[1,1':3',1"-terphenyl]-2'-amine (1 eq), 3-iodo-1,1'-biphenyl (2 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the mixture was washed with ethyl acetate and water. The organic layer was separated and dried over anhydrous MgSO₄, and then dried under reduced pressure. An intermediate 1-1 was obtained by purification using column chromatography with methylene chloride (MC) and n-hexane as developing solvents (yield: 49%).

### (2) Synthesis of Intermediate 1-2

The intermediate 1-1 (1 eq), 4-chlorophenol (1.2 eq), Cul (0.1 eq), 2-picolinic acid (0.1 eq), and K₂CO₃ (3 eq) were dissolved in dimethylformamide (DMF) and stirred at 160 °C for 12 hours. After being cooled, the solvent was removed under reduced pressure, and washed with ethyl acetate and water. The organic layer was separated and dried over anhydrous MgSO₄, and then dried under reduced pressure. An intermediate 1-2 was obtained by purification using column chromatography with MC and n-Hexane as developing solvents (yield: 72%).

### (3) Synthesis of intermediates 1-3

N-(5-bromo-[1,1'-biphenyl]-3-yl)-[1,1':3',1"-terphenyl]-2'-amine (1 eq), [1,1'-biphenyl]-3-ol (1.2 eq), Cul (0.1 eq), 2-picolinic acid (0.1 eq), and K₂CO₃ (3 eq) were dissolved in DMF and stirred at 160°C for 12 hours. After being cooled, the solvent was removed under reduced pressure, and washed with ethyl acetate and water. The organic layer was separated and dried over anhydrous MgSO₄, and then dried under reduced pressure. An intermediate 1-3 was obtained by purification using column chromatography with MC and n-hexane as developing solvents (yield: 69%).

### (4) Synthesis of Intermediate 1-4

The intermediate 1-2 (1.3 eq), the intermediate 1-3 (1 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the mixture was washed with ethyl acetate and water. The organic layer was separated and dried over anhydrous MgSO₄, and then dried under reduced pressure. An intermediate 1-4 was obtained by purification using column chromatography with MC and n-hexane as developing solvents (yield: 43%).

### (5) Synthesis of Compound 1

The intermediate 1-4 (1 eq) was dissolved in ortho dichlorobenzene in a flask, cooled to 0 °C, and BBr₃ (3 eq) was slowly injected under a nitrogen atmosphere. Thereafter, a temperature was increased to 180 °C and stirred for 24 hours. After cooling the mixture, triethylamine was slowly dropped into the flask to terminate the reaction, and then ethyl alcohol was added to the flask. A product was obtained by precipitation and filtration. The obtained solid was purified by column chromatography with MC and n-hexane as developing solvents, and then Compound 1 was obtained by recrystallization using toluene and acetone (yield: 19%).

### Example 2: Synthesis of Compound 2

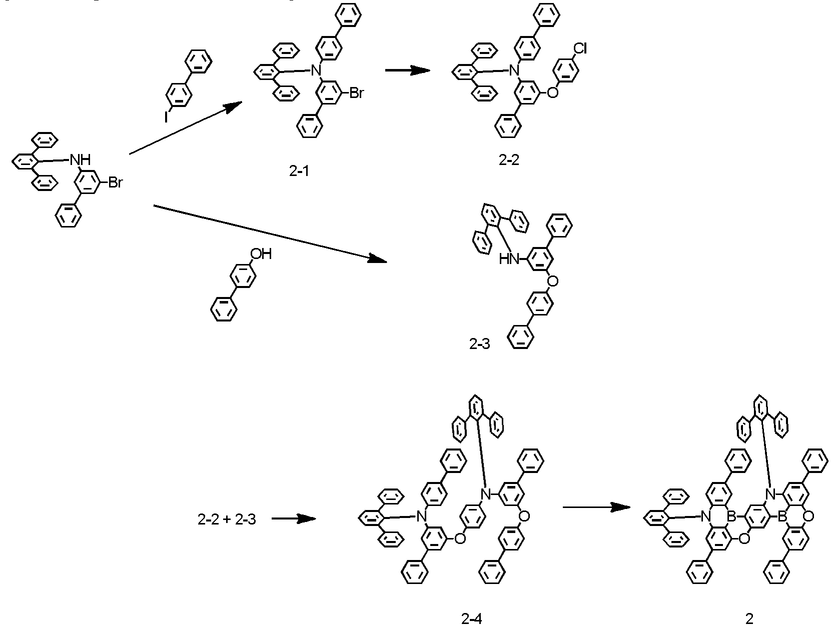

### (1) Synthesis of intermediate 2-1

N-(5-bromo-[1,1'-biphenyl]-3-yl)-[1,1':3',1"-terphenyl]-2'-amine (1 eq), 4-iodo-1,1'-biphenyl (2 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the mixture was washed with ethyl acetate and water. The organic layer was separated and dried over anhydrous MgSO₄, and then dried under reduced pressure. An intermediate 2-1 was obtained by purification using column chromatography with MC and n-hexane as developing solvents (yield: 55%).

### (2) Synthesis of Intermediate 2-2

The intermediate 2-1 (1 eq), 4-chlorophenol (1.2 eq), Cul (0.1 eq), 2-picolinic acid (0.1 eq), and K₂CO₃ (3 eq) were dissolved in DMF and stirred at 160 °C for 12 hours. After being cooled, the solvent was removed under reduced pressure, and washed with ethyl acetate and water. The organic layer was separated and dried over anhydrous MgSO₄, and then dried under reduced pressure. An intermediate 2-2 was obtained by purification using column chromatography with MC and n-hexane as developing solvents (yield: 74%).

### (3) Synthesis of intermediate 2-3

N-(5-bromo-[1,1'-biphenyl]-3-yl)-[1,1':3',1"-terphenyl]-2'-amine (1 eq), [1,1'-biphenyl]-4-ol (1.2 eq), Cul (0.1 eq), 2-picolinic acid (0.1 eq), and K₂CO₃ (3 eq) were dissolved in DMF and stirred at 160 °C for 12 hours. After being cooled, the solvent was removed under reduced pressure, and washed with ethyl acetate and water. The organic layer was separated and dried over anhydrous MgSO₄, and then dried under reduced pressure. An intermediate 2-3 was obtained by purification using column chromatography with MC and n-hexane as developing solvents (yield: 70%).

### (4) Synthesis of intermediate 2-4

The intermediate 2-2 (1.3 eq), the intermediate 2-3 (1 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the mixture was washed with ethyl acetate and water. The organic layer was separated and dried over anhydrous MgSO₄, and then dried under reduced pressure. An intermediate 2-4 was obtained by purification using column chromatography with MC and n-hexane as developing solvents (yield: 47%).

### (5) Synthesis of Compound 2

The intermediate 2-4 (1 eq) was dissolved in ortho dichlorobenzene in a flask, cooled to 0°C, and BBr₃ (3 eq) was slowly injected under a nitrogen atmosphere. Thereafter, a temperature was increased to 180°C and stirred for 24 hours. After cooling the mixture, triethylamine was slowly dropped into the flask to terminate the reaction, and then ethyl alcohol was added to the flask to obtain a product by precipitation and filtration. The obtained solid was purified by column chromatography with MC and n-hexane as developing solvents, and then Compound 2 was obtained by recrystallization using toluene and acetone (yield: 14%).

### Example 3: Synthesis of Compound 3

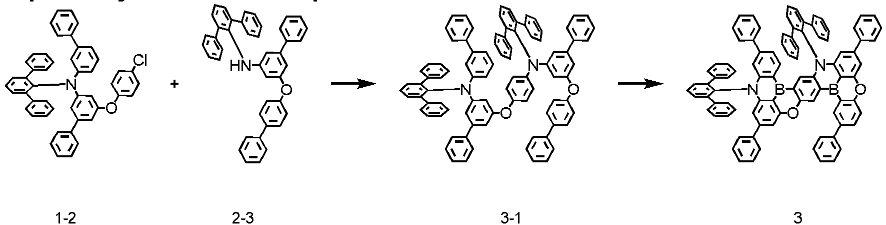

### (1) Synthesis of intermediate 3-1

The Intermediate 1-2 (1.3 eq) of Example 1, the intermediate 2-3 (1 eq) of Example 2, tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the mixture was washed with ethyl acetate and water. The organic layer was separated and dried over anhydrous MgSO₄, and then dried under reduced pressure. An intermediate 3-1 was obtained by purification using column chromatography with MC and n-hexane as developing solvents (yield: 52%).

### (2) Synthesis of Compound 3

The intermediate 3-1 (1 eq) was dissolved in ortho dichlorobenzene in a flask, cooled to 0 °C, and BBr₃ (3 eq) was slowly injected under a nitrogen atmosphere. Thereafter, a temperature was increased to 180°C and stirred for 24 hours. After being cooled, triethylamine was slowly dropped into the flask to terminate the reaction, and then ethyl alcohol was added to the flask to obtain a product by precipitation and filtration. The obtained solid was purified by column chromatography with MC and n-hexane as developing solvents, and then Compound 3 was obtained by recrystallization using toluene and acetone (yield: 21%).

### Example 4: Synthesis of Compound 13

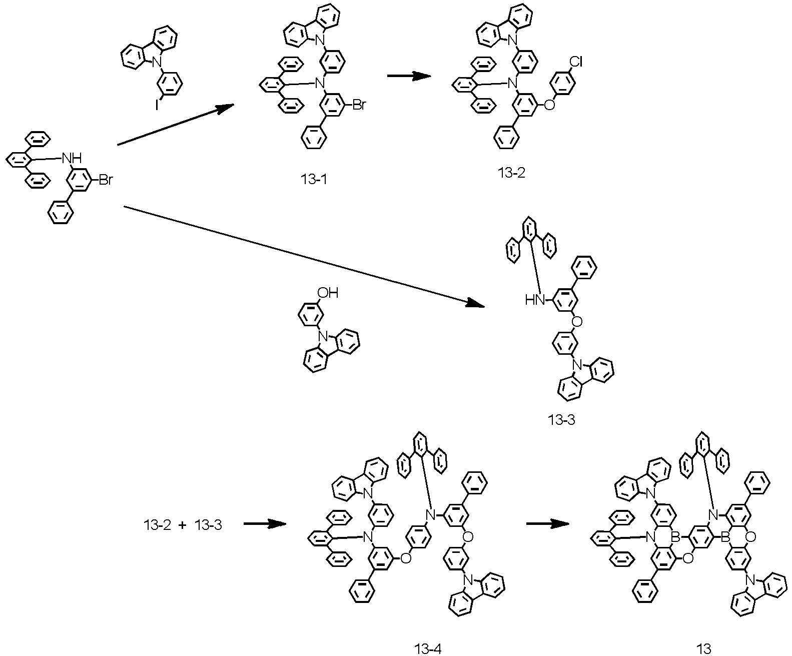

### (1) Synthesis of intermediate 13-1

N-(5-bromo-[1,1'-biphenyl]-3-yl)-[1,1':3',1"-terphenyl]-2'-amine (1 eq), 9-(3-iodophenyl)-9H-carbazole (2 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the mixture was washed with ethyl acetate and water. The organic layer was separated and dried over anhydrous MgSO₄, and then dried under reduced pressure. An intermediate 13-1 was obtained by purification using column chromatography with MC and n-hexane as developing solvents (yield: 43%).

### (2) Synthesis of Intermediate 13-2

The intermediate 13-1 (1 eq), 4-chlorophenol (1.2 eq), Cul (0.1 eq), 2-picolinic acid (0.1 eq), and K₂CO₃ (3 eq) were dissolved in DMF and stirred at 160 °C for 12 hours. After cooling the mixture, the solvent was removed under reduced pressure, and washed with ethyl acetate and water. The organic layer was separated and dried over anhydrous MgSO₄, and then dried under reduced pressure. An intermediate 13-2 was obtained by purification using column chromatography with MC and n-hexane as developing solvents (yield: 77%).

### (3) Synthesis of intermediate 13-3

N-(5-bromo-[1,1'-biphenyl]-3-yl)-[1,1':3',1"-terphenyl]-2'-amine (1 eq), 3-(9H-carbazol-9-yl)phenol (1.2 eq), Cul (0.1 eq), 2-picolinic acid (0.1 eq), and K₂CO₃ (3 eq) were dissolved in DMF and stirred at 160°C for 12 hours. After cooling the mixture, the solvent was removed under reduced pressure, and washed with ethyl acetate and water. The organic layer was separated and dried over anhydrous MgSO₄, and then dried under reduced pressure. An intermediate 13-3 was obtained by purification using column chromatography with MC and n-hexane as developing solvents (yield: 70%).

### (4) Synthesis of Intermediate 13-4

The intermediate 13-2 (1.3 eq), the intermediate 13-3 (1 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the mixture was washed with ethyl acetate and water. The organic layer was separated and dried over anhydrous MgSO₄, and then dried under reduced pressure. An intermediate 13-4 was obtained by purification using column chromatography with MC and n-hexane as developing solvents (yield: 50%).

### (5) Synthesis of Compound 13

After dissolving the intermediate 13-4 (1 eq) in ortho dichlorobenzene in a flask and cooling to 0 °C, BBr₃ (3 eq) was slowly added under a nitrogen atmosphere after. Thereafter, a temperature was increased to 180 °C and stirred for 24 hours. After cooling the mixture, triethylamine was slowly dropped into the flask to terminate the reaction, and then ethyl alcohol was added to the flask to obtain a product by precipitation and filtration. The obtained solid was purified by column chromatography with MC and n-hexane as developing solvents, and then recrystallized using toluene and acetone to obtain Compound 13 (yield: 18%).

### Example 5: Synthesis of Compound 85

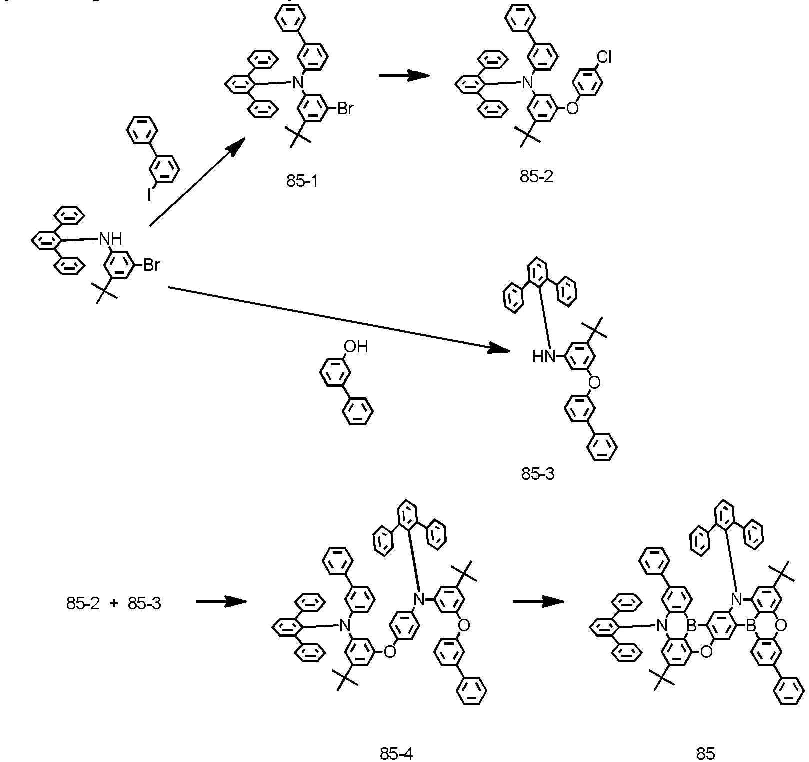

### (1) Synthesis of intermediate 85-1

N-(3-bromo-5-(tert-butyl)phenyl)-[1,1':3',1"-terphenyl]-2'-amine (1 eq), 3-iodo-1,1'-biphenyl (2 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the mixture was washed with ethyl acetate and water. The organic layer was separated and dried over anhydrous MgSO₄, and then dried under reduced pressure. An intermediate 85-1 was obtained by purification by column chromatography with MC and n-hexane as developing solvents (yield: 54%).

### (2) Synthesis of Intermediate 85-2

The intermediate 85-1 (1 eq), 4-chlorophenol (1.2 eq), Cul (0.1 eq), 2-picolinic acid (0.1 eq), and K₂CO₃ (3 eq) were dissolved in DMF and stirred at 160 °C for 12 hours. After cooling the mixture, the solvent was removed under reduced pressure, and washed with ethyl acetate and water. The organic layer was separated and dried over anhydrous MgSO₄, and then dried under reduced pressure. An intermediate 85-2 was obtained by purification using column chromatography with MC and n-hexane as developing solvents (yield: 77%).

### (3) Synthesis of intermediate 85-3

N-(3-bromo-5-(tert-butyl)phenyl)-[1,1':3',1"-terphenyl]-2'-amine (1 eq), [1,1'-biphenyl]-3-ol (1.2 eq), Cul (0.1 eq), 2-picolinic acid (0.1 eq), and K₂CO₃ (3 eq) were dissolved in DMF and stirred at 160°C for 12 hours. After cooling the mixture, the solvent was removed under reduced pressure, and washed with ethyl acetate and water. The organic layer was separated and dried over anhydrous MgSO₄, and then dried under reduced pressure. An intermediate 85-3 was obtained by purification using column chromatography with MC and n-hexane as developing solvents (yield: 70%).

### (4) Synthesis of intermediate 85-4

The intermediate 85-2 (1.3 eq), the intermediate 85-3 (1 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the mixture was washed with ethyl acetate and water. The organic layer was separated and dried over anhydrous MgSO₄, and then dried under reduced pressure. An intermediate 85-4 was obtained by purification using column chromatography with MC and n-hexane as developing solvents (yield: 42%).

### (5) Synthesis of Compound 85

After dissolving the intermediate 85-4 (1 eq) in ortho dichlorobenzene in a flask and cooling to 0 °C, BBr₃ (3 eq) was slowly added under a nitrogen atmosphere. Thereafter, a temperature was increased to 180 °C and stirred for 24 hours. After cooling the mixture, triethylamine was slowly dropped into the flask to terminate the reaction, and then ethyl alcohol was added to the flask to obtain a product by precipitation and filtration. The obtained solid was purified using column chromatography with MC and n-hexane as developing solvents, and then recrystallized using toluene and acetone to obtain Compound 85 (yield: 17%).

### Example 6: Synthesis Compound 193

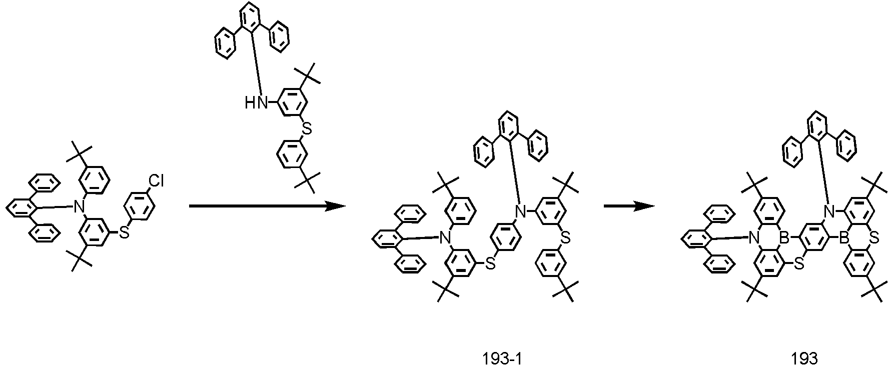

### (1) Synthesis of intermediate 193-1

N-(3-(tert-butyl)-5-((4-chlorophenyl)thio)phenyl)-N-(3-(tert-butyl)phenyl)-[1,1':3',1"-terphenyl]-2'-amine (1 eq), N-(3-(tert-butyl)-5-((3-(tert-butyl)phenyl)thio)phenyl)-[1,1':3',1"-terphenyl]-2'-amine (1 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the mixture was washed with ethyl acetate and water. The organic layer was separated and dried over anhydrous MgSO₄, and then dried under reduced pressure. The mixture was purified by column chromatography with MC and n-Hexane as developing solvents to obtain an intermediate 193-1 (yield: 48%).

### (2) Synthesis of Compound 193

After dissolving the intermediate 193-1 (1 eq) in ortho dichlorobenzene in a flask and cooling to 0 °C, BBr₃ (3 eq) was slowly injected under a nitrogen atmosphere. Thereafter, a temperature was increased to 180 °C and stirred for 24 hours. After cooling the mixture, triethylamine was slowly dropped into the flask to terminate the reaction, and then ethyl alcohol was added to the flask to obtain a product by precipitation and filtration. The obtained solid was purified by column chromatography with MC and n-Hexane as developing solvents, and then Compound 193 was obtained by recrystallization using toluene and acetone (yield: 14%).

### Example 7: Synthesis of Compound 199

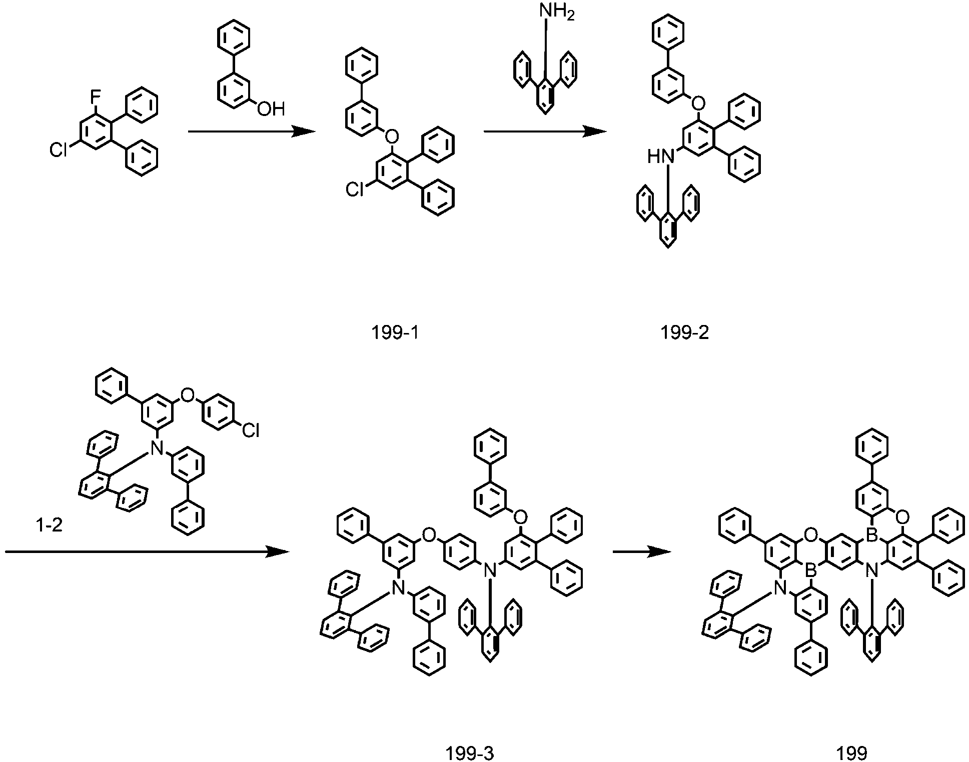

### (1) Synthesis of intermediate 199-1

5'-chloro-3'-fluoro-1,1':2',1"-terphenyl (1 eq), [1,1'-biphenyl]-3-ol (1.5 eq), and K₃PO₄ (2 eq) were dissolved in DMF and stirred at 160 °C for 12 hours. After being cooled, the solvent was removed under reduced pressure and washed with ethyl acetate and water. The organic layer was separated and dried over anhydrous MgSO₄, and then dried under reduced pressure. An intermediate 199-1 was obtained by purification using column chromatography with MC and n-hexane as developing solvents (yield: 81%)

### (2) Synthesis of Intermediate 199-2

The intermediate 199-1 (1 eq), [1,1':3',1"-terphenyl]-2'-amine (1.3 eq), tris(dibenzylideneacetone)dipalladium(0) (0.05 eq), tri-tert-butylphosphine (0.1 eq), and sodium tert-butoxide (3 eq) were dissolved in toluene and stirred at 100 °C for 12 hours. After being cooled, the solvent was removed under reduced pressure and washed with ethyl acetate and water. The organic layer was separated and dried over anhydrous MgSO₄, and then dried under reduced pressure. An intermediate 199-2 was obtained by purification using column chromatography with MC and n-hexane as developing solvents (yield: 83%)

### (3) Synthesis of intermediate 199-3

The intermediate 199-2 (1 eq), the intermediate 1-2 (1.4 eq), tris(dibenzylideneacetone)dipalladium(0) (0.15eq), tri-tert-butylphosphine (0.3 eq), and sodium tert-butoxide (5 eq) were dissolved in o-xylene and stirred at 150 °C for 48 hours. After being cooled, the solvent was removed under reduced pressure and washed with ethyl acetate and water. The organic layer was separated and dried over anhydrous MgSO₄, and then dried under reduced pressure. An intermediate 199-3 was obtained by purification using column chromatography with MC and n-hexane as developing solvents (yield: 48%).

### (4) Synthesis of Compound 199

The intermediate 199-3 (1 eq) and 2,6-dichloropyridine (5 eq) were dissolved in ortho dichlorobenzene in a flask, cooled to 0°C, and BBr₃ (5 eq) was slowly injected under a nitrogen atmosphere. Thereafter, a temperature was increased to 180°C and stirred for 24 hours. After cooling the mixture, triethylamine was slowly dropped into the flask to terminate the reaction, and then ethyl alcohol was added to the flask to obtain a product by precipitation and filtration. The obtained solid was purified by column chromatography with MC and n-hexane as developing solvents, and then Compound 199 was obtained by recrystallization using toluene and acetone (yield: 17%).

### Example 8: Synthesis of Compound 201

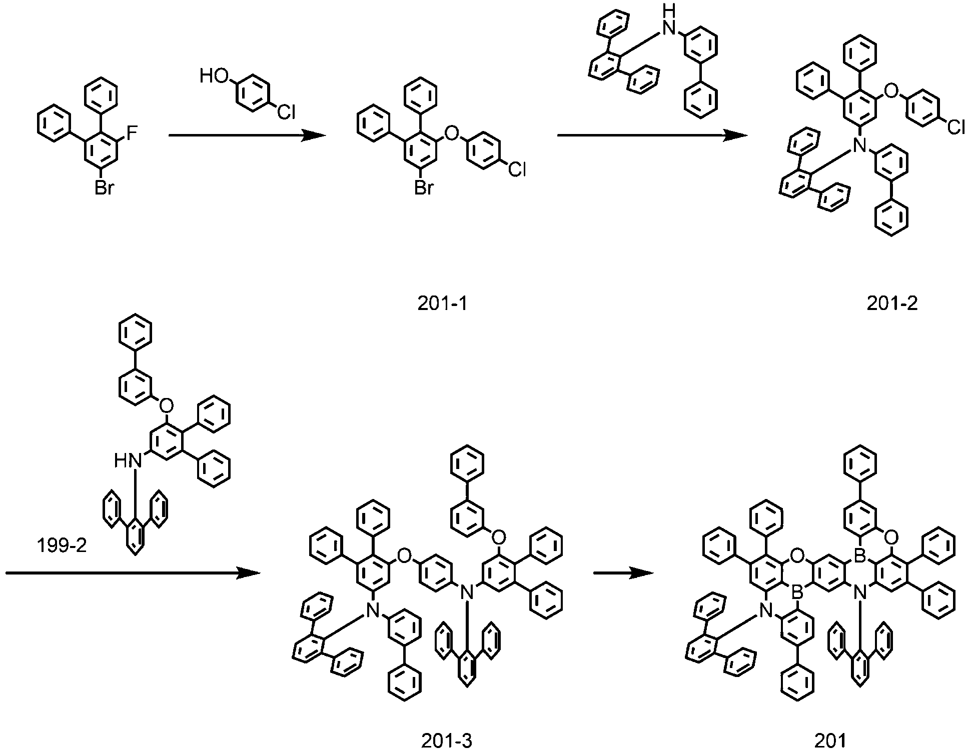

### (1) Synthesis of intermediate 201-1

5'-bromo-3'-fluoro-1,1':2',1"-terphenyl (1 eq), and 4-chlorophenol (1.5 eq), K₃PO₄ (2 eq) were dissolved in DMF and stirred at 160 °C for 12 hours. After being cooled, the solvent was removed under reduced pressure and washed with ethyl acetate and water. The organic layer was separated and dried over anhydrous MgSO₄, and then dried under reduced pressure. An intermediate 201-1 was obtained by purification using column chromatography with MC and n-hexane as developing solvents (yield: 79%)

### (2) Synthesis of Intermediate 201-2

The intermediate 201-1 (1 eq), N-([1,1'-biphenyl]-3-yl)-[1,1':3',1"-terphenyl]-2'-amine (1.1eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 24 hours. After being cooled, the solvent was removed under reduced pressure and washed with ethyl acetate and water. The organic layer was separated and dried over anhydrous MgSO₄, and then dried under reduced pressure. An intermediate 201-2 was obtained by purification using column chromatography with MC and n-hexane as developing solvents (yield: 32%)

### (3) Synthesis of intermediate 201-3

The intermediate 201-2 (1 eq), the intermediate 199-2 (1.3 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the solvent was removed under reduced pressure and washed with ethyl acetate and water. The organic layer was separated and dried over anhydrous MgSO₄, and then dried under reduced pressure. An intermediate 201-3 was obtained by purification using column chromatography with MC and n-hexane as developing solvents (yield: 45%).

### (4) Synthesis of Compound 201

The intermediate 201-3 (1 eq) and 2,6-dichloropyridine (5 eq) were dissolved in ortho dichlorobenzene in a flask, cooled to 0 °C, and BBr₃ (5 eq) was slowly injected under a nitrogen atmosphere. Thereafter, a temperature was increased to 180 °C and stirred for 24 hours. After cooling the mixture, triethylamine was slowly dropped into the flask to terminate the reaction, and then ethyl alcohol was added to the flask to obtain a product by precipitation and filtration. The obtained solid was purified by column chromatography with MC and n-hexane as developing solvents, and then Compound 201 was obtained by recrystallization using toluene and acetone (yield: 14%).

### Example 9: Synthesis of Compound 222

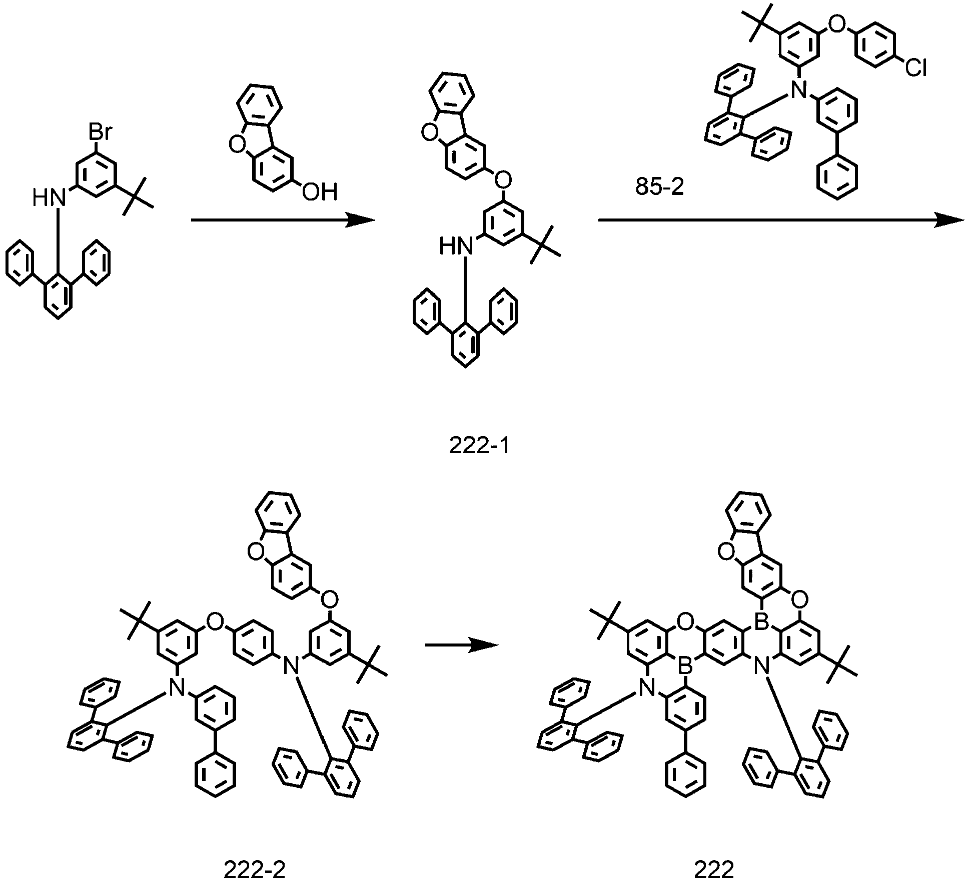

### (1) Synthesis of intermediate 222-1

N-(3-bromo-5-(tert-butyl)phenyl)-[1,1':3',1"-terphenyl]-2'-amine (1 eq), dibenzo[b,d]furan-2-ol (1.5 eq), Cul (0.1 eq), 2-picolinic acid (0.1 eq) and K₂CO₃ (3 eq) were dissolved in DMF and stirred at 160 °C for 12 hours. After being cooled, the solvent was removed under reduced pressure and washed with ethyl acetate and water. The organic layer was separated and dried over anhydrous MgSO₄, and then dried under reduced pressure. An intermediate 222-1 was obtained by purification using column chromatography with MC and n-hexane as developing solvents (yield: 62%)

### (2) Synthesis of intermediate 222-2

The intermediate 222-1 (1 eq), the intermediate 85-2 (1.3 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the solvent was removed under reduced pressure and washed with ethyl acetate and water. The organic layer was separated and dried over anhydrous MgSO₄, and then dried under reduced pressure. An intermediate 222-2 was obtained by purification using column chromatography with MC and n-hexane as developing solvents (yield: 43%).

### (3) Synthesis of Compound 222

The intermediate 222-2 (1 eq) and 2,6-dichloropyridine (5 eq) were dissolved in ortho dichlorobenzene in a flask, cooled to 0 °C, and BBr₃ (5 eq) was slowly injected under a nitrogen atmosphere. Thereafter, a temperature was increased to 180 °C and stirred for 24 hours. After cooling the mixture, triethylamine was slowly dropped into the flask to terminate the reaction, and then ethyl alcohol was added to the flask to obtain a product by precipitation and filtration. The obtained solid was purified by column chromatography with MC and n-hexane as developing solvents, and then Compound 222 was obtained by recrystallization using toluene and acetone (yield: 19%).

### Example 10: Synthesis of Compound 225

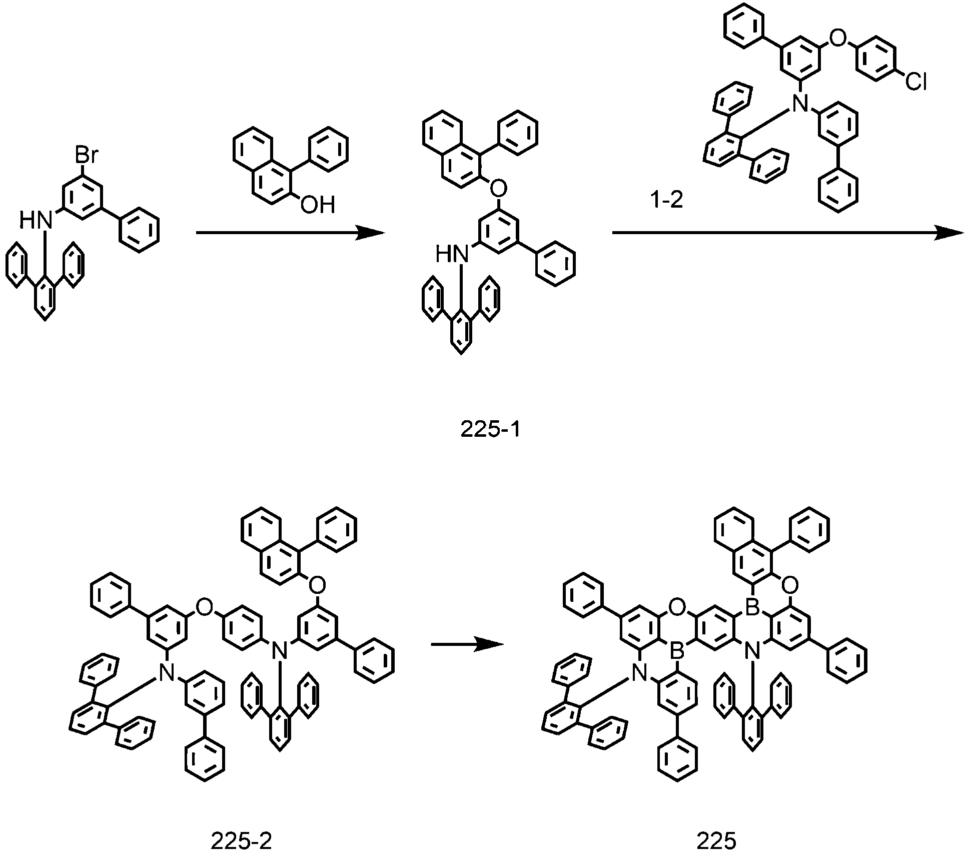

### (1) Synthesis of intermediate 225-1

N-(5-bromo-[1,1'-biphenyl]-3-yl)-[1,1':3',1"-terphenyl]-2'-amine (1 eq), 1-phenylnaphthalen-2-ol (1.5 eq), Cul (0.1 eq), 2-picolinic acid (0.1 eq) and K₂CO₃ (3 eq) were dissolved in DMF and stirred at 160 °C for 24 hours. After being cooled, the solvent was removed under reduced pressure and washed with ethyl acetate and water. The organic layer was separated and dried over anhydrous MgSO₄, and then dried under reduced pressure. An intermediate 225-1 was obtained by purification using column chromatography with MC and n-hexane as developing solvents (yield: 55%)

### (2) Synthesis of intermediate 225-2

The intermediate 225-1 (1 eq), the intermediate 1-2 (1.3 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the solvent was removed under reduced pressure and washed with ethyl acetate and water. The organic layer was separated and dried over anhydrous MgSO₄, and then dried under reduced pressure. An intermediate 225-2 was obtained by purification using column chromatography with MC and n-hexane as developing solvents (yield: 46%).

### (3) Synthesis of Compound 225

The intermediate 225-2 (1 eq) and 2,6-dichloropyridine (5 eq) were dissolved in ortho dichlorobenzene in a flask, cooled to 0 °C, and BBr₃ (5 eq) was slowly injected under a nitrogen atmosphere. Thereafter, a temperature was increased to 180 °C and stirred for 24 hours. After cooling the mixture, triethylamine was slowly dropped into the flask to terminate the reaction, and then ethyl alcohol was added to the flask to obtain a product by precipitation and filtration. The obtained solid was purified by column chromatography with MC and n-hexane as developing solvents, and then Compound 225 was obtained by recrystallization using toluene and acetone (yield: 17%).

### Example 11: Synthesis of Compound 240

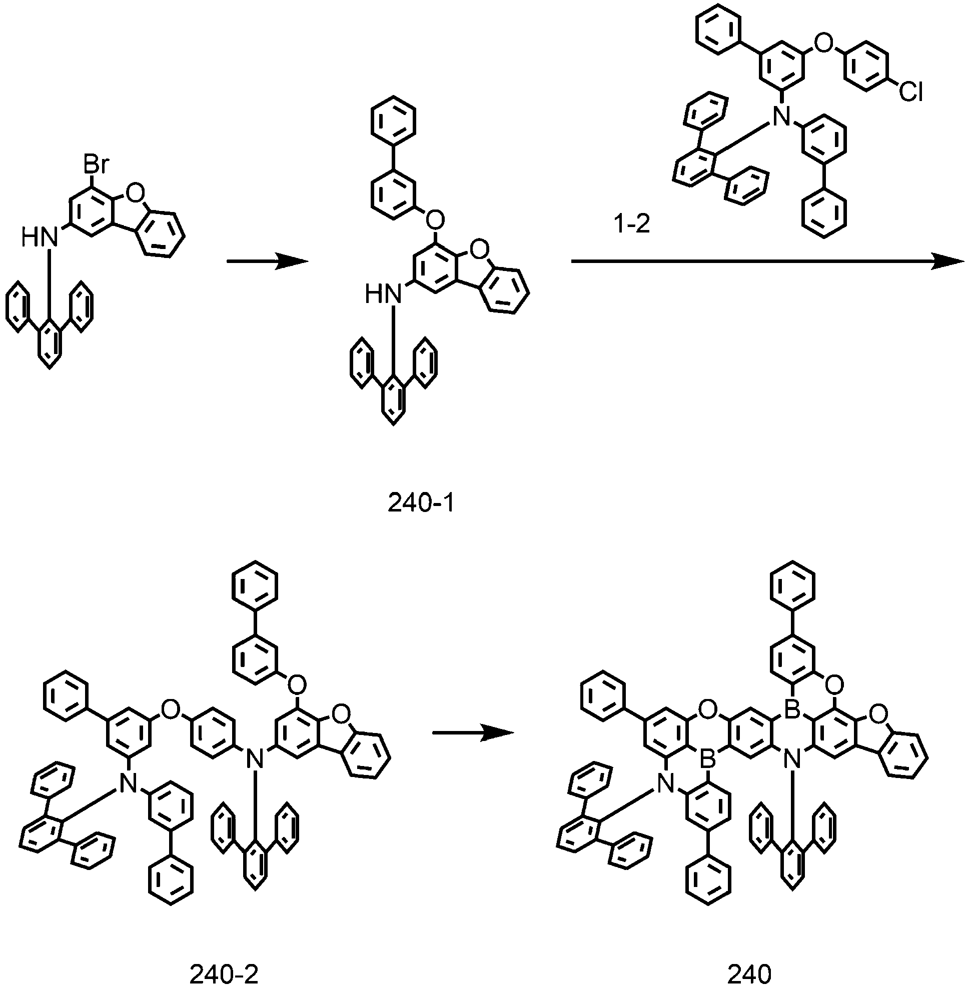

### (1) Synthesis of intermediate 240-1

N-([1,1':3',1"-terphenyl]-2'-yl)-4-bromodibenzo[b,d]furan-2-amine (1 eq), [1,1'-biphenyl]-3-ol (1.5 eq), Cul (0.1 eq), 2-picolinic acid (0.1 eq) and K₂CO₃ (3 eq) were dissolved in DMF and stirred at 160 °C for 24 hours. After being cooled, the solvent was removed under reduced pressure and washed with ethyl acetate and water. The organic layer was separated and dried over anhydrous MgSO₄, and then dried under reduced pressure. An intermediate 240-1 was obtained by purification using column chromatography with MC and n-hexane as developing solvents (yield: 68%)

### (2) Synthesis of intermediate 240-2

The intermediate 240-1 (1 eq), the intermediate 1-2 (1.3 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the solvent was removed under reduced pressure and washed with ethyl acetate and water. The organic layer was separated and dried over anhydrous MgSO₄, and then dried under reduced pressure. An intermediate 240-2 was obtained by purification using column chromatography with MC and n-hexane as developing solvents (yield: 50%).

### (3) Synthesis of Compound 240

The intermediate 240-2 (1 eq) and 2,6-dichloropyridine (5 eq) were dissolved in ortho dichlorobenzene in a flask, cooled to 0 °C, and BBr₃ (5 eq) was slowly injected under a nitrogen atmosphere. Thereafter, a temperature was increased to 180 °C and stirred for 24 hours. After cooling the mixture, triethylamine was slowly dropped into the flask to terminate the reaction, and then ethyl alcohol was added to the flask to obtain a product by precipitation and filtration. The obtained solid was purified by column chromatography with MC and n-hexane as developing solvents, and then Compound 240 was obtained by recrystallization using toluene and acetone (yield: 15%).

### Example 12: Synthesis of Compound 271

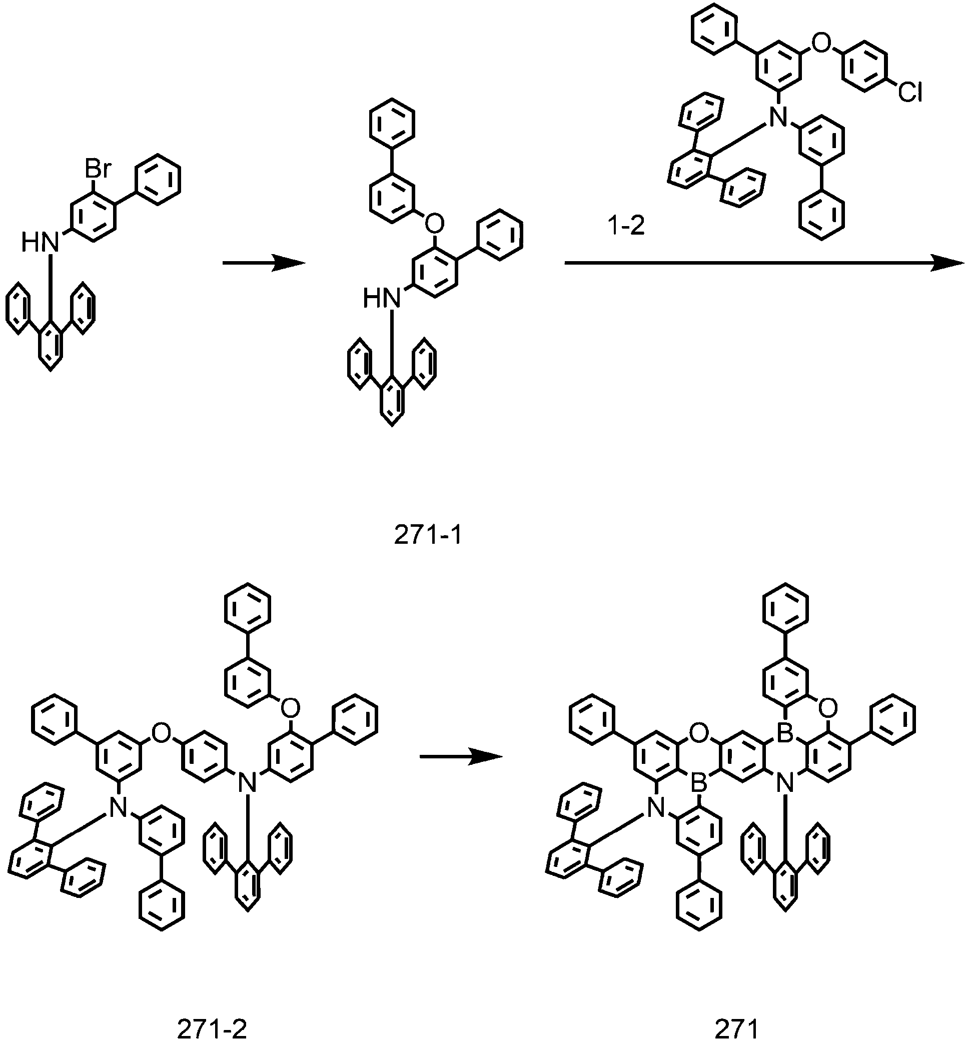

### (1) Synthesis of intermediate 271-1

N-(2-bromo-[1,1'-biphenyl]-4-yl)-[1,1':3',1"-terphenyl]-2'-amine (1 eq), [1,1'-biphenyl]-3-ol (1.5 eq), Cul (0.1 eq), 2-picolinic acid (0.1 eq) and K₂CO₃ (3 eq) were dissolved in DMF and stirred at 160 °C for 24 hours. After being cooled, the solvent was removed under reduced pressure and washed with ethyl acetate and water. The organic layer was separated and dried over anhydrous MgSO₄, and then dried under reduced pressure. An intermediate 271-1 was obtained by purification using column chromatography with MC and n-hexane as developing solvents (yield: 52%)

### (2) Synthesis of intermediate 271-2

The intermediate 271-1 (1 eq), the intermediate 1-2 (1.3 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After being cooled, the solvent was removed under reduced pressure and washed with ethyl acetate and water. The organic layer was separated and dried over anhydrous MgSO₄, and then dried under reduced pressure. An intermediate 271-2 was obtained by purification using column chromatography with MC and n-hexane as developing solvents (yield: 41%).

### (3) Synthesis of Compound 271

The intermediate 271-2 (1 eq) and 2,6-dichloropyridine (5 eq) were dissolved in ortho dichlorobenzene in a flask, cooled to 0 °C, and BBr₃ (5 eq) was slowly injected under a nitrogen atmosphere. Thereafter, a temperature was increased to 180 °C and stirred for 24 hours. After cooling the mixture, triethylamine was slowly dropped into the flask to terminate the reaction, and then ethyl alcohol was added to the flask to obtain a product by precipitation and filtration. The obtained solid was purified by column chromatography with MC and n-hexane as developing solvents, and then Compound 271 was obtained by recrystallization using toluene and acetone (yield: 16%).

### Comparative Example 1

p-DINBO represented by chemical formula was used.

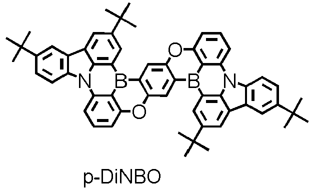

### Comparative Examples 2 to 5

Compounds represented by chemical formulae were used.

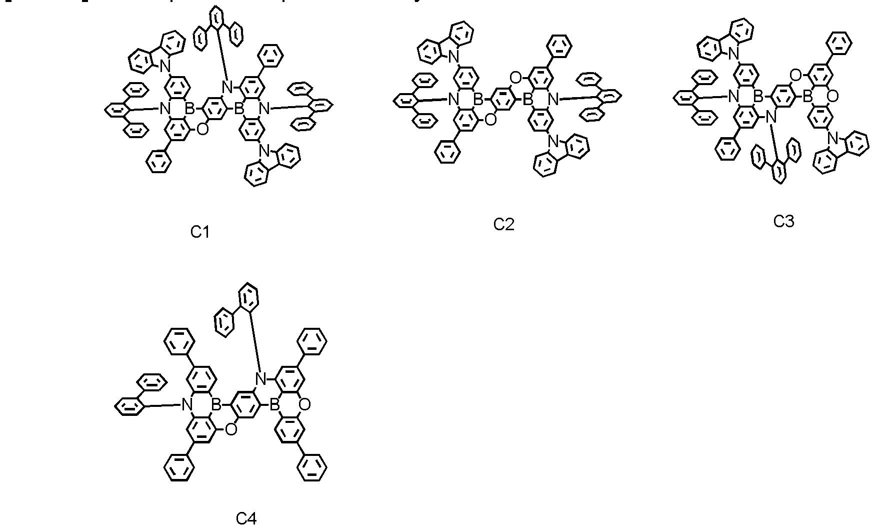

### Fabrication of light-emitting device

As an anode, a glass substrate (Corning product) on which a 15 Ω/cm² (1200 Å) ITO electrode was formed was cut into a size of 50 mm x 50 mm x 0.7 mm, and the cut substrate was ultrasonically cleaned for 5 minutes with isopropyl alcohol and then with pure water. The ultrasonically cleaned substrate was irradiated with an ultraviolet ray for 30 minutes and exposed to ozone, and then mounted on a vacuum deposition device.

Thereafter, Compound HT3 was vacuum-deposited on the anode to form a hole transport layer having a thickness of 600 Å. Compound HT47 was vacuum-deposited on the hole transport layer to form an electron blocking layer having a thickness of 100 Å.

A host compound in which a first host (Compound HTH1) and a second host (Compound ETH26) were mixed in a 1:1 ratio, a phosphorescent sensor (Compound S1), and a dopant compound shown in Table 1 were co-deposited in a weight ratio of 85:14:1 on the electron blocking layer to form an emission layer having a thickness of 300 Å.

Compound ET46 was vacuum-deposited on the emission layer to form a hole blocking layer having a thickness of 50 Å, and Compound ET47:LiQ (5:5 weight ratio) was deposited to form an electron transport layer having a thickness of 300 Å. LiQ was deposited on the electron transport layer to form an electron injection layer having a thickness of 10 Å.

A light-emitting device was obtained by vacuum-depositing Al on the electron injection layer to form a cathode having a thickness of 1,000 Å.

The compounds used in the fabrication of the light-emitting device are as follows.

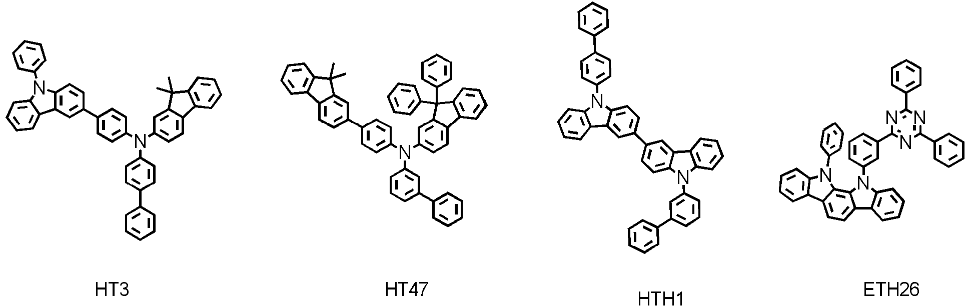

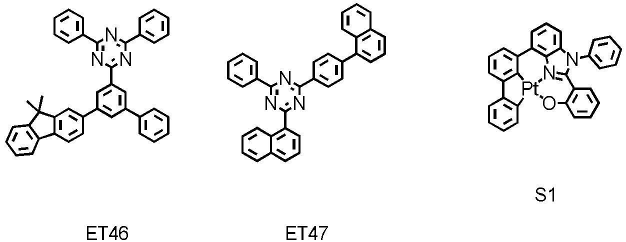

### Evaluation Example

Properties of the light-emitting device were measured by the following methods, and the results are shown in Table 1.

For example, a driving voltage (V), a luminous efficacy (cd/A), a maximum luminous wavelength (nm), and a device life-span (h) of the light-emitting device at 1000 cd/m² luminance were measured using Keithley SMU 236 and luminance meter PR650.

In Table 1, the device life-span (T95) indicates a time (h) until a luminance dropped to 95% of an initial value. A relative value with respect to the time measured in the light-emitting device using the compound of Comparative Example 1 was expressed as a life-span (T95) of each light-emitting device in Table 1. For example, the lifespan (T95) of each light-emitting device in Table 1 is expressed as a relative value compared to the time measured in the light-emitting device using the compound of Comparative Example 1.

**Table 1**

| | dopant compound | driving voltage (V) | efficiency (cd/A) | luminous wavelength (nm) | Device life-span (T95) |
|---|---|---|---|---|---|
| Example 1 | Compound 1 | 3.5 | 159 | 526 | 10.5 |
| Example 2 | Compound 2 | 3.6 | 145 | 524 | 11.7 |
| Example 3 | Compound 3 | 3.4 | 152 | 525 | 12.9 |
| Example 4 | Compound 13 | 3.6 | 148 | 527 | 8.8 |
| Example 5 | Compound 85 | 3.5 | 147 | 523 | 9.4 |
| Example 6 | Compound 193 | 3.7 | 139 | 524 | 6.8 |
| Example 7 | Compound 199 | 3.5 | 154 | 526 | 9.5 |
| Example 8 | Compound 201 | 3.6 | 143 | 527 | 8.2 |
| Example 9 | Compound 222 | 3.6 | 138 | 525 | 7.7 |
| Example 10 | Compound 225 | 3.6 | 149 | 528 | 8.9 |
| Example 11 | Compound 240 | 3.5 | 153 | 527 | 9.4 |
| Example 12 | Compound 271 | 3.6 | 135 | 528 | 7.3 |
| Comparative Example 1 | p-DINBO | 4.5 | 87 | 515 | 1 |
| Comparative Example 2 | C1 | 4.1 | 126 | 533 | 3.7 |
| Comparative Example 3 | C2 | 3.9 | 131 | 509 | 4.6 |
| Comparative Example 4 | C3 | 4.7 | 108 | 548 | 4.2 |
| Comparative Example 5 | C4 | 3.9 | 103 | 529 | 4.8 |

Referring to Table 1, each light-emitting device of Examples provided a driving voltage of 3.6 V or less and an efficiency of 135 cd/A or more. Additionally, the light-emitting devices of Examples provided improved life-span 8.3 times or more that of Comparative Example 1.

In the light-emitting device of Comparative Example 1 where the heterocyclic compound of Chemical Formula 1 was not included as the dopant, the efficiency was deteriorated and the life-span was also explicitly and significantly reduced.

When the compound C1 of Comparative Example 2 was used, the driving voltage of the light-emitting device increased and the life-span decreased. The compound C1 contains three nitrogen atoms and one oxygen atom around (e.g., surrounding) a boron atom in a multi-resonance core. Excessive nitrogen atoms of the compound C1 caused shallow HOMO level. Further, a triplet exciton concentration increased due to the generation of exciton by direct trapping in a boron emitter to result in life-span deterioration. A hole trap was caused even by a slight voltage increase, and a slight long-wavelength shift was also caused. Accordingly, high-purity green light dopant properties were not sufficiently provided.

The compound C2 of Comparative Example 3 had weak bonding properties due to oxygen atoms bonded to a para position of a benzene ring at a center of the molecule. Accordingly, sufficient green light emission was not implemented. The compound C2 of Comparative Example 3 corresponds to a short-wavelength light-emitting dopant that cannot be used as a green light dopant due to insufficient condensation structure around a core.

The compound C3 of Comparative Example 4 has a structure in which an N-B-N side and an O-B-O side are clearly separated. Accordingly, LRCT (long range charge transfer) between the N-B-N and O-B-O additionally occurs in addition to a multiple resonance, i.e., SRCT (short range charge transfer), thereby increasing an emission wavelength of the heterocyclic compound. Accordingly, the compound C3 cannot be used as a green light dopant due to a color spectrum deviation.

A color coordinate standard of a display device has been changing for demand for high color reproduction, such as Adobe color coordinate and BT.2020 color coordinate beyond DCI-P3. In the case of a green emitter, a maximum emission wavelength is shifted from about 530 nm to about 520 nm. The heterocyclic compound represented by Chemical Formula 1 may have a wavelength shortened by several nm compared to those of the compounds C1-C4 so that a deep green emission can be implemented and can be used for the above-described demands.

The compound C4 of Comparative Example 5 has a biphenyl group instead of a terphenyl group bonded to nitrogen, so the intermolecular distance cannot be sufficiently achieved. Accordingly, a long-wavelength shift slightly occurred due to intermolecular interaction in the light-emitting device, and DET suppression effect was also insufficient to deteriorate life-span of the light-emitting device.

In this disclosure, it will be understood that if (e.g., when) an element (or a region, a layer, a portion, and/or the like) is referred to as being "on" or "connected to" another element, it may be directly arranged on or connected to the other element, or intervening elements may be arranged therebetween. In contrast, "directly on" may refer to that there are no additional layers, films, regions, plates, and/or the like, between a layer, a film, a region, a plate, and/or the like and the other part. For example, "directly on" may refer to two layers or two members are arranged without utilizing an additional member such as an adhesive member therebetween.

As used herein, the term "and/or" or "or" may include any and all combinations of one or more of the associated listed items. Expressions such as "at least one of," "one of," and "selected from," when preceding a list of elements, modify the entire list of elements and do not modify the individual elements of the list. For example, "at least one of a, b, or c," "at least one selected from a, b, and c," "at least one selected from among a to c," and/or the like, may indicate only a, only b, only c, both (e.g., simultaneously) a and b, both (e.g., simultaneously) a and c, both (e.g., simultaneously) b and c, all of a, b, and c, or variations thereof. The "/" utilized herein may be interpreted as "and" or as "or" depending on the situation.

It will be understood that, although the terms "first," "second," and/or the like may be used herein to describe one or more suitable elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed herein could be termed a second element, component, region, layer, or section, respectively, without departing from the scope of the disclosure. Similarly, a second element, component, region, layer, or section may be termed a first element, component, region, layer, or section, respectively. As used herein, the singular forms, "a," "an," "one," and "the" are intended to include the plural forms as well, unless the context clearly indicates otherwise. Further, the utilization of "may" when describing embodiments of the present disclosure refers to "one or more embodiments of the present disclosure".

It will be further understood that the terms "comprise(s)/comprising," "include(s)/including," and/or "have(has)/having," if (e.g., when) used in this disclosure, specify the presence of stated features, integers, steps, operations, elements, components, and/or groups thereof, but do not preclude the presence or addition of one or more other features, integers, steps, operations, elements, components, and/or groups thereof. Additionally, the terms "comprise(s)/comprising," "include(s)/including," "have/has/having," or other similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

Unless otherwise defined, all terms (including technical and scientific terms) used herein have the same meaning as commonly understood by one of ordinary skill in the art to which this disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, or 5% of the stated value.

In the context of the present application and unless otherwise defined, the terms "use," "using," and "used" may be considered synonymous with the terms "utilize," "utilizing," and "utilized," respectively.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

The light emitting device, the display apparatus/device, the electronic apparatus/device, a device for manufacturing the same, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

In the present disclosure, each suitable feature of the various embodiments of the disclosure may be combined or combined with each other, partially or entirely, and may be technically interlocked and operated in various suitable ways, and each embodiment may be implemented independently of each other or in conjunction with each other in any suitable manner unless otherwise stated or implied.

Although one or more embodiments of the disclosure have been described, it is understood that the disclosure should not be limited to these embodiments, but one or more suitable changes and modifications can be made by one ordinary skilled in the art within the scope of disclosure as hereinafter claimed.

Accordingly, the technical scope of the disclosure is not intended to be limited to the contents set forth in the detailed description of the disclosure, but is intended to be defined by the appended claims and equivalents thereof.

## Claims

1. A condensed heterocyclic compound represented by Chemical Formula 1: 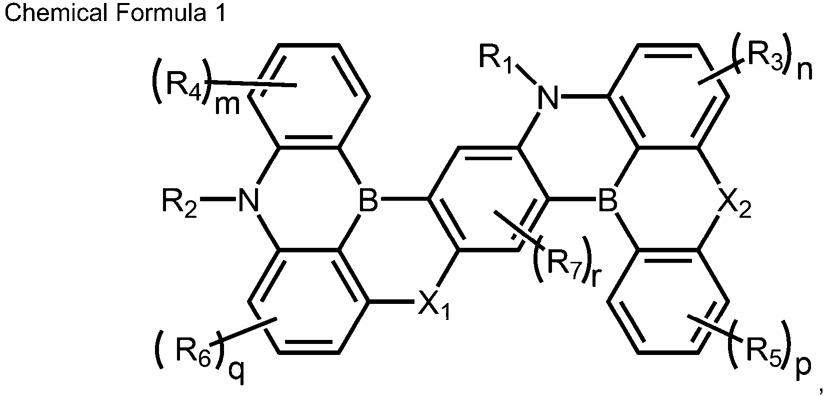
wherein, in Chemical Formula 1, X₁ and X₂ are each independently O, S, or Se, and
R₁ and R₂ are each independently a group represented by Chemical Formula 2: 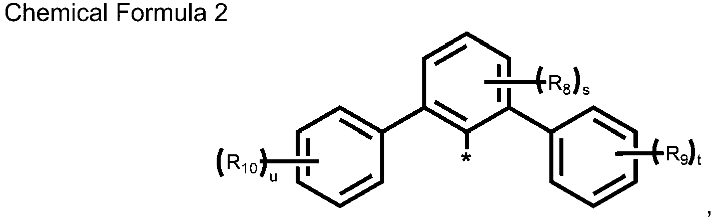 and
wherein, in Chemical Formulae 1 and 2,
R₃ to R₁₀ are each independently hydrogen, deuterium, a halogen, a hydroxyl group, a cyano group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, a substituted or unsubstituted C₈-C₆₀ condensed polycyclic group, -SiRR'R", -P(=O)RR', -NRR', -BRR', -C(=O)R, or -S(=O)₂R; and/or
optionally, two or more selected from among R₃ to R₁₀ are combined with each other to form a substituted or unsubstituted C₃-C₆₀ cycloalkyl ring, a substituted or unsubstituted C₅-C₆₀ cycloalkenyl ring, a substituted or unsubstituted C₃-C₆₀ heterocycloalkyl ring, a substituted or unsubstituted C₃-C₆₀ heterocycloalkenyl ring, a substituted or unsubstituted C₆-C₆₀ aryl ring, or a substituted or unsubstituted C₂-C₆₀ heteroaryl ring,
wherein R, R', and R" are each independently hydrogen, deuterium, a halogen, a hydroxyl group, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group or a substituted or unsubstituted C₈-C₆₀ condensed polycyclic group,
n, q, and s are each independently an integer from 0 to 3,
m and p are each independently an integer from 0 to 4,
r is an integer from 0 to 2,
t and u are each independently an integer from 0 to 5, and
* represents a bonding point.

2. The condensed heterocyclic compound of claim 1, wherein the group represented by Chemical Formula 2 is represented by Chemical Formula 2-1 or Chemical Formula 2-2: 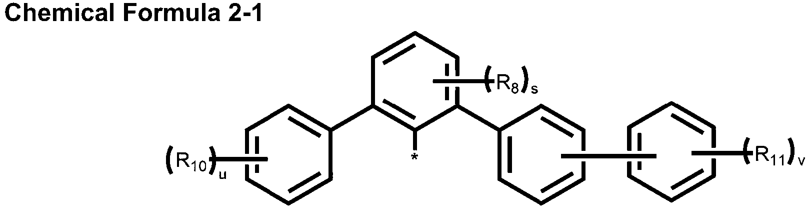 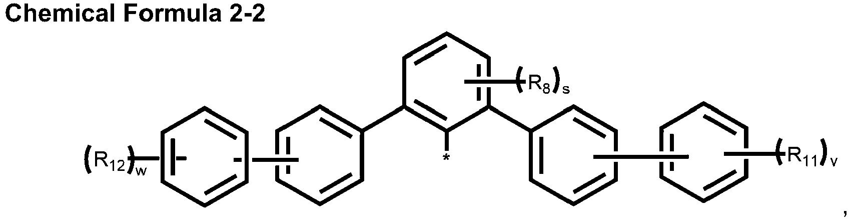 and
wherein, in Chemical Formulae 2-1 and 2-2, R₈, R₁₀, s, and u are the same as those defined in Chemical Formula 2,
R₁₁ and R₁₂ are each independently hydrogen, deuterium, a halogen, a cyano group, a hydroxyl group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, a substituted or unsubstituted C₈-C₆₀ condensed polycyclic group, - SiRR'R", -P(=O)RR', -NRR', -BRR', -C(=O)R, or -S(=O)₂R,
R, R', and R" are the same as those defined in Chemical Formulae 1 and 2, and
v and w are each independently an integer from 0 to 5.

3. The condensed heterocyclic compound of claim 1 or claim 2, wherein the condensed heterocyclic compound is represented by one of Chemical Formulae 1-1 to 1-11: 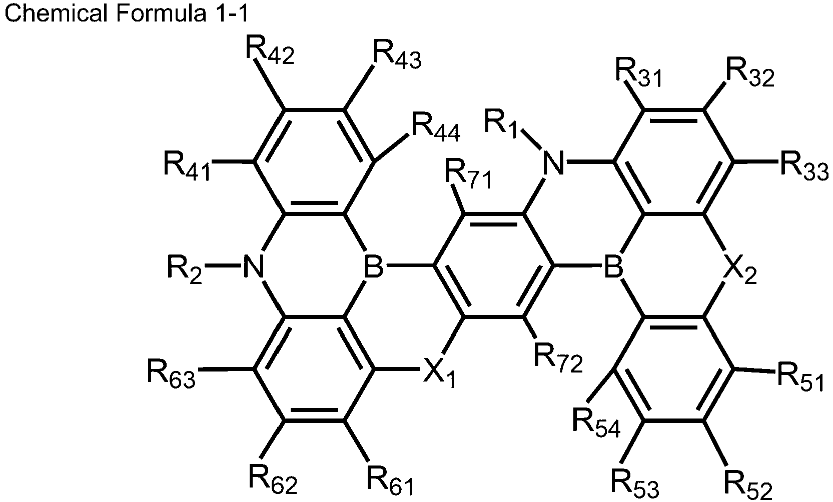 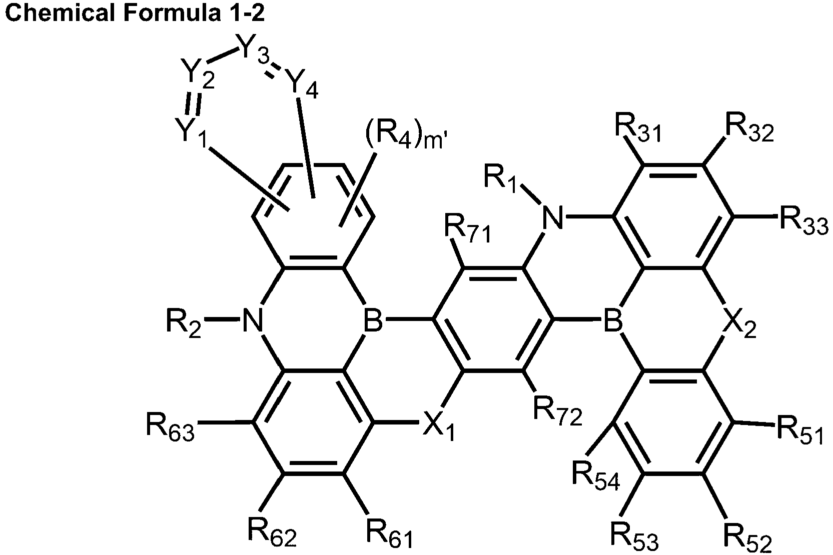 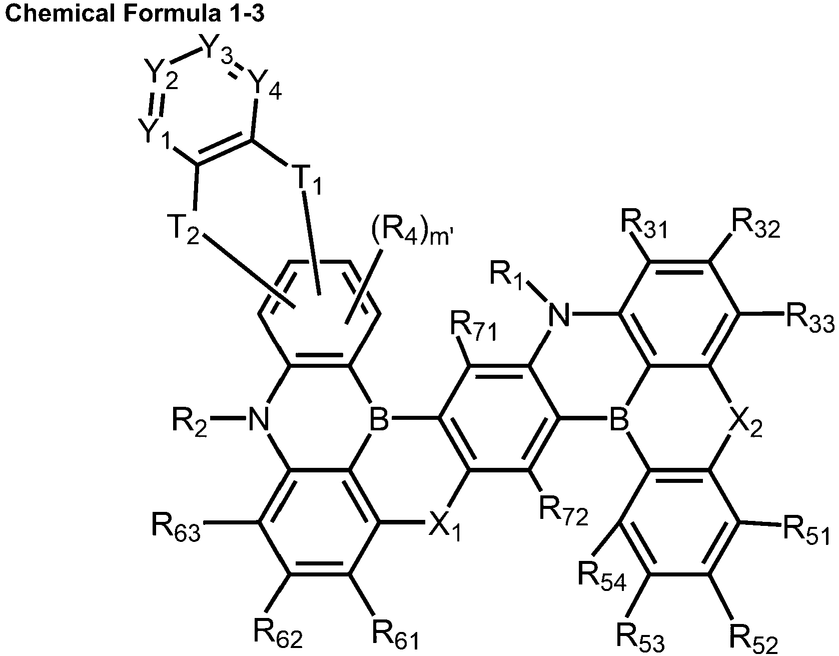 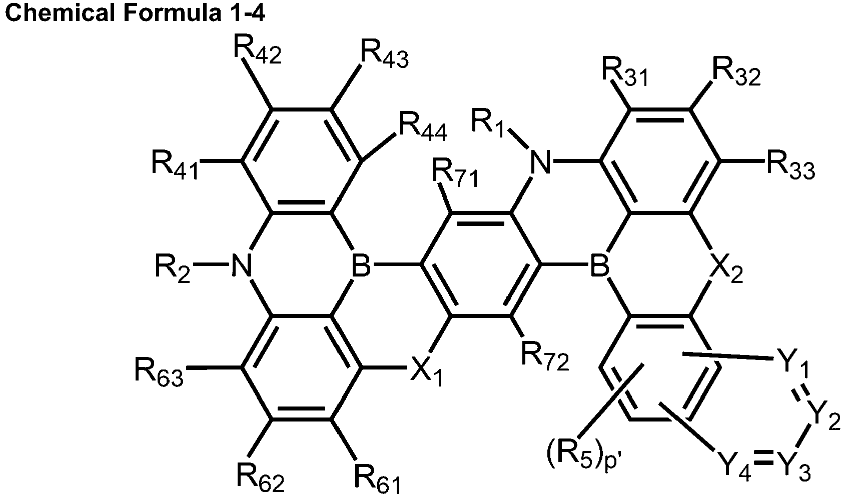 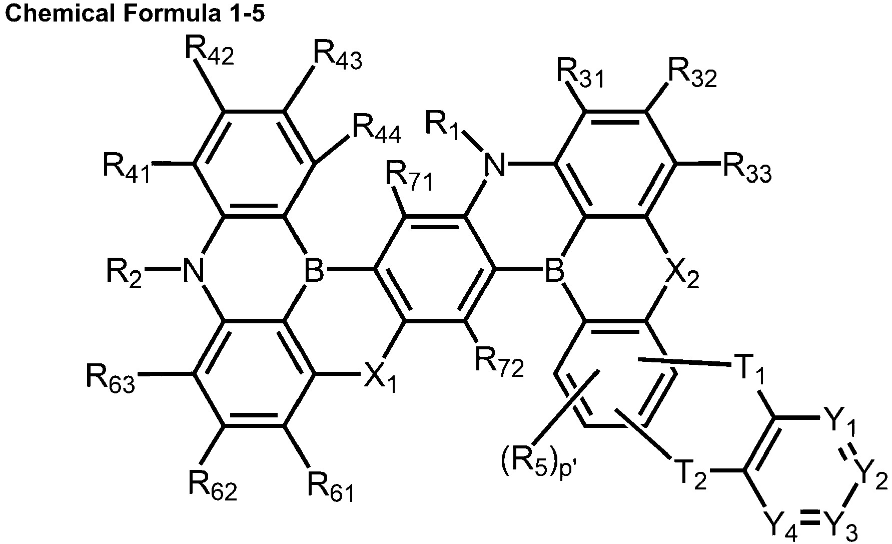 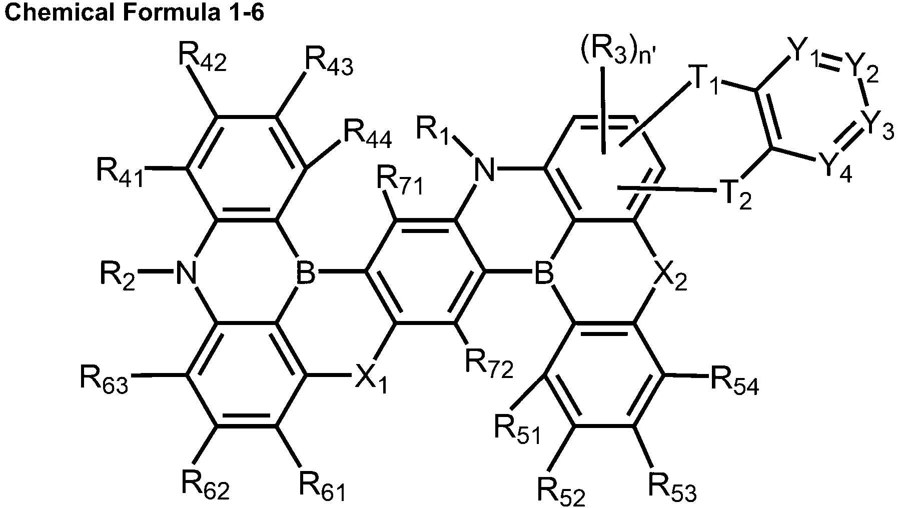 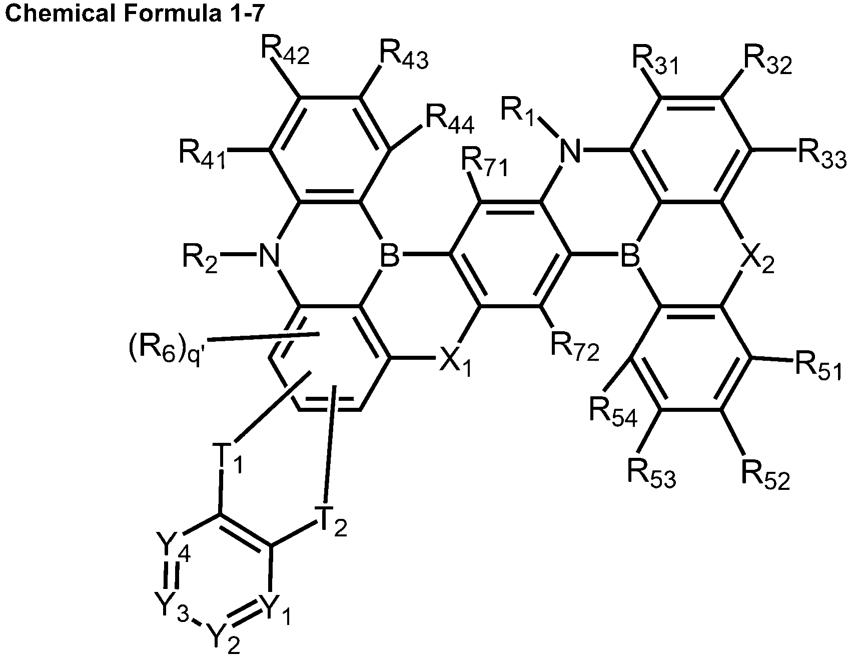 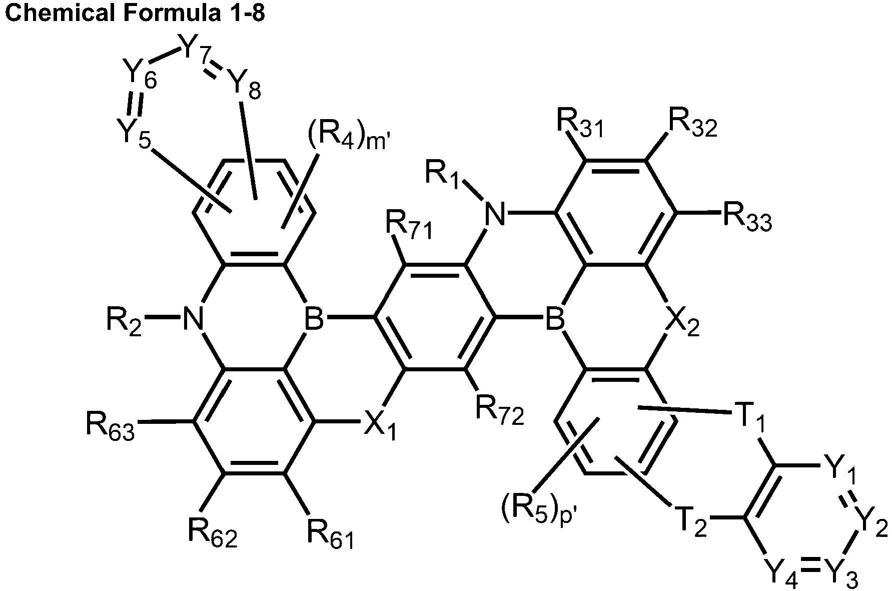 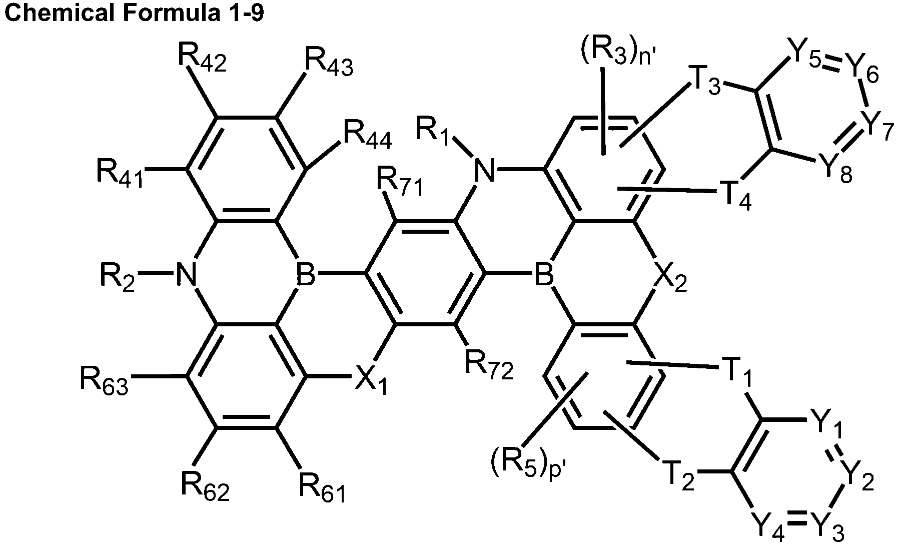 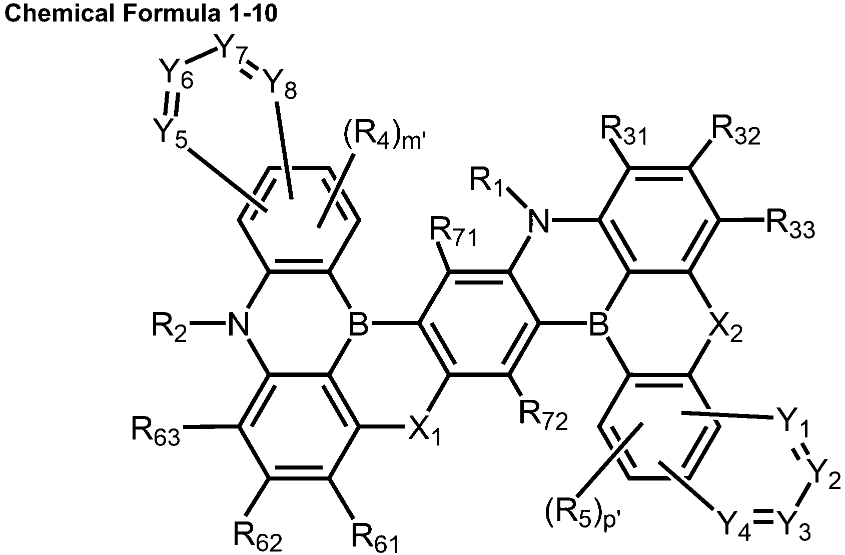 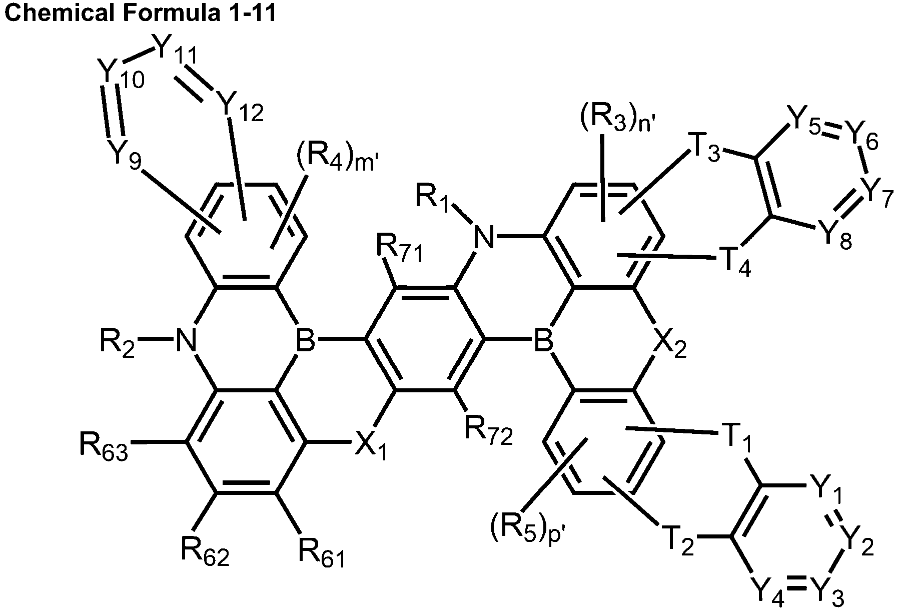 in Chemical Formulae 1-1 to 1-11, X₁, X₂, and R₁ to R₆ being the same as those defined in Chemical Formulae 1 and 2,
R₃₁ to R₃₃ are each as described in connection with R₃,
R₄₁ to R₄₄ are each as described in connection with R₄,
R₅₁ to R₅₄ are each as described in connection with R₅,
R₆₁ to R₆₃ are each as described in connection with R₆,
R₇₁ and R₇₂ are each as described in connection with R₇,
m' is 0 to 2,
n' is 0 or 1,
p' is 0 to 2,
q' is 0 or 1,
Y₁ is C(Z₁) or N, Y₂ is C(Z₂) or N, Y₃ is C(Z₃) or N, Y₄ is C(Z₄) or N, Y₅ is C(Z₅) or N, Y₆ is C(Z₆) or N, Y₇ is C(Z₇) or N, Y₈ is C(Z₈) or N, Y₉ is C(Z₉) or N, Y₁₀ is C(Z₁₀) or N, Y₁₁ is C(Z₁₁) or N, Y₁₂ is C(Z₁₂) or N,
T₁ to T₄ are each independently a single bond, O, S or Se,
and Z₁ to Z₁₂ may each as described in connection with R₃.

4. The condensed heterocyclic compound of any one of claims 1 to 3, wherein:
(i) in Chemical Formula 1, at least two selected from among R₃ to R₆ are the same; and/or
(ii) in Chemical Formulae 1 and 2, R₃ to R₁₀ are each independently hydrogen, deuterium, a substituted or unsubstituted C₁-C₆₀ alkyl group, a substituted or unsubstituted C₆-C₂₀ aryl group or a substituted or unsubstituted C₂-C₁₅ heteroaryl group.

5. The condensed heterocyclic compound of any one of claims 1 to 4, wherein:
(i) in Chemical Formula 1, n, m, p, and q are each independently 0, 1 or 2; and/or
(ii )in Chemical Formula 2, s, t, and u are each independently 0 or 1.

6. The condensed heterocyclic compound of any one of claims 1 to 5, wherein, in Chemical Formulae 1 and 2, R₃ to R₁₀ are each independently hydrogen, deuterium, a C₄-C₁₅ tert-alkyl group substituted or unsubstituted with deuterium, a phenyl group substituted or unsubstituted with deuterium, a C₇-C₂₀ alkylphenyl group substituted or unsubstituted with deuterium, a biphenyl group substituted or unsubstituted with deuterium, a terphenyl group substituted or unsubstituted with deuterium, a naphthalene group substituted or unsubstituted with deuterium, a carbazole group substituted or unsubstituted with deuterium, a dibenzofuran group substituted or unsubstituted with deuterium, or a pyridine group substituted or unsubstituted with deuterium.

7. The condensed heterocyclic compound of claim 1, wherein the condensed heterocyclic compound is any one selected from among compounds represented by the following chemical formulae:

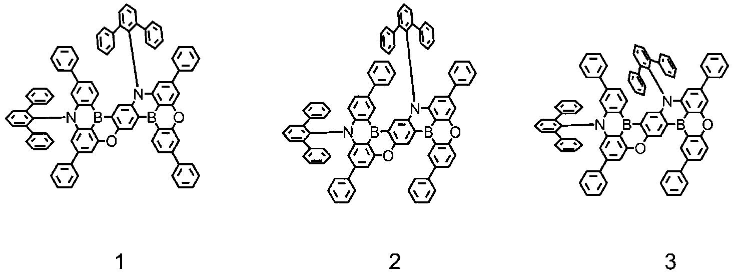

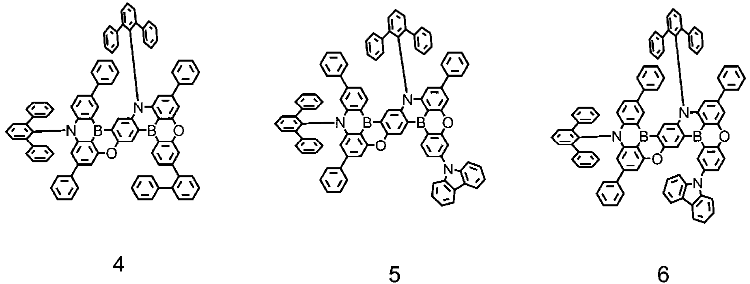

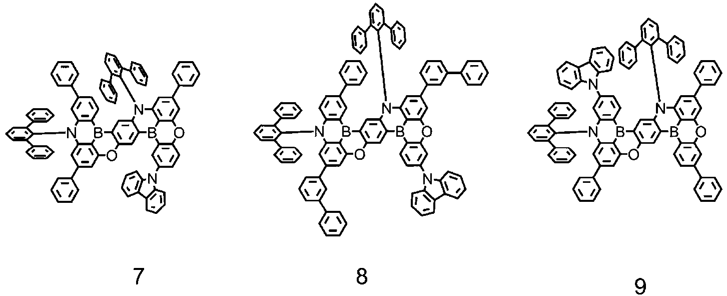

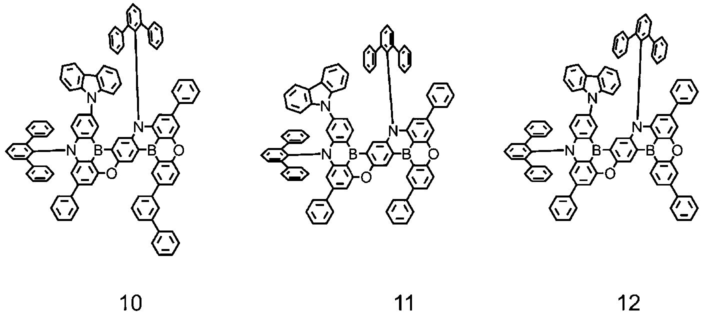

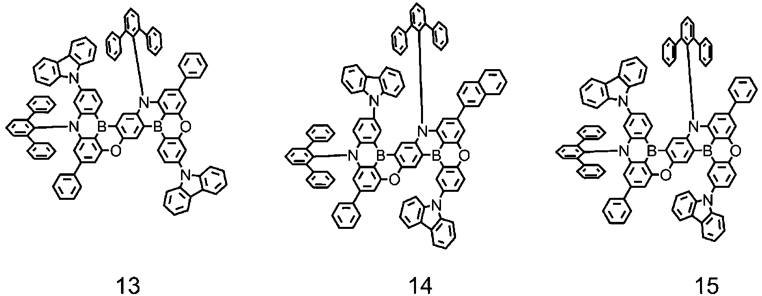

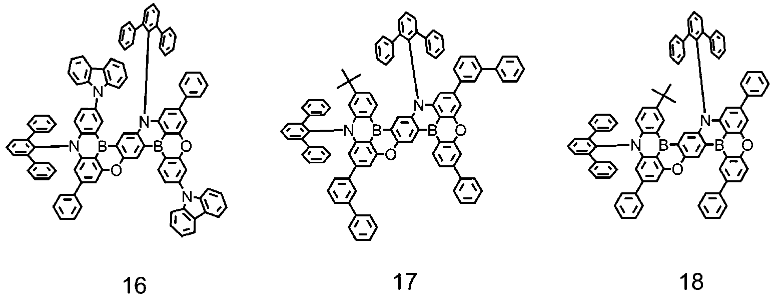

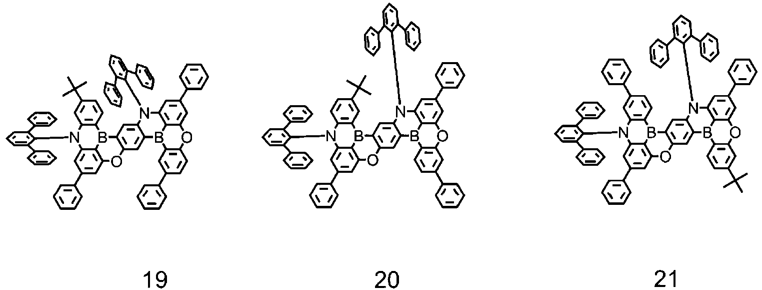

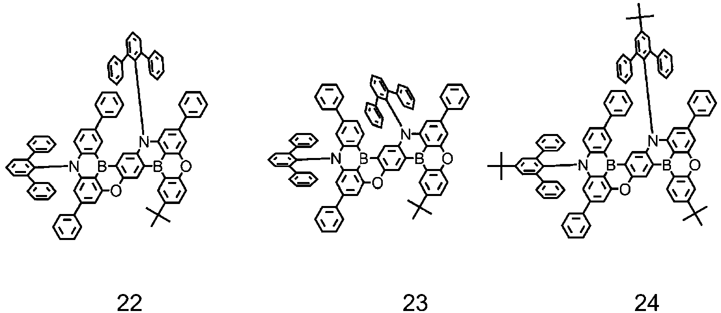

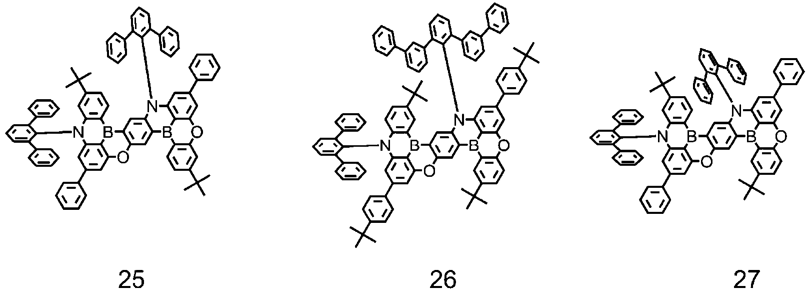

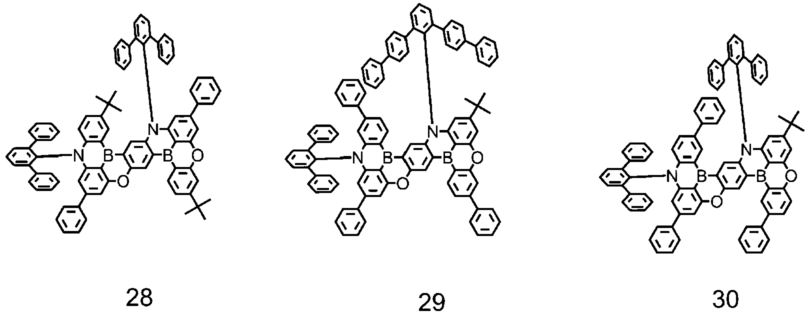

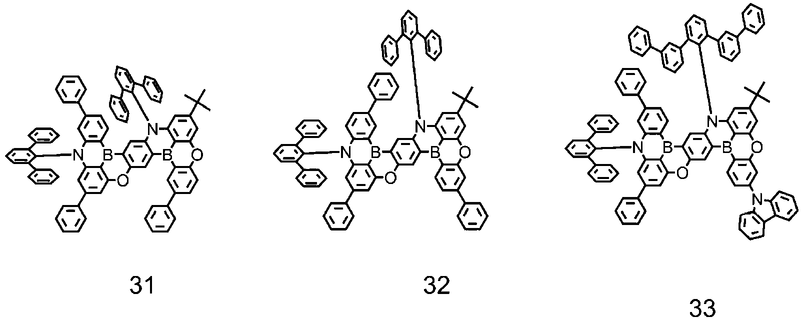

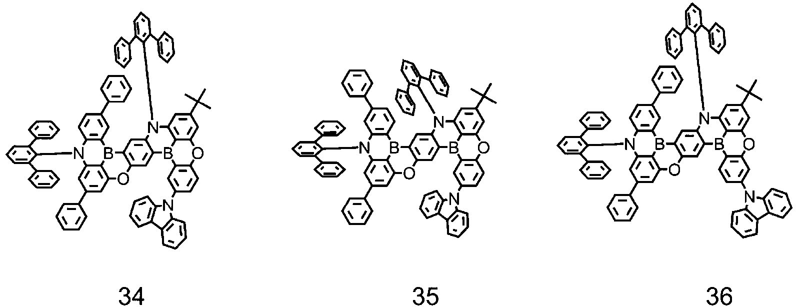

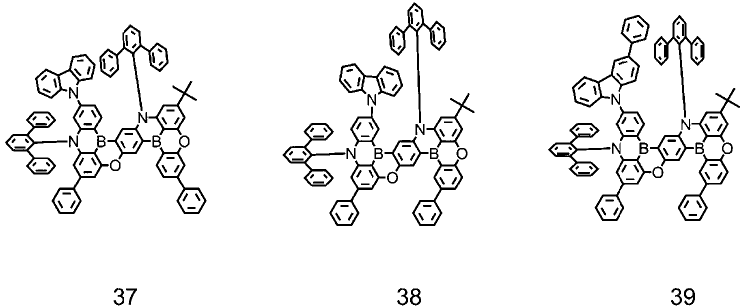

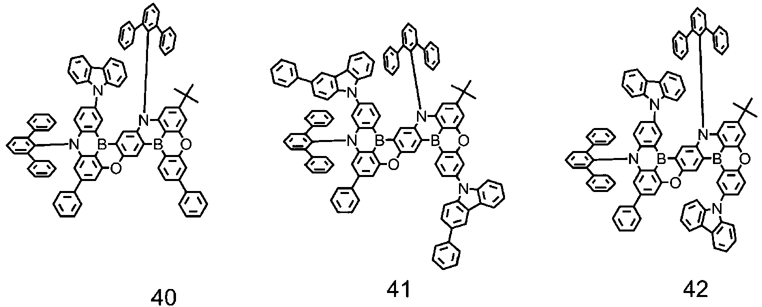

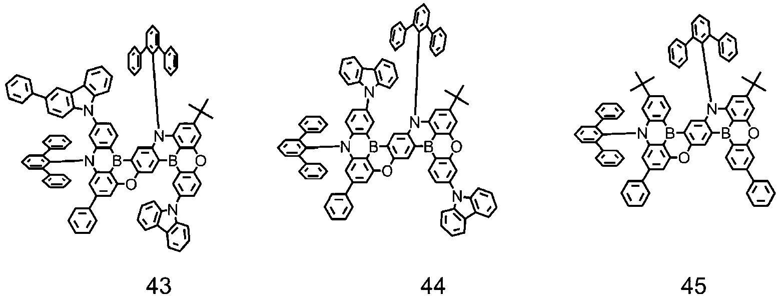

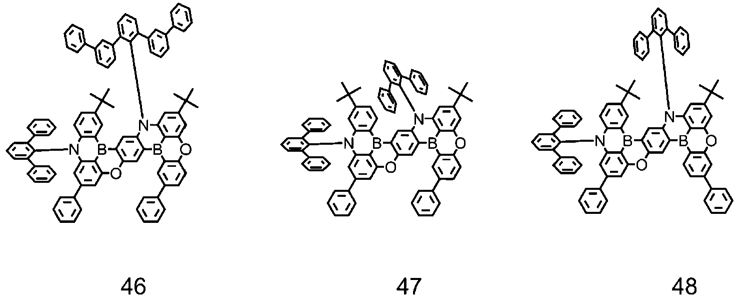

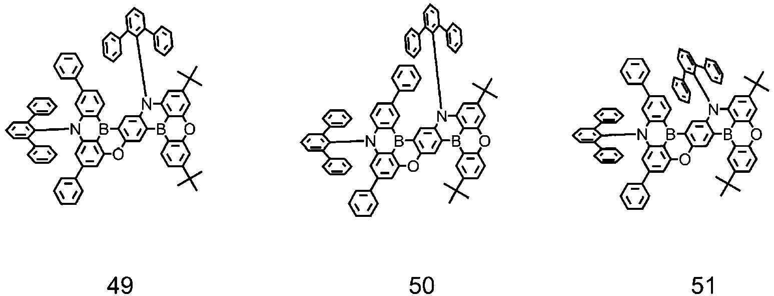

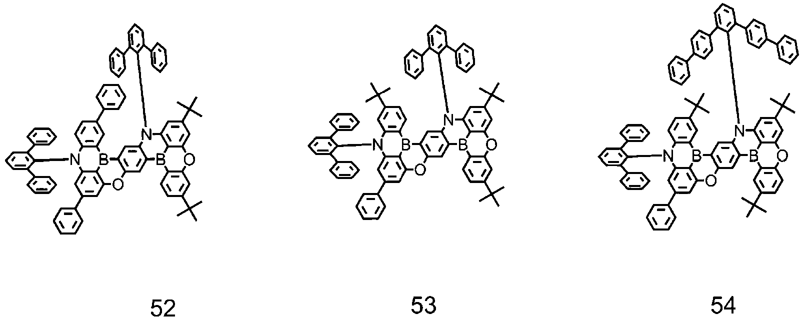

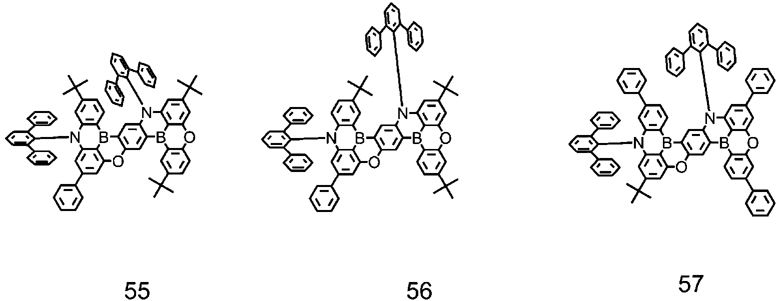

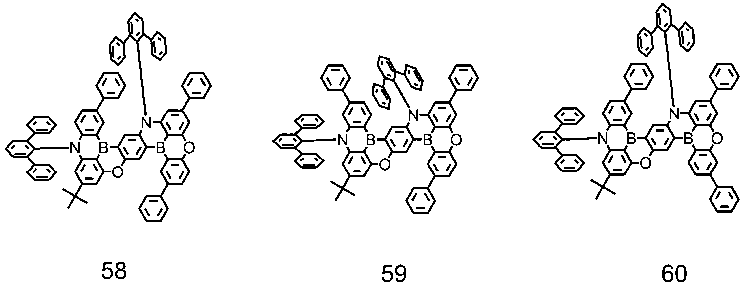

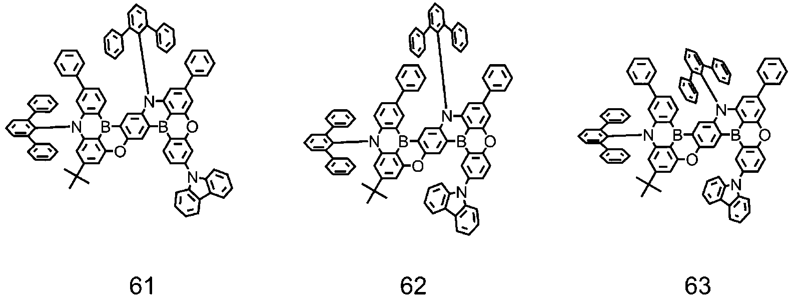

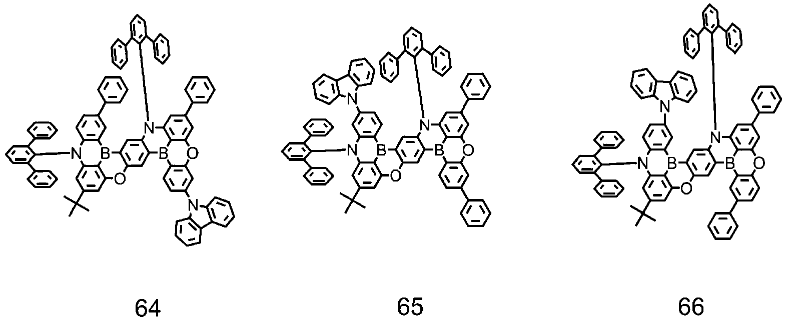

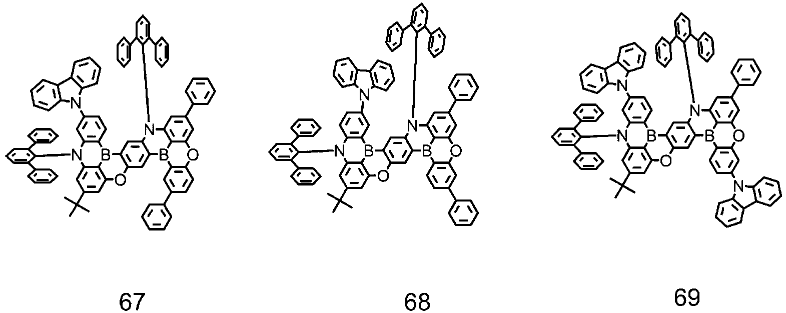

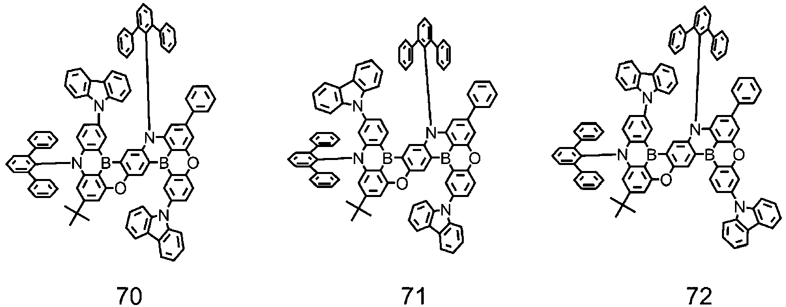

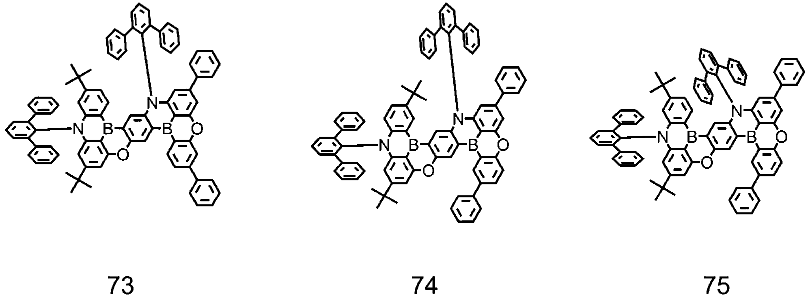

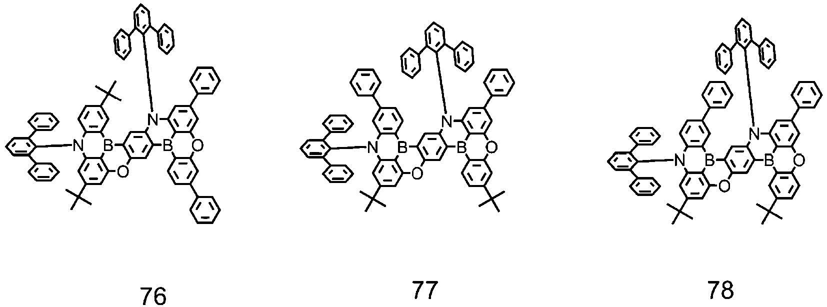

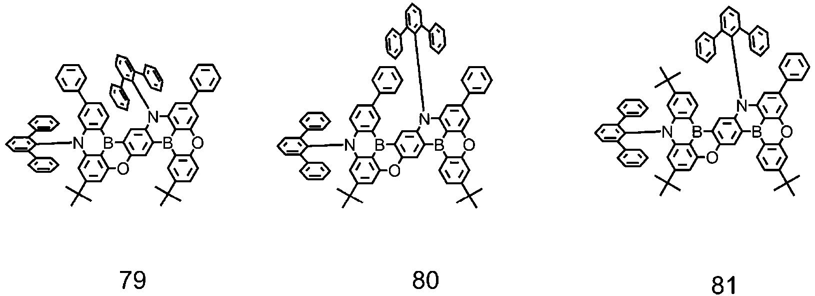

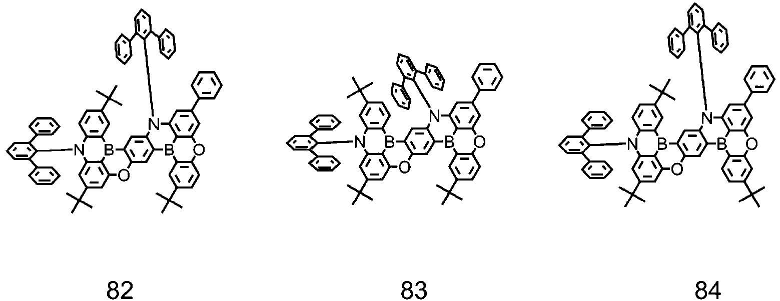

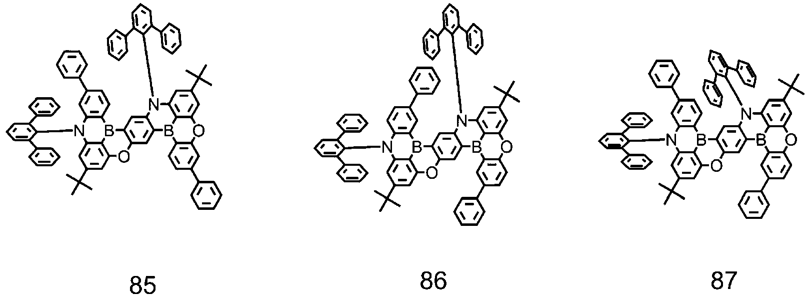

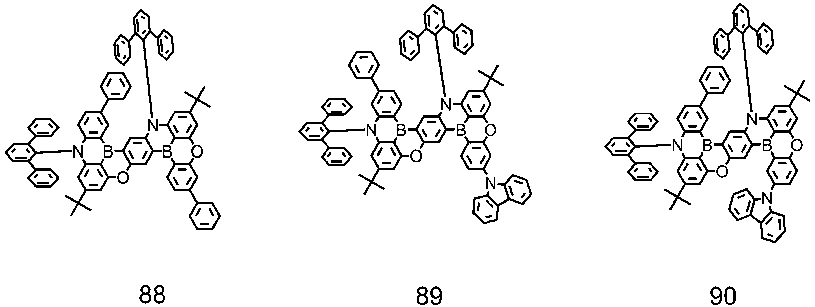

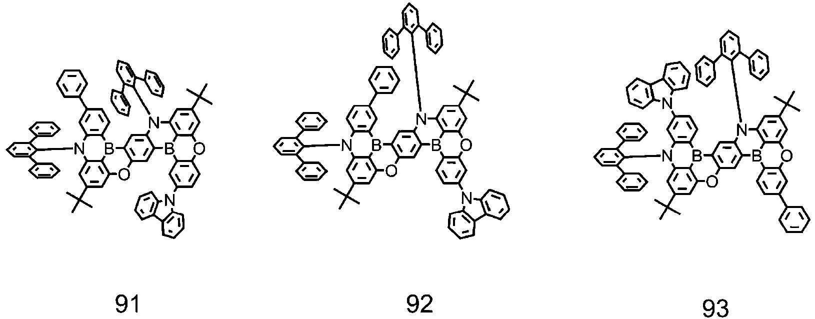

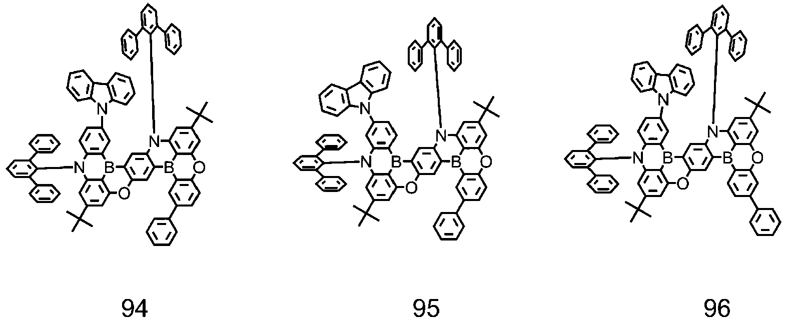

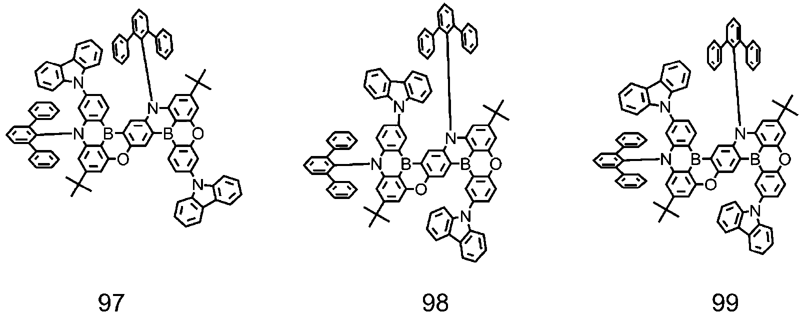

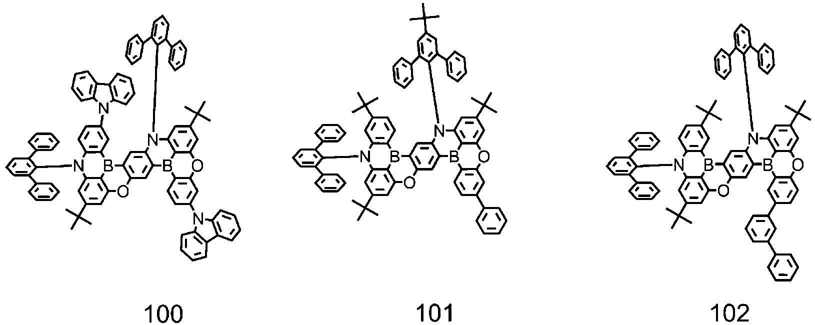

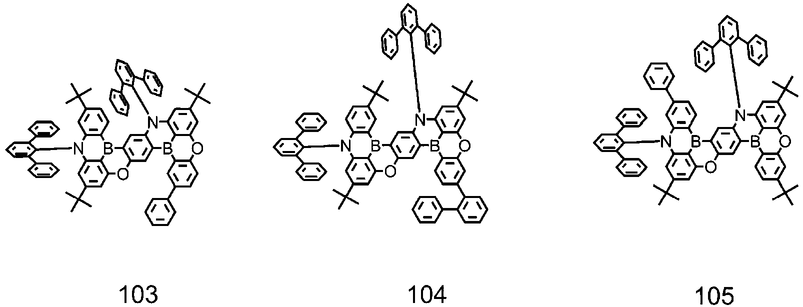

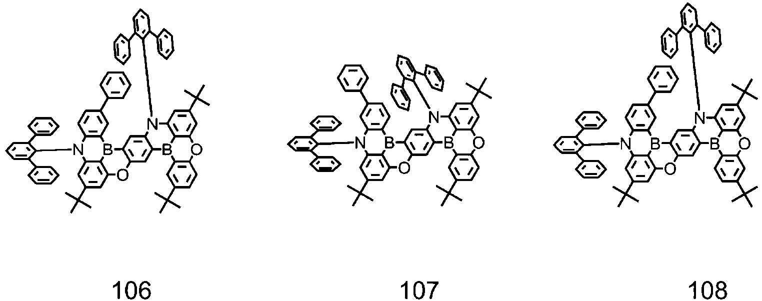

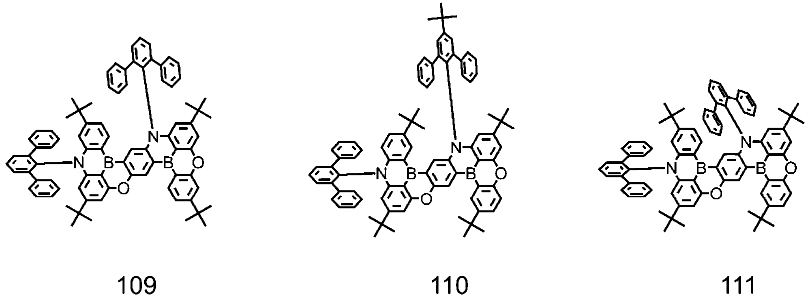

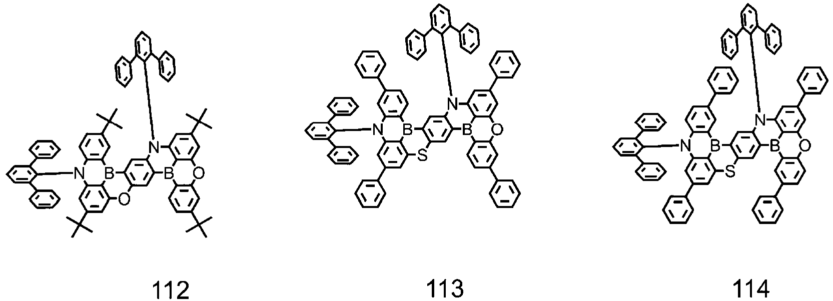

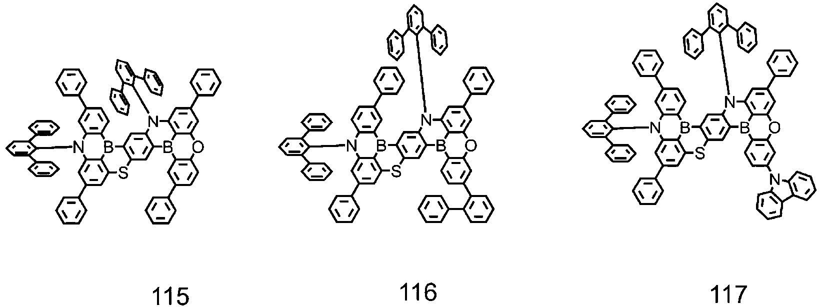

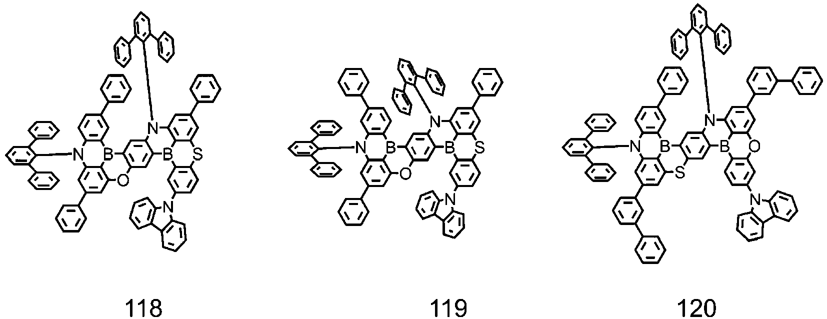

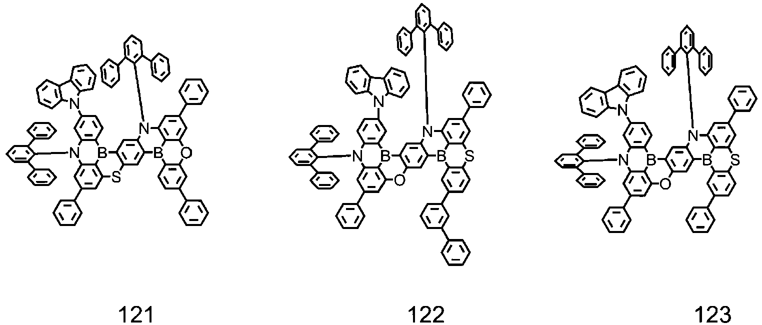

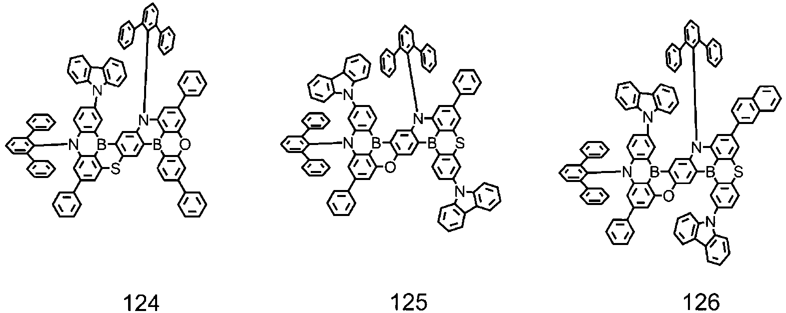

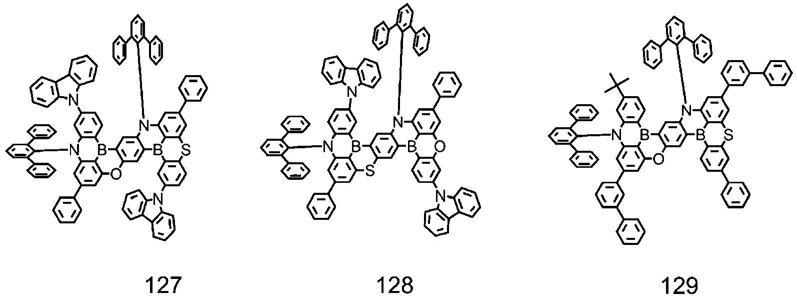

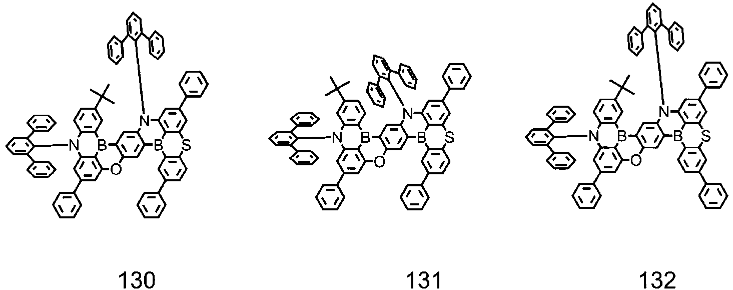

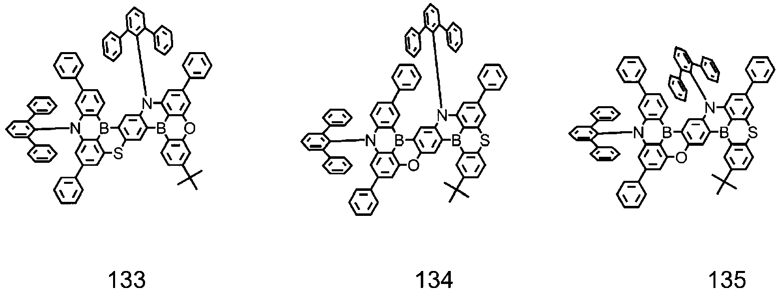

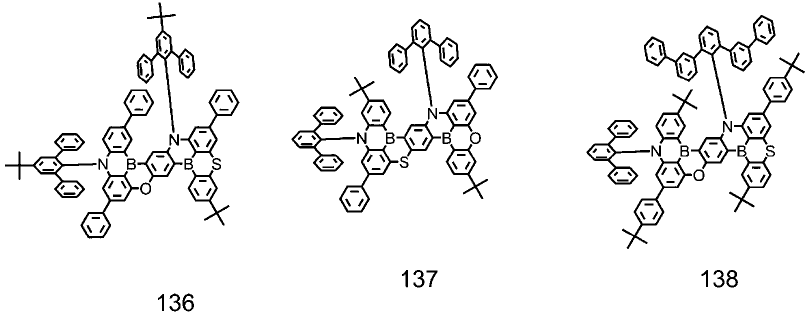

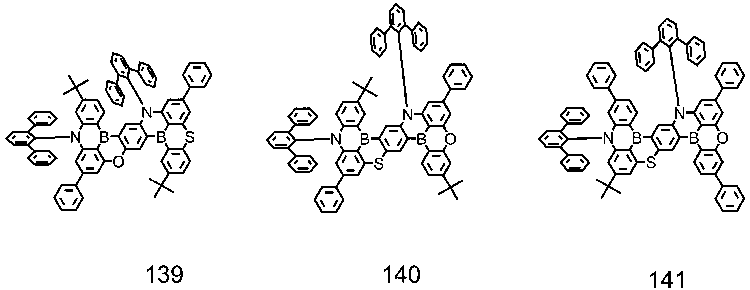

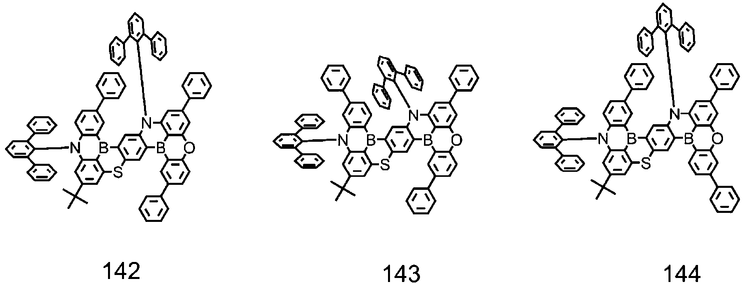

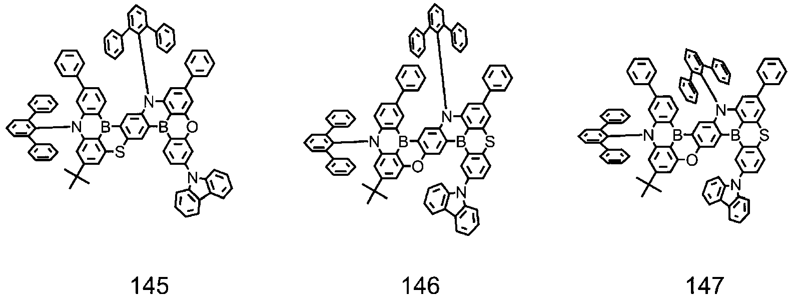

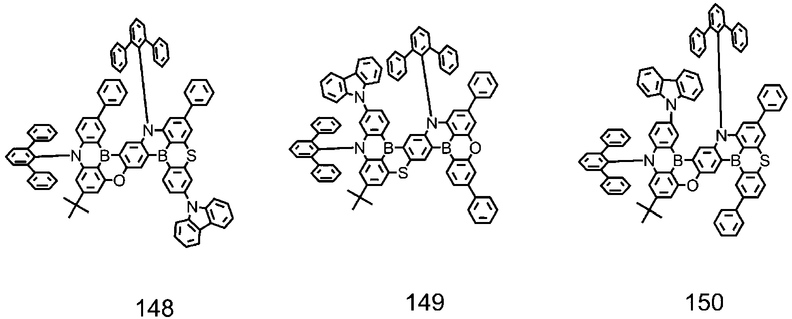

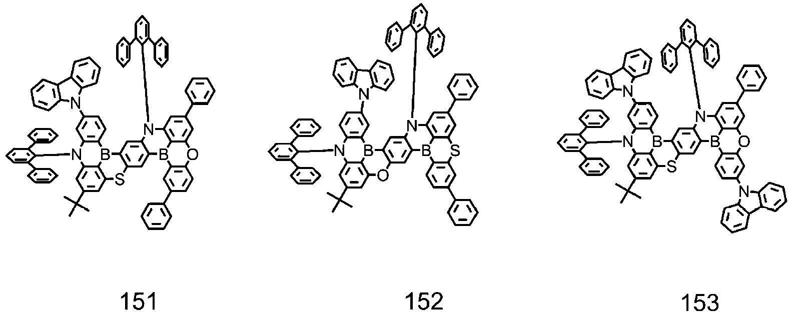

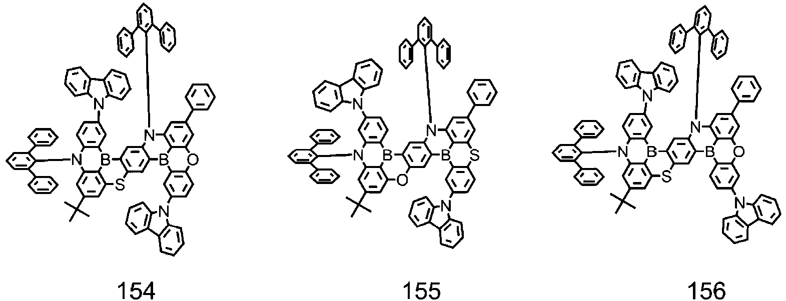

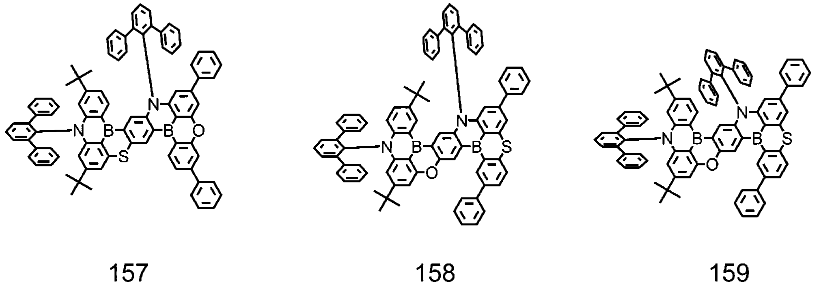

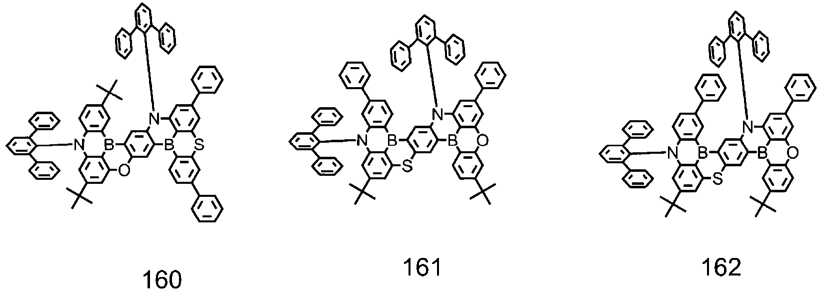

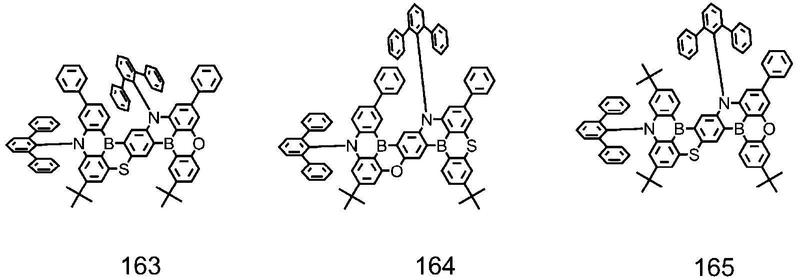

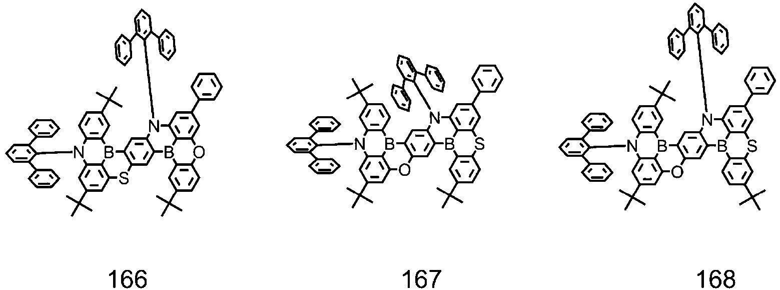

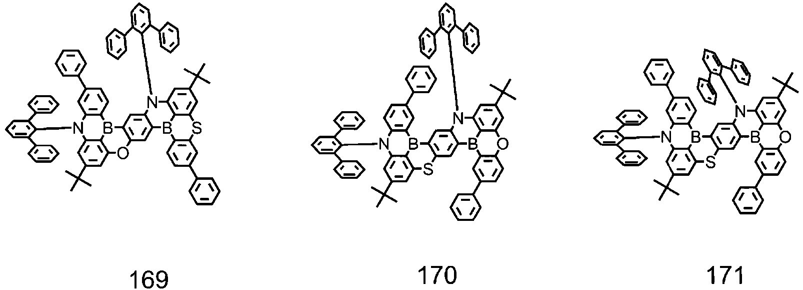

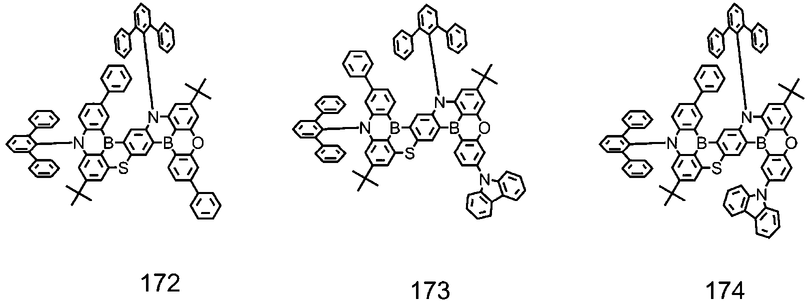

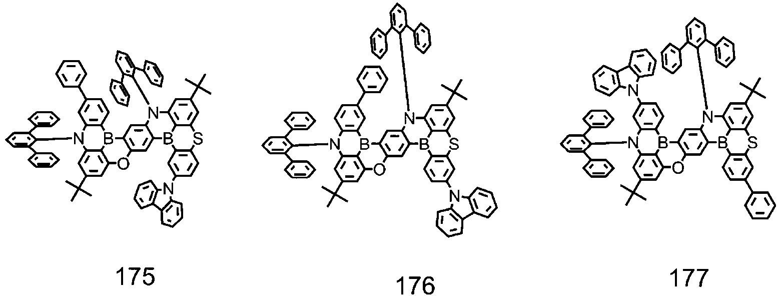

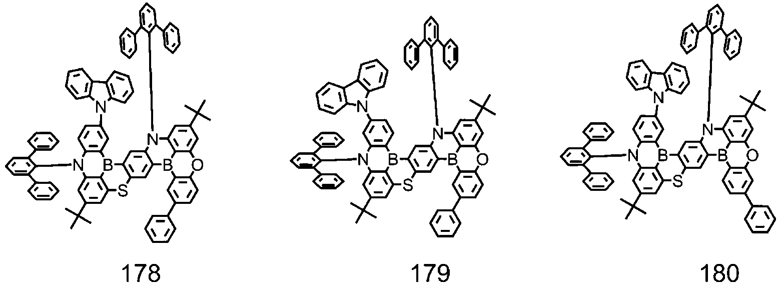

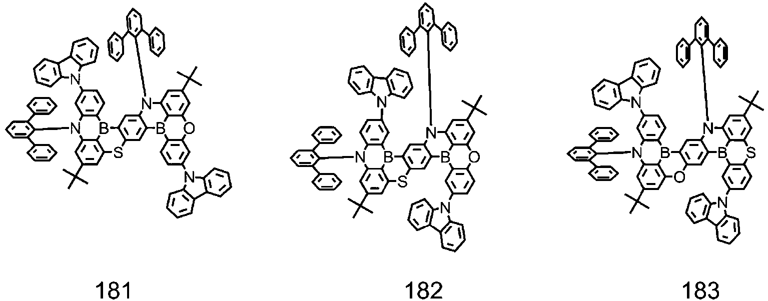

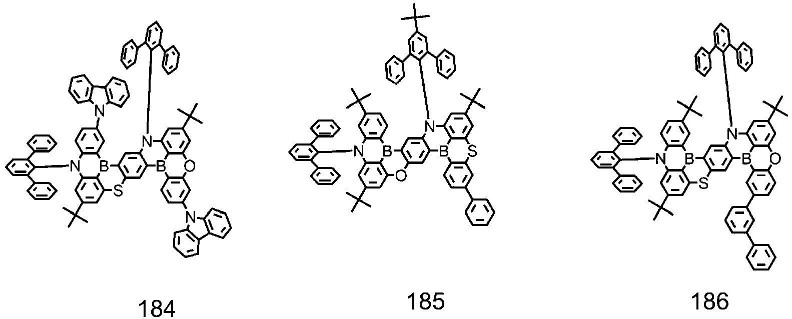

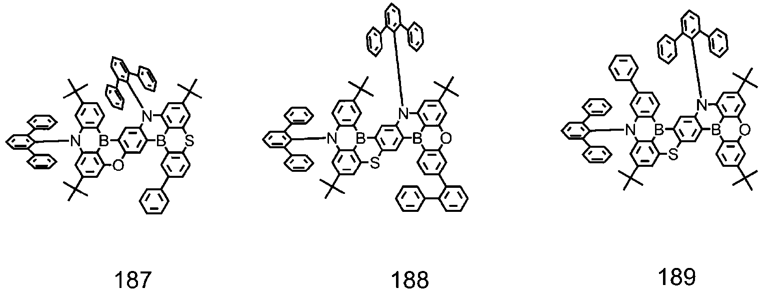

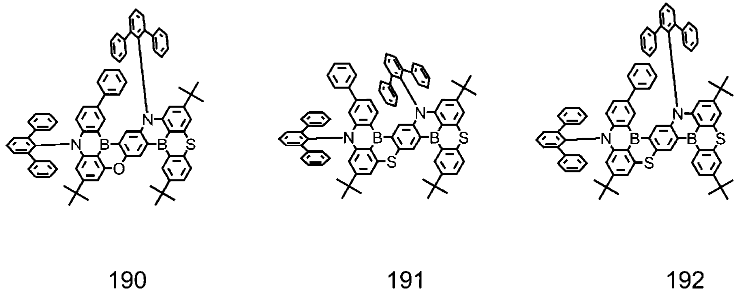

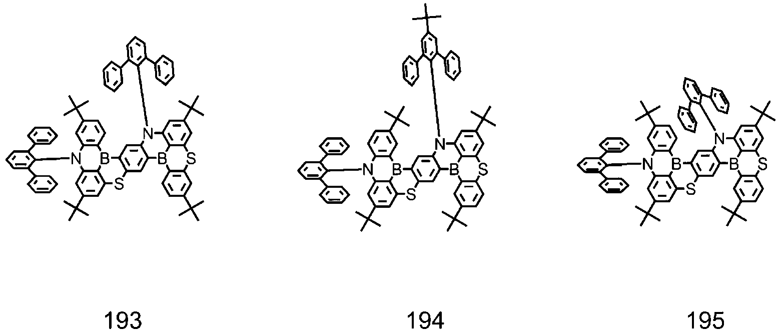

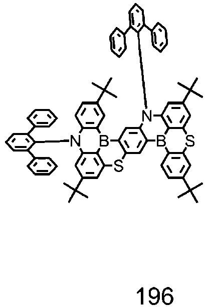

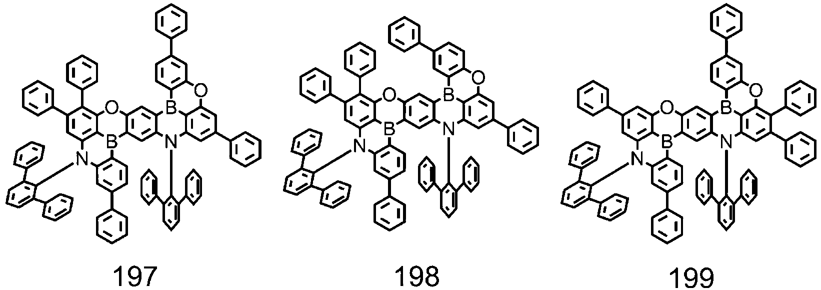

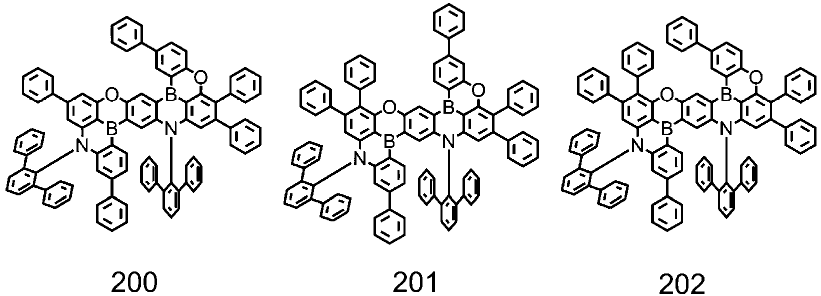

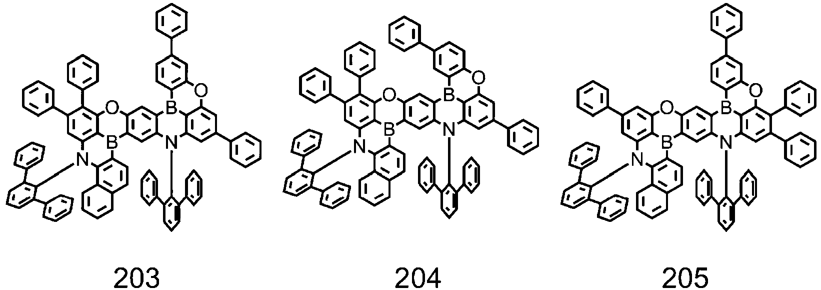

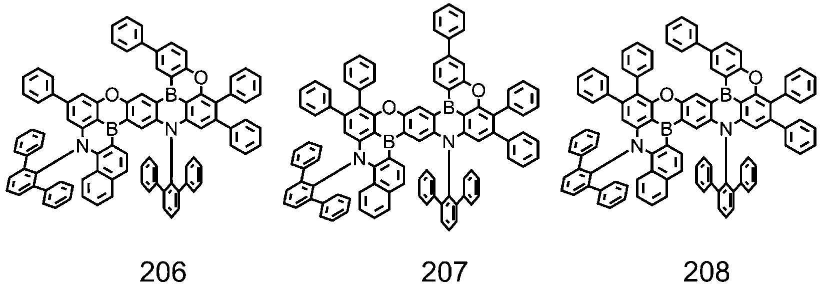

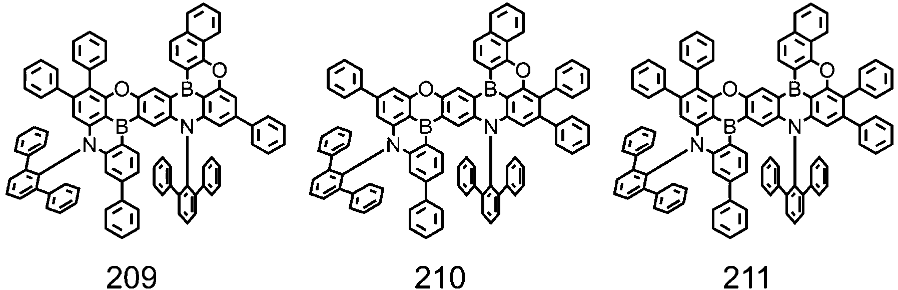

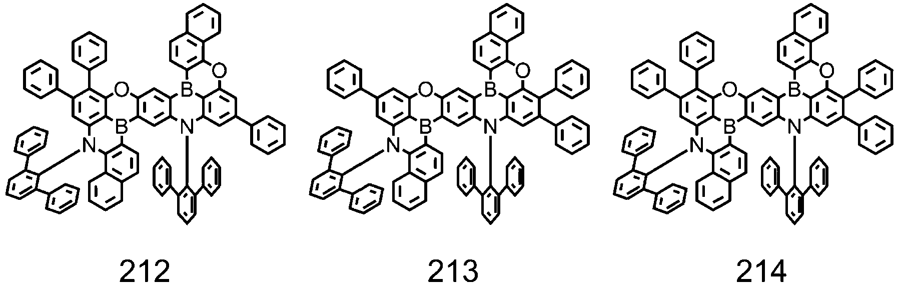

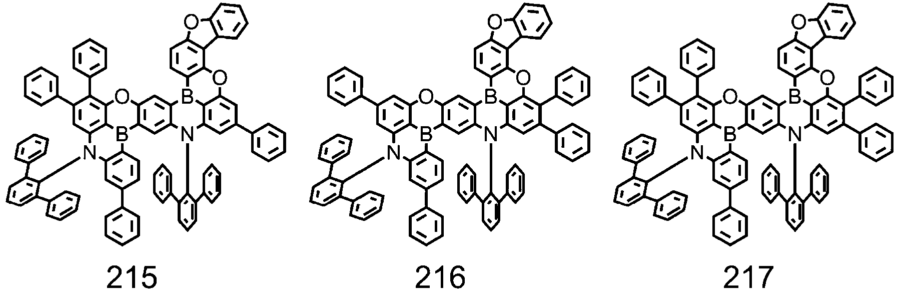

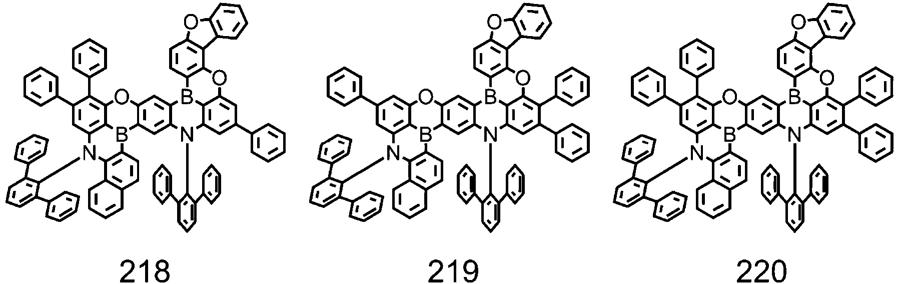

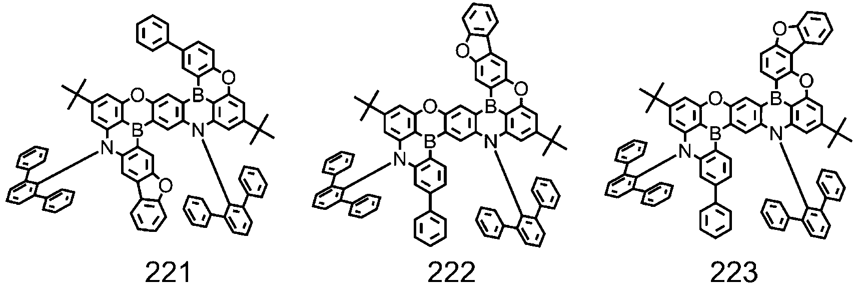

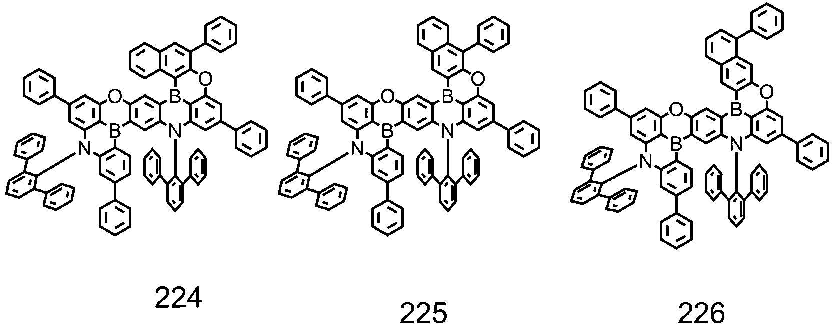

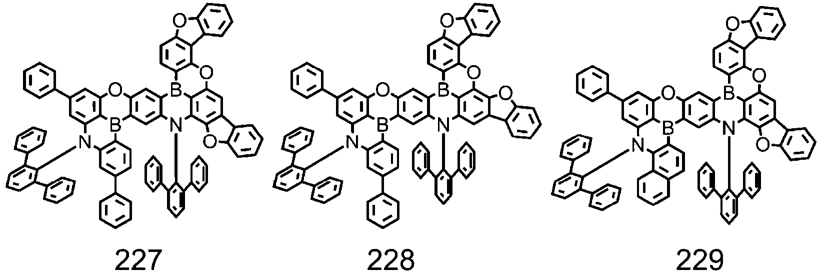

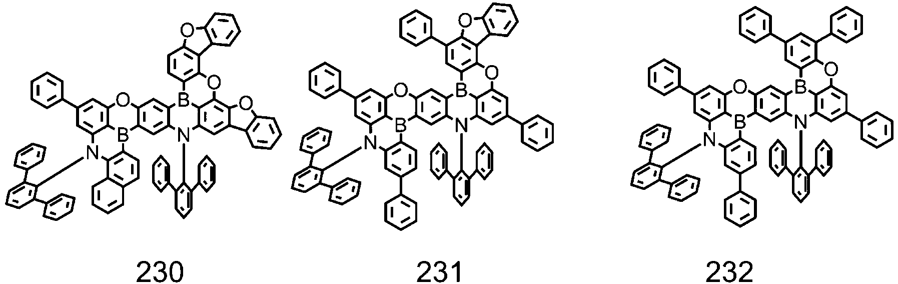

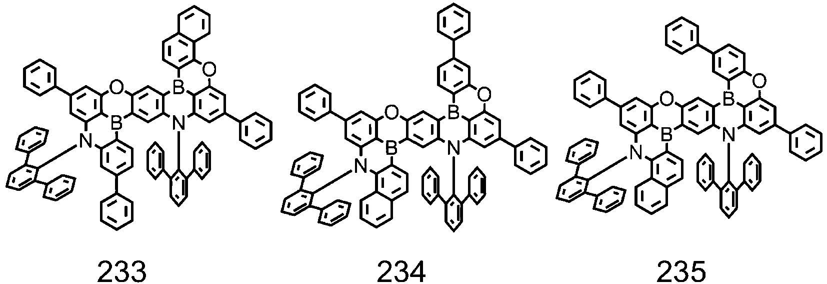

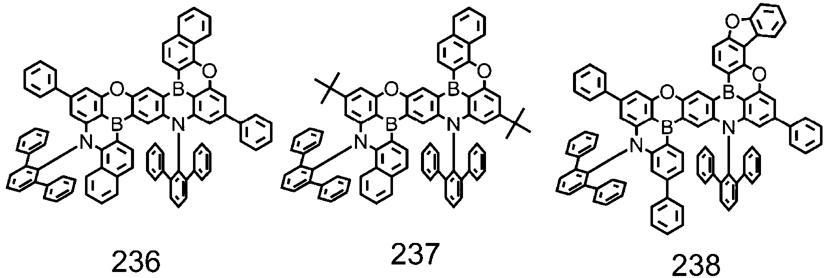

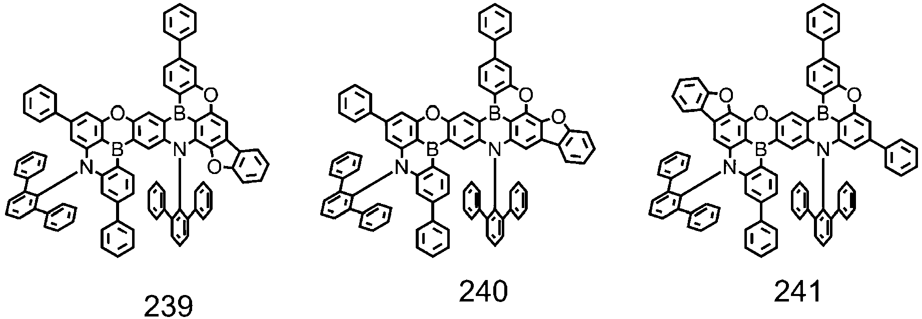

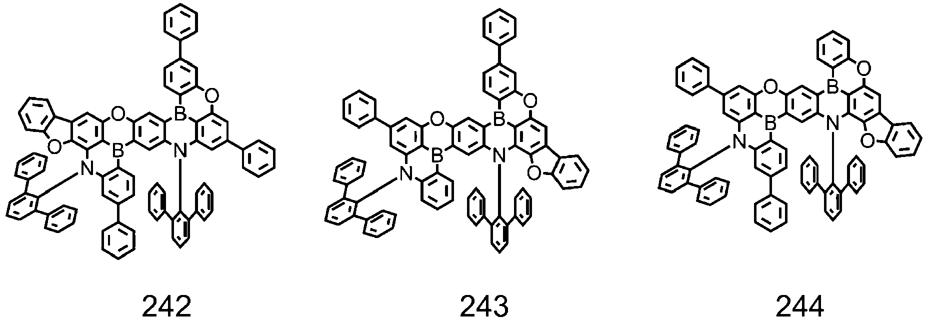

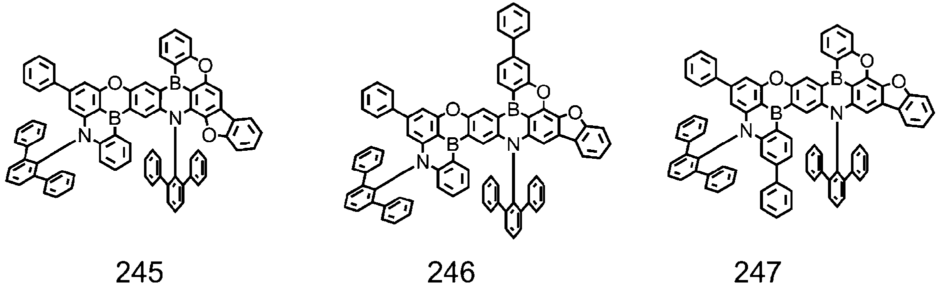

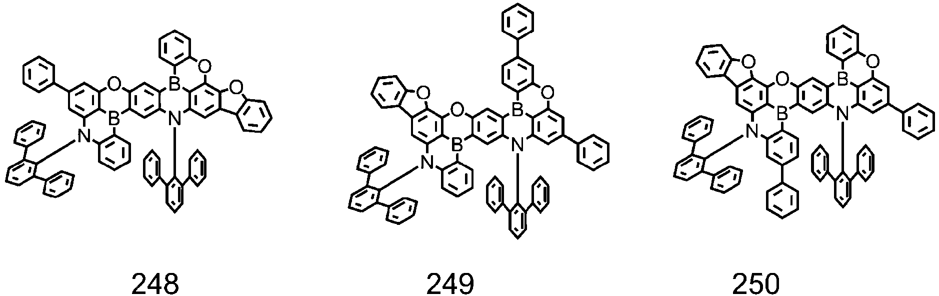

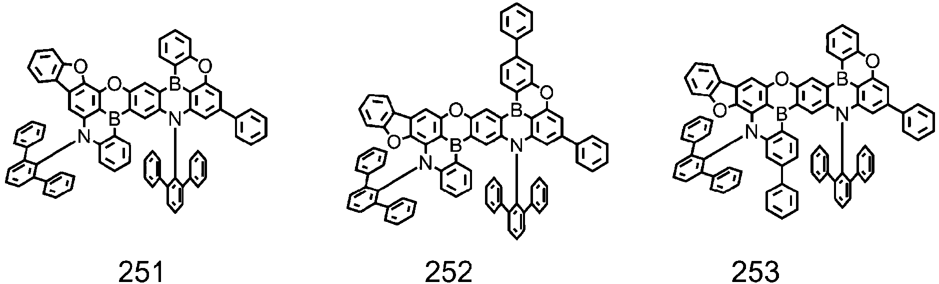

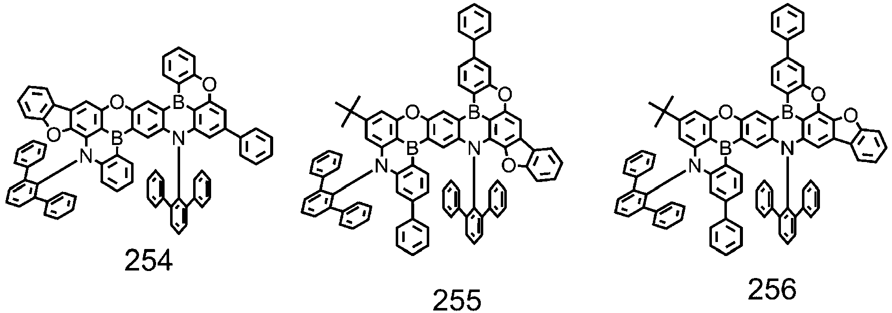

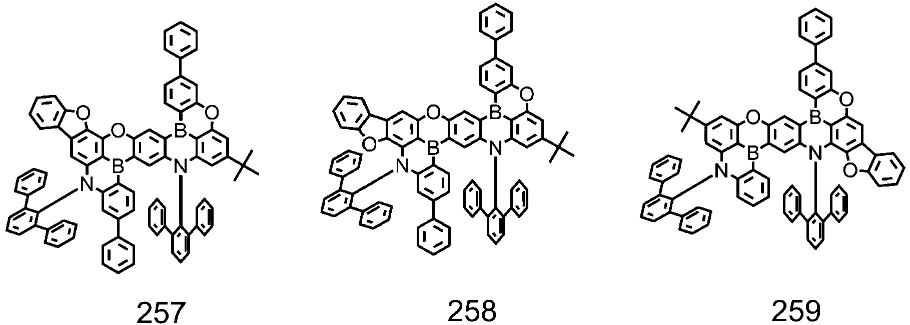

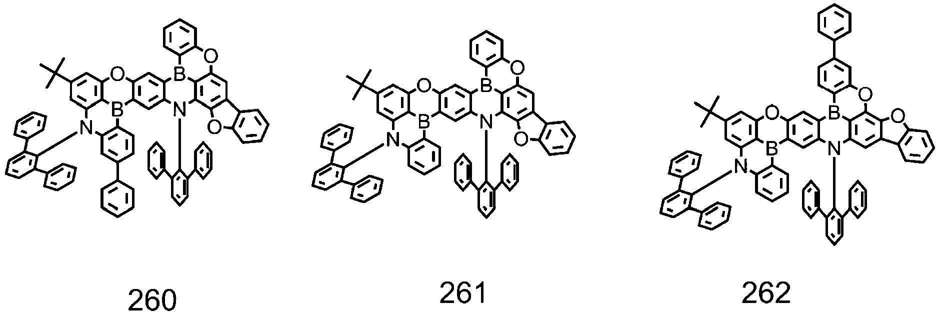

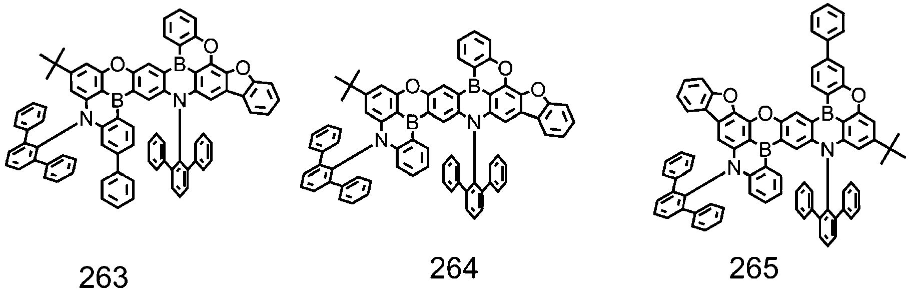

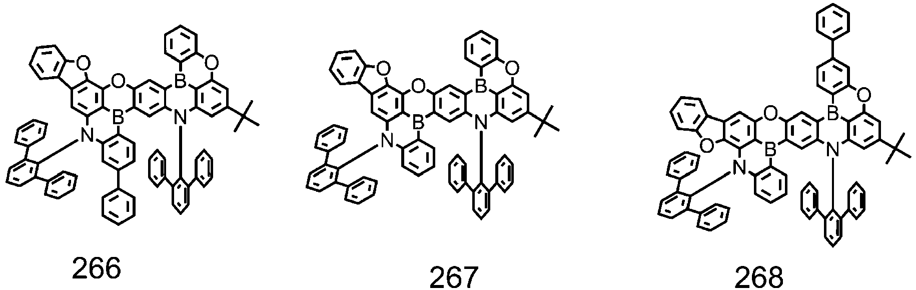

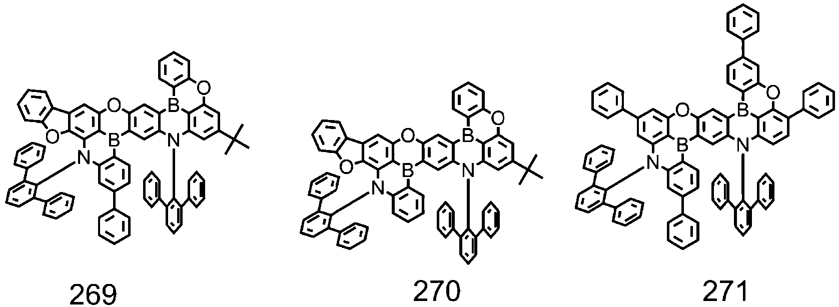

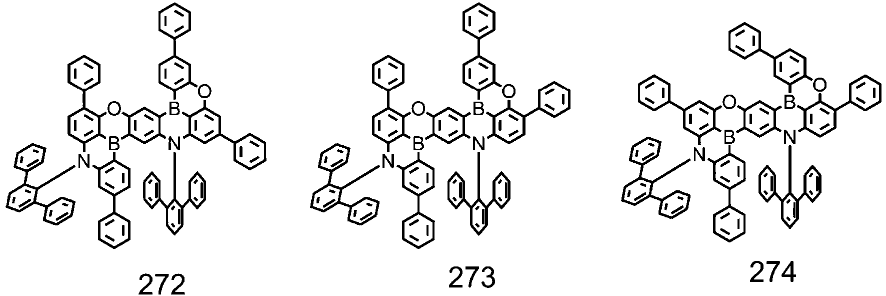

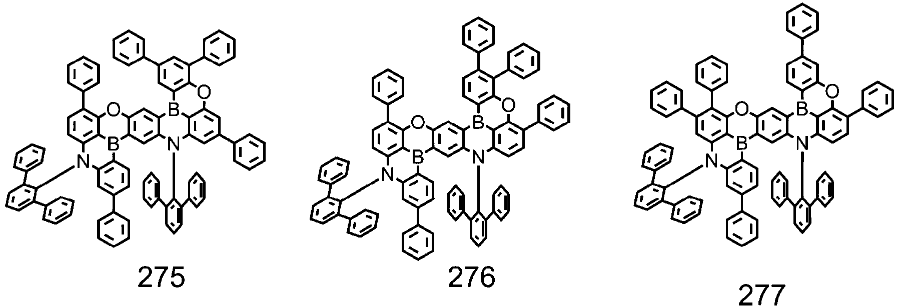

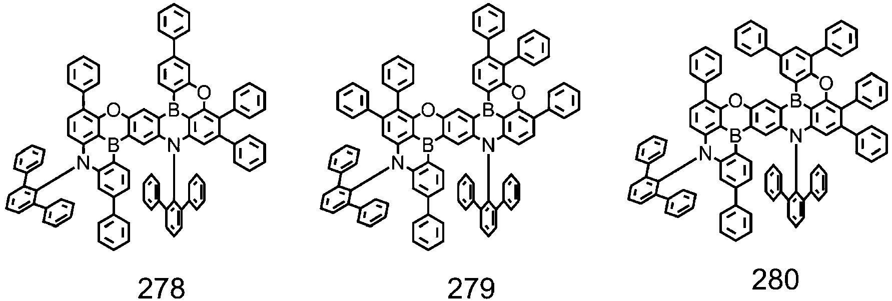

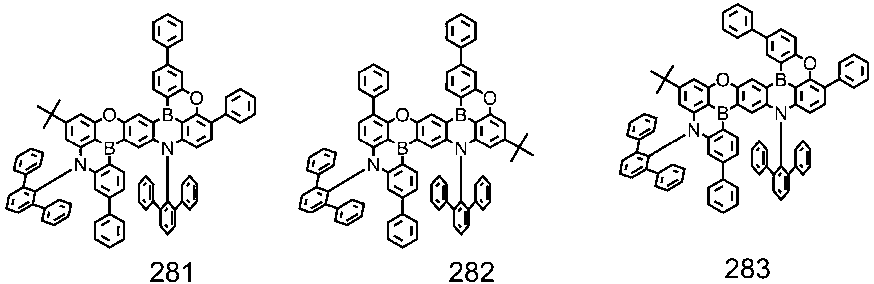

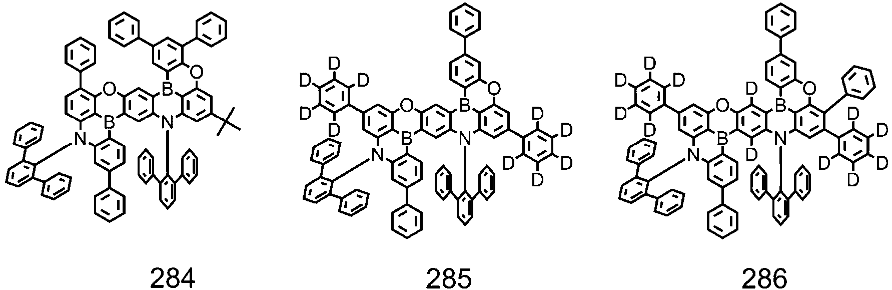

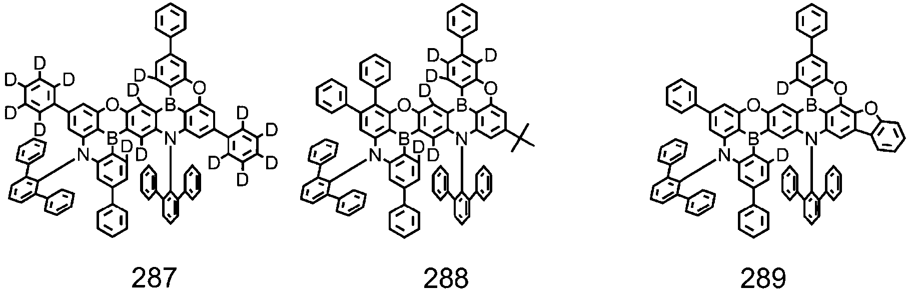

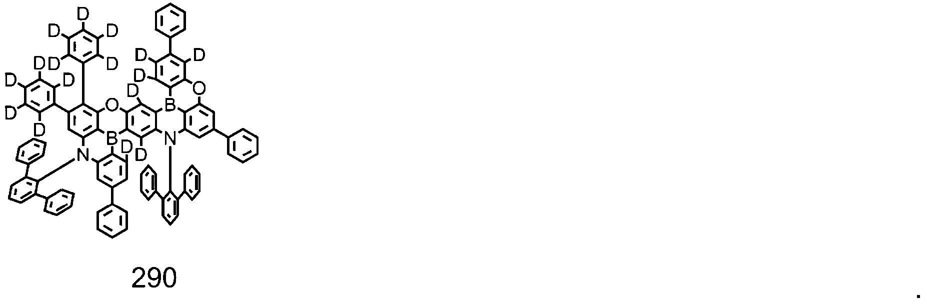

8. A light-emitting device (ED), comprising:
a first electrode (110);
a second electrode (150); and
an intermediate layer (ITL) between the first electrode (110) and the second electrode (150), the intermediate layer (ITL) comprising an emission layer (130) that comprises a condensed heterocyclic compound represented by Chemical Formula 1: 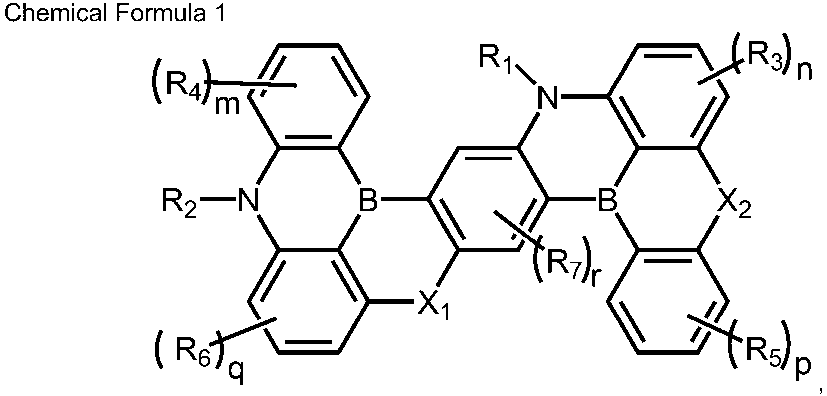
wherein, in Chemical Formula 1, X₁ and X₂ are each independently O, S, or Se, and
R₁ and R₂ are each independently a group represented by Chemical Formula 2 : 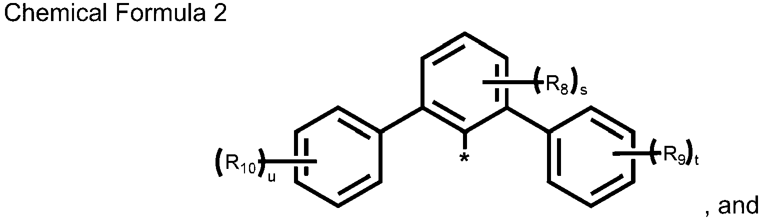
wherein, in Chemical Formulae 1 and 2,
R₃ to R₁₀ are each independently hydrogen, deuterium, a halogen, a hydroxyl group, a cyano group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, a substituted or unsubstituted C₈-C₆₀ condensed polycyclic group, -SiRR'R", -P(=O)RR', -NRR', -BRR', -C(=O)R, or -S(=O)₂R; and/or
optionally, two or more of R₃ to R₁₀ are combined with each other to form a substituted or unsubstituted C₃-C₆₀ cycloalkyl ring, a substituted or unsubstituted C₅-C₆₀ cycloalkenyl ring, a substituted or unsubstituted C₃-C₆₀ heterocycloalkyl ring, a substituted or unsubstituted C₃-C₆₀ heterocycloalkenyl ring, a substituted or unsubstituted C₆-C₆₀ aryl ring, or a substituted or unsubstituted C₂-C₆₀ heteroaryl ring,
wherein R, R', and R" are each independently hydrogen, deuterium, a halogen, a hydroxyl group, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, or a substituted or unsubstituted C₈-C₆₀ condensed polycyclic group,
n, q, and s are each independently an integer from 0 to 3,
m and p are each independently an integer from 0 to 4,
r is an integer from 0 to 2,
t and u are each independently an integer from 0 to 5, and
* represents a bonding point.

9. The light-emitting device (ED) of claim 8, wherein the emission layer (130) comprises a host and a dopant, the dopant comprising the condensed heterocyclic compound as a thermally activated delayed fluorescence dopant, optionally wherein the dopant further comprises a phosphorescent dopant.

10. The light-emitting device (ED) according to claim 9, wherein the host comprises a hole transporting host represented by Chemical Formula HT and an electron transporting host represented by Chemical Formula ET: 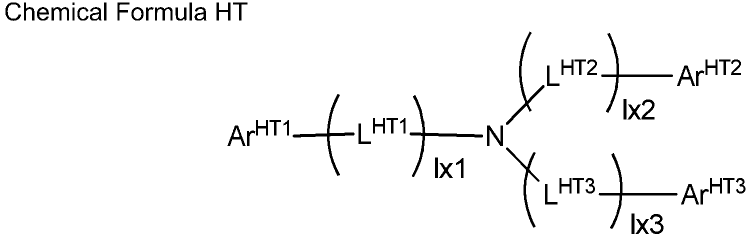
wherein, in Chemical Formula HT, L^{HT1}, L^{HT2}, and L^{HT3} are each independently a direct linkage, a substituted or unsubstituted C₆-C₃₀ arylene group, or a substituted or unsubstituted C₂-C₃₀ heteroarylene group,
Ix1 to Ix3 are each independently be an integer from 0 to 10,
Ar^{HT1} and Ar^{HT2} are each independently a substituted or unsubstituted C₆-C₃₀ aryl group or a substituted or unsubstituted C₂-C₃₀ heteroaryl group, and Ar^{HT3} is a substituted or unsubstituted C₆-C₃₀ aryl group. 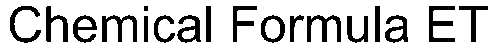 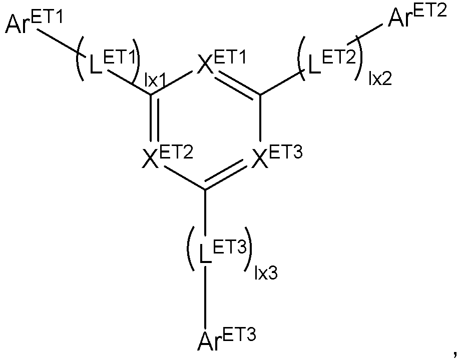
and
wherein, in Chemical Formula ET, at least one selected from among X^{ET1} to X^{ET3} is N, and the remainder of X^{ET1} to X^{ET3} are each independently C(R^{ET}),
R^{ET} is hydrogen, deuterium, a substituted or unsubstituted C₁-C₂₀ alkyl group, a substituted or unsubstituted C₆-C₆₀ aryl group, or a substituted or unsubstituted C₂-C₆₀ heteroaryl group,
Ix1 to Ix3 are each independently an integer from 0 to 10,
L^{ET1} to L^{ET3} are each independently be a direct linkage, a substituted or unsubstituted C₆-C₃₀ arylene group, or a substituted or unsubstituted C₂-C₃₀ heteroarylene group, and
Ar^{ET1} to Ar^{ET3} are each independently hydrogen, deuterium, a substituted or unsubstituted C₁-C₂₀ alkyl group, a substituted or unsubstituted C₆-C₃₀ aryl group, or a substituted or unsubstituted C₂-C₃₀ heteroaryl group.

11. The light-emitting device (ED) of claim 10, wherein the intermediate layer (ITL) further comprises:
a hole transport layer (124) between the emission layer (130) and the first electrode (110); and
an electron transport layer (144) between the emission layer (130) and the second electrode (150).

12. The light-emitting device (ED) of claim 14, wherein the intermediate layer (ITL) further comprises:
an electron blocking layer (126) between the hole transport layer (124) and the emission layer (130); and
a hole blocking layer (146) between the emission layer (130) and the electron transport layer (144).

13. The light-emitting device (ED) of claim 12, wherein:
(i) the hole transport layer (124) or the electron blocking layer (126) comprises a compound represented by Chemical Formula HT; and/or
(ii) the electron transport layer (144) or the hole blocking layer (146) comprises a compound represented by Chemical Formula ET.

14. The light-emitting device (ED) of any one of claims 8 to 13, wherein the emission layer (130) is to emit a green light with a maximum emission wavelength in a range of about 510 nm to about 540 nm.

15. An electronic apparatus comprising a light-emitting device (ED), wherein,
the light-emitting device (ED) comprises:
a first electrode (110);
a second electrode (150); and
an intermediate layer (ITL) between the first electrode (110) and the second electrode (150), the intermediate layer (ITL) comprising an emission layer (130) that comprises a condensed heterocyclic compound represented by Chemical Formula 1: 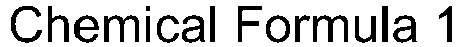 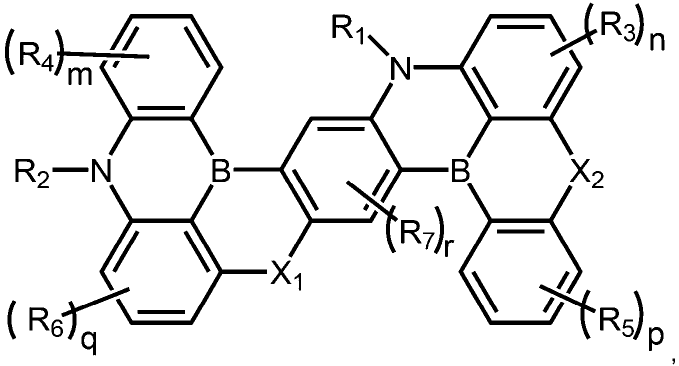
wherein, in Chemical Formula 1, X₁ and X₂ are each independently O, S, or Se, and
R₁ and R₂ are each independently a group represented by Chemical Formula 2: 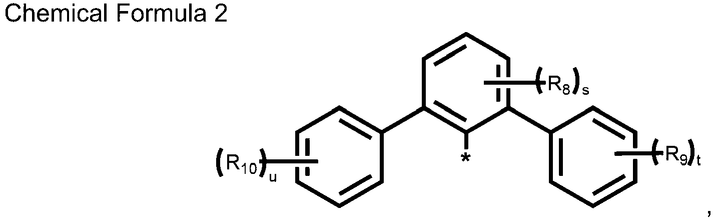 and
wherein, in Chemical Formulae 1 and 2,
R₃ to R₁₀ are each independently hydrogen, deuterium, a halogen, a hydroxyl group, a cyano group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, a substituted or unsubstituted C₈-C₆₀ condensed polycyclic group, -SiRR'R", -P(=O)RR', -NRR', -BRR', -C(=O)R, or -S(=O)₂R; and/or
optionally, two or more of R₃ to R₁₀ are combined with each other to form a substituted or unsubstituted C₃-C₆₀ cycloalkyl ring, a substituted or unsubstituted C₅-C₆₀ cycloalkenyl ring, a substituted or unsubstituted C₃-C₆₀ heterocycloalkyl ring, a substituted or unsubstituted C₃-C₆₀ heterocycloalkenyl ring, a substituted or unsubstituted C₆-C₆₀ aryl ring, or a substituted or unsubstituted C₂-C₆₀ heteroaryl ring,
wherein R, R', and R" are each independently hydrogen, deuterium, a halogen, a hydroxyl group, a cyano group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₃-C₆₀ heterocycloalkenyl group, a substituted or unsubstituted C₆-C₆₀ aryl group, a substituted or unsubstituted C₂-C₆₀ heteroaryl group, a substituted or unsubstituted C₆-C₆₀ aryloxy group, a substituted or unsubstituted C₆-C₆₀ arylthio group, or a substituted or unsubstituted C₈-C₆₀ condensed polycyclic group,
n, q, and s are each independently an integer from 0 to 3,
m and p are each independently an integer from 0 to 4,
r is an integer from 0 to 2,
t and u are each independently an integer from 0 to 5, and
* represents a bonding point, optionally wherein the electronic apparatus is at least one of a flat panel display, a curved display, a computer monitor, a medical monitor, a television, a billboard, an indoor light, an outdoor light, a light for signaling, a head-up display, a fully transparent display, a partially transparent display, a flexible display, a rollable display, a foldable display, a stretchable display, a laser printer, a phone, a mobile phone, a tablet, a phablet, a personal information terminal (PDA), a wearable device, a laptop computer, a digital camera, a camcorder, a viewfinder, a micro display, a 3D display, a virtual reality display, an augmented reality display, a vehicle, a video wall comprising multiple displays tiled together, a theater screen, a stadium screen, a phototherapy device, or a signage.
